# EUROPEAN PATENT APPLICATION

(11) **EP 2 528 104 A1**
(43) Date of publication of application: **28.11.2012**
(21) Application number: 11734775.7
(22) Date of filing: 21.01.2011
(51) Int. Cl.: H01L 31/04

(54) **BACK CONTACT SOLAR CELL, WIRING SHEET, SOLAR CELL HAVING WIRING SHEET, SOLAR CELL MODULE AND PRODUCTION METHOD FOR SOLAR CELL HAVING WIRING SHEET**

(30) Priority: 18.01.2011 JP 2011008158; 22.01.2010 JP 2010012361; 22.01.2010 JP 2010012344
(71) Applicant: Sharp Kabushiki Kaisha, Osaka-shi, Osaka 545-8522 (JP)
(72) Inventor: MIKAMI, Rui, Osaka-shi, Osaka 545-8522 (JP); ABIKO, Yoshiya, Osaka-shi, Osaka 545-8522 (JP); SAINOO, Yasushi, Osaka-shi, Osaka 545-8522 (JP); TSUNEMI, Akiko, Osaka-shi, Osaka 545-8522 (JP); MORII, Kohjiroh, Osaka-shi, Osaka 545-8522 (JP); SATOMURA, Masafumi, Osaka-shi, Osaka 545-8522 (JP); NISHINA, Tomohiro, Osaka-shi, Osaka 545-8522 (JP); NAITO, Shinsuke, Osaka-shi, Osaka 545-8522 (JP); SHIRAKI, Tomoyo, Osaka-shi, Osaka 545-8522 (JP)
(74) Representative: Müller-Boré & Partner Patentanwälte
(86) International application number: PCT/JP2011/051116
(87) International publication number: WO 2011/090169

(57) **Abstract**

A back contact solar cell according to an embodiment of the invention includes an alignment mark (25a, 25b) in an inner region inside of an outer periphery of an electrode pattern that includes plural electrodes for first conductivity type (24) and plural electrodes for second conductivity type (25), which are formed on one surface side of a semiconductor substrate (21). According to the configuration, alignment accuracy is improved between a back contact of a solar cell and a wiring of a wiring sheet.

## Description

### TECHNICAL FIELD

The present invention relates to a back contact solar cell, a wiring sheet, a solar cell having wiring sheet, a solar cell module, and a production method for the solar cell having wiring sheet.

### BACKGROUND ART

For example, Japanese Patent Laying-Open No. 2005-340362 (PTL 1) and Japanese Patent Laying-Open No. 2009-88145 (PTL 2) disclose a solar cell module in which a back contact solar cell and a wiring sheet are connected. In the solar cell module disclosed in Japanese Patent Laying-Open No. 2005-340362 (PTL 1) and Japanese Patent Laying-Open No. 2009-88145 (PTL 2), an electrode pattern of the back contact solar cell is disposed so as to be overlapped with a wiring pattern formed on the wiring sheet. At this point, in a solar cell module producing method disclosed in Japanese Patent Laying-Open No. 2009-88145 (PTL 2), a slit pattern provided in the wiring sheet is used to perform alignment between the back contact solar cell and the wiring sheet.

### CITATION LIST

### PATENT LITERATURE

PTL 1: Japanese Patent Laying-Open No. 2005-340362
PTL 2: Japanese Patent Laying-Open No. 2009-88145

### SUMMARY OF INVENTION

### TECHNICAL PROBLEM

As a back contact of the back contact solar cell is finely fabricated to narrow a pitch between the electrodes, higher accuracy is required for the alignment between the back contact solar cell and the wiring sheet.

In view of the foregoing problem, an object of the invention is to provide a back contact solar cell, a wiring sheet, a solar cell having wiring sheet, a solar cell module, and a production method for the solar cell having wiring sheet, which can improve the alignment accuracy between the back contact of the solar cell and the wiring of the wiring sheet.

### SOLUTION TO PROBLEM

A back contact solar cell based on the present invention includes an alignment mark in an inner region inside of an outer periphery of an electrode pattern that includes plural electrodes formed on one surface side of a semiconductor substrate.

Preferably the alignment mark is located in a space where the plural electrodes are not located in the inner region.

In the aspect of the present invention, the electrode includes a linearly extending electrode line. The space is formed such that one end portion in the electrode-line extending direction of at least one of the plural electrode lines is located inside of the one end portion in each of other electrode lines in the electrode-line extending direction.

In the aspect of the present invention, the electrode includes a linearly extending electrode line. The space is a gap between the electrode lines, the gap being formed such that at least one of the plural electrode lines is separately disposed in the electrode-line extending direction.

In the aspect of the present invention, the electrode includes a linearly extending electrode line. The alignment mark is located between electrode lines adjacent to each other in the plural electrode lines.

Preferably the alignment mark is made of a material identical to that of the plural electrodes.

A wiring sheet according to a second aspect of the invention includes a wiring electrically connecting plural back contact solar cells. The wiring includes plural identical shape portion having an identical shape and at least one different shape portion having a shape different from that of the identical shape portion.

In the aspect of the present invention, the wiring includes a first wiring and a second wiring, which are electrically insulated from each other. Each of the first wiring and the second wiring includes plural comb-tooth-shaped portions and a connection wiring portion connecting the plural comb-tooth-shaped portions. At least one of the first wiring and the second wiring includes the identical shape portion and the different shape portion. The different shape portion is formed such that at least one of the plural comb-tooth-shaped portions is shorter than the other comb-tooth-shaped portions that are the identical shape portion.

In the aspect of the present invention, the wiring includes a first wiring and a second wiring, which are electrically insulated from each other. Each of the first wiring and the second wiring includes plural comb-tooth-shaped portions and a connection wiring portion connecting the plural comb-tooth-shaped portions. At least one of the first wiring and the second wiring includes the identical shape portion and the different shape portion. The different shape portion is formed such that the wiring includes an opening.

Preferably the wiring includes a first wiring and a second wiring, which are electrically insulated from each other. Each of the first wiring and the second wiring includes plural comb-tooth-shaped portions and a connection wiring portion connecting the plural comb-tooth-shaped portions. At least one of the first wiring and the second wiring includes the identical shape portion and the different shape portion. The different shape portion is formed such that at least one of the plural comb-tooth-shaped portion has a shape in which a gap between the comb-tooth-shaped portions adjacent to each other is partially widened.

A solar cell having wiring sheet based on the present invention includes: the back contact solar cell described in any one of the above descriptions; and the wiring sheet described in any one of the above descriptions. At least one of the alignment marks is disposed while overlapped with an alignment target region defined by the different shape portion.

In the aspect of the present invention, the back contact solar cell includes the plural alignment marks.

In the aspect of the present invention, at least two of the plural alignment marks are disposed while overlapped with the alignment target region.

In the aspect of the present invention, at least one of the plural alignment marks is disposed while overlapped with the wiring.

In the aspect of the present invention, the back contact solar cell includes at least three of the alignment marks. At least two of the alignment marks are disposed while overlapped with the alignment target region. At least one of the alignment marks is disposed while overlapped with the wiring.

A solar cell module based on the present invention includes the solar cell having wiring sheet.

A production method for a solar cell having wiring sheet based on the present invention, includes a step of: preparing a back contact solar cells including an alignment mark in an inner region inside of an outer periphery of an electrode pattern that includes plural electrodes formed on one surface side of a semiconductor substrate. Moreover, the method includes a step of preparing a wiring sheet electrically connecting the back contact solar cells, the wiring including plural identical shape portions having an identical shape and at least one different shape portion having a shape different from that of the identical shape portion. Furthermore, the method includes a step of performing alignment between the back contact solar cell and the wiring sheet such that the alignment mark of the back contact solar cell and an alignment target region defined by the different shape portion of the wiring sheet are disposed while overlapped with each other.

Preferably the plural alignment marks and the alignment target region are disposed while overlapped with each other in the alignment step.

In the aspect of the present invention, the at least one alignment mark and the wiring are disposed while overlapped with each other in the alignment step.

In the aspect of the present invention, in the alignment step, the alignment between the back contact solar cell and the wiring sheet is performed such that the back contact solar cell and the wiring sheet are overlapped with each other while the back contact solar cell is irradiated with light, which is transmitted through the back contact solar cell, to check the alignment mark and the alignment target region.

Preferably, in the alignment step, the alignment between the back contact solar cell and the wiring sheet is performed such that the back contact solar cell and the wiring sheet are overlapped with each other while the back contact solar cell is irradiated with light, which is reflected by the electrode of the back contact solar cell, to check the alignment mark and the alignment target region.

### ADVANTAGEOUS EFFECTS OF INVENTION

According to the invention, the alignment accuracy between the back contact of the back contact solar cell and the wiring of the wiring sheet can be improved. Additionally, the power generation efficiencies of the solar cell having wiring sheet and the solar cell module can be improved.

### BRIEF DESCRIPTION OF DRAWINGS

Fig. 1 is a plan view of a solar cell having wiring sheet according to a first embodiment of the invention when viewed from a light receiving side.
Fig. 2 is a perspective view illustrating a disposition relationship between a back contact solar cell and a wiring sheet.
Fig. 3 is a sectional view taken on a line III-III of Fig. 2 when viewed from an arrow direction.
Fig. 4 is a plan view illustrating a back surface of the back contact solar cell of the first embodiment.
Fig. 5 is a plan view illustrating a wiring pattern of the wiring sheet of the first embodiment.
Fig. 6 is a plan view illustrating a state in which the back contact solar cell and the wiring sheet of the first embodiment are overlapped with each other when viewed from a back surface side of the solar cell having wiring sheet.
Fig. 7 is a sectional view illustrating a state before the solar cell having wiring sheet is sealed.
Fig. 8 is a sectional view illustrating a state in which the solar cell having wiring sheet is sealed to form a solar cell module.
Fig. 9 is a plan view illustrating a back surface of a back contact solar cell according to a second embodiment of the invention.
Fig. 10 is a plan view illustrating a wiring pattern of a wiring sheet of the second embodiment.
Fig. 11 is a plan view illustrating a state in which the back contact solar cell and the wiring sheet of the second embodiment are overlapped with each other when viewed from a back surface side of the solar cell having wiring sheet.
Fig. 12 is a plan view illustrating a back surface of a back contact solar cell according to a third embodiment of the invention.
Fig. 13 is a plan view illustrating a wiring pattern of a wiring sheet of the third embodiment.
Fig. 14 is a plan view illustrating a state in which the back contact solar cell and the wiring sheet of the third embodiment are overlapped with each other when viewed from a back surface side of the solar cell having wiring sheet.
Fig. 15 is a perspective view illustrating the state in which the back contact solar cell and the wiring sheet of the third embodiment are overlapped with each other.
Fig. 16 is a plan view illustrating a back surface of a back contact solar cell according to a fourth embodiment of the invention.
Fig. 17 is a plan view illustrating a wiring pattern of a wiring sheet of the fourth embodiment.
Fig. 18 is a plan view illustrating a state in which the back contact solar cell and the wiring sheet of the fourth embodiment are overlapped with each other when viewed from a back surface side of the solar cell having wiring sheet.
Fig. 19 is a plan view illustrating a back surface of a back contact solar cell according to a fifth embodiment of the invention.
Fig. 20 is a plan view illustrating a wiring pattern of a wiring sheet of the fifth embodiment.
Fig. 21 is a plan view illustrating a state in which the back contact solar cell and the wiring sheet of the fifth embodiment are overlapped with each other when viewed from a back surface side of the solar cell having wiring sheet.
Fig. 22 is a plan view illustrating a back surface of a back contact solar cell according to a sixth embodiment of the invention.
Fig. 23 is a plan view illustrating a wiring pattern of a wiring sheet of the sixth embodiment.
Fig. 24 is a plan view illustrating a state in which the back contact solar cell and the wiring sheet of the sixth embodiment are overlapped with each other when viewed from a back surface side of the solar cell having wiring sheet.
Fig. 25 is a plan view illustrating a back surface of a back contact solar cell according to a seventh embodiment of the invention.
Fig. 26 is a plan view illustrating a wiring pattern of a wiring sheet of the seventh embodiment.
Fig. 27 is a plan view illustrating a state in which the back contact solar cell and the wiring sheet of the seventh embodiment are overlapped with each other when viewed from a back surface side of the solar cell having wiring sheet.
Fig. 28 is a plan view illustrating a back surface of a back contact solar cell according to an eighth embodiment of the invention.
Fig. 29 is a plan view illustrating a wiring pattern of a wiring sheet of the eighth embodiment.
Fig. 30 is a plan view illustrating a state in which the back contact solar cell and the wiring sheet of the eighth embodiment are overlapped with each other when viewed from a back surface side of the solar cell having wiring sheet.
Fig. 31 is a plan view illustrating a back surface of a back contact solar cell according to a ninth embodiment of the invention.
Fig. 32 is a plan view illustrating a wiring pattern of a wiring sheet of the ninth embodiment.
Fig. 33 is a plan view illustrating a state in which the back contact solar cell and the wiring sheet of the eighth embodiment are overlapped with each other when viewed from a back surface side of the solar cell having wiring sheet.
Fig. 34 is a plan view illustrating a back surface of a back contact solar cell according to a tenth embodiment of the invention.
Fig. 35 is a plan view illustrating a wiring pattern of a wiring sheet of the tenth embodiment.
Fig. 36 is a plan view illustrating a state in which the back contact solar cell and the wiring sheet of the tenth embodiment are overlapped with each other when viewed from a back surface side of the solar cell having wiring sheet.
Fig. 37 is a plan view illustrating a back surface of a back contact solar cell according to an eleventh embodiment of the invention.
Fig. 38 is a plan view illustrating a wiring pattern of a wiring sheet of the eleventh embodiment.
Fig. 39 is a plan view illustrating a state in which the back contact solar cell and the wiring sheet of the eleventh embodiment are overlapped with each other when viewed from a back surface side of the solar cell having wiring sheet.
Fig. 40 is a plan view illustrating a back surface of a back contact solar cell according to a twelfth embodiment of the invention.
Fig. 41 is a plan view illustrating a wiring pattern of a wiring sheet of the twelfth embodiment.
Fig. 42 is a plan view illustrating a state in which the back contact solar cell and the wiring sheet of the twelfth embodiment are overlapped with each other when viewed from a back surface side of the solar cell having wiring sheet.
Fig. 43 is a plan view illustrating a back surface of a back contact solar cell according to a thirteenth embodiment of the invention.
Fig. 44 is a plan view illustrating a wiring pattern of a wiring sheet of the thirteenth embodiment.
Fig. 45 is a plan view illustrating a state in which the back contact solar cell and the wiring sheet of the thirteenth embodiment are overlapped with each other when viewed from a back surface side of the solar cell having wiring sheet.
Fig. 46 is a plan view illustrating a back surface of a back contact solar cell according to a fourteenth embodiment of the invention.
Fig. 47 is a plan view illustrating a wiring pattern of a wiring sheet of the fourteenth embodiment.
Fig. 48 is a plan view illustrating a state in which the back contact solar cell and the wiring sheet of the fourteenth embodiment are overlapped with each other when viewed from a back surface side of the solar cell having wiring sheet.
Fig. 49 is a plan view illustrating a back surface of a back contact solar cell according to a fifteenth d embodiment of the invention.
Fig. 50 is a plan view illustrating a wiring pattern of a wiring sheet of the fifteenth embodiment.
Fig. 51 is a plan view illustrating a state in which the back contact solar cell and the wiring sheet of the fifteenth embodiment are overlapped with each other when viewed from a back surface side of the solar cell having wiring sheet.
Fig. 52 is a plan view illustrating a back surface of a back contact solar cell according to a sixteenth embodiment of the invention.
Fig. 53 is a partially enlarged view illustrating an alignment mark formed on one of end portion sides in an electrode extending direction.
Fig. 54 is a partially enlarged view illustrating an alignment mark formed on the other end portion side in the electrode extending direction.
Fig. 55 is a plan view illustrating a wiring pattern of a wiring sheet of the sixteenth embodiment.
Fig. 56 is a plan view illustrating a state in which the back contact solar cell and the wiring sheet of the sixteenth embodiment are overlapped with each other when viewed from a back surface side of the solar cell having wiring sheet.
Fig. 57 is a partially enlarged view illustrating one of end portion sides of the solar cell having wiring sheet located in a column L₁.
Fig. 58 is a partially enlarged view illustrating one of end portion sides of the solar cell having wiring sheet located in a column L₂.
Fig. 59 is a partially enlarged view illustrating the other end portion side of the solar cell having wiring sheet located in column L₁.
Fig. 60 is a partially enlarged view illustrating the other end portion side of the solar cell having wiring sheet located in column L₂.
Fig. 61 is a plan view illustrating a back surface of a back contact solar cell according to a seventeenth embodiment of the invention.
Fig. 62 is a plan view illustrating a wiring pattern of a wiring sheet of the seventeenth embodiment.
Fig. 63 is a plan view illustrating a state in which the back contact solar cell and the wiring sheet of the seventeenth embodiment are overlapped with each other when viewed from a back surface side of the solar cell having wiring sheet.
Fig. 64 is a plan view illustrating a back surface of a back contact solar cell according to an eighteenth embodiment of the invention.
Fig. 65 is a plan view illustrating a wiring pattern of a wiring sheet of the eighteenth embodiment.
Fig. 66 is a plan view illustrating a state in which the back contact solar cell and the wiring sheet of the eighteenth embodiment are overlapped with each other when viewed from a back surface side of the solar cell having wiring sheet.

### DESCRIPTION OF EMBODIMENTS

Hereinafter, a back contact solar cell, a wiring sheet, a solar cell having wiring sheet, a solar cell module, and a production method for the solar cell having wiring sheet according to an exemplary embodiment of the invention will be described. In the following embodiments, the identical or equivalent component in the drawings is designated by the identical numeral, and the repetitive description is not given.

### <First Embodiment>

### (Solar Cell Having Wiring Sheet)

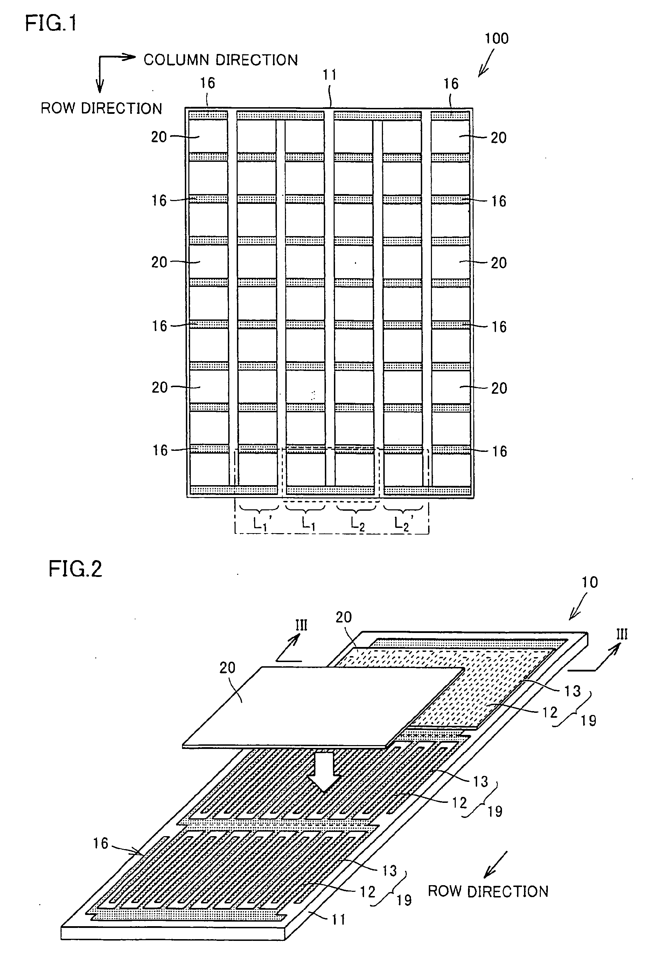

Fig. 1 is a plan view of a solar cell having wiring sheet according to a first embodiment of the invention when viewed from a light receiving side. As illustrated in Fig. 1, a solar cell having wiring sheet 100 is formed such that plural back contact solar cells 20 are electrically connected by wiring materials 16 provided on a surface of an insulating base material 11.

A wiring sheet is formed by providing wiring materials 16 on the surface of insulating base material 11. In the wiring sheet, plural cell disposition portions are two-dimensionally arrayed in a row direction and a column direction in order to dispose back contact solar cell 20.

As illustrated in Fig. 1, in solar cell having wiring sheet 100, plural back contact solar cells 20 are disposed into a serpentine shape on insulating base material 11 of a wiring sheet 10, and electrically connected in series. However, the electric connection mode of back contact solar cell 20 is not limited to the first embodiment, but a parallel connection and a combination of the series connection and the parallel connection are also included in the electric connection mode of back contact solar cell 20.

Fig. 2 is a perspective view illustrating a disposition relationship between the back contact solar cell and the wiring sheet. Only part of solar cell having wiring sheet 100 in Fig. 1 is illustrated in Fig. 2.

As illustrated in Fig. 2, wiring material 16 of wiring sheet 10 constitutes a first wiring for first conductivity type 12 and a second wiring second conductivity type 13. First wiring 12 and second wiring 13 are disposed such that comb-tooth portions of comb-shaped first wiring 12 and comb-tooth portions of comb-shaped second wiring 13 are alternately engaged. As a result, the comb-tooth portions of comb-shaped first wiring 12 and the comb-tooth portions of comb-shaped second wiring 13 are alternately disposed at predetermined intervals.

Cell disposition portions 19, each of which corresponds to one back contact solar cell and includes first wiring 12 and second wiring 13, are arrayed on insulating base material 11 of wiring sheet 10. Back contact solar cells 20 are placed on wiring sheets 10 to prepare solar cell having wiring sheet 100.

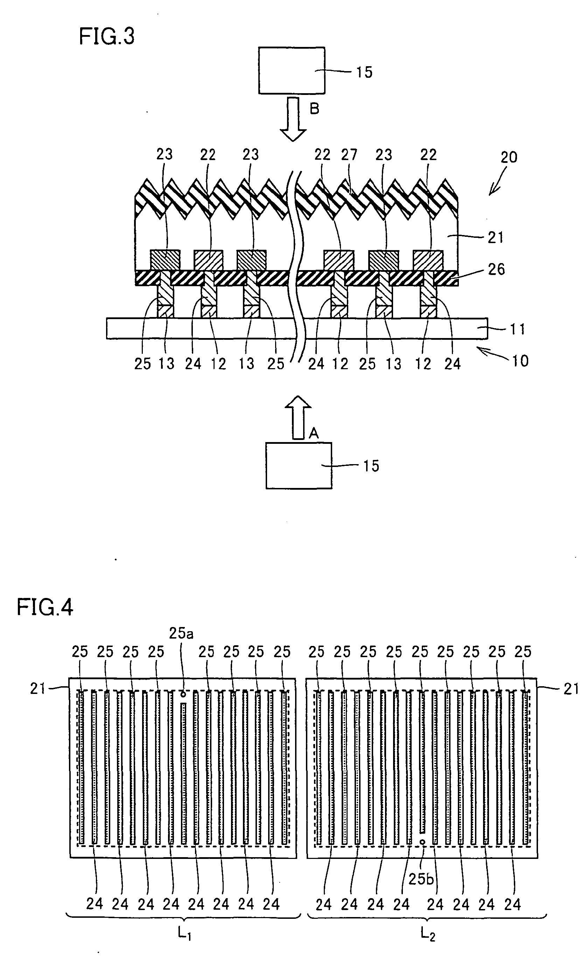

Fig. 3 is a sectional view taken on a line III-III of Fig. 2 when viewed from an arrow direction. An observation device 15 that is not included in solar cell having wiring sheet 100 is also illustrated in Fig. 3.

As illustrated in Fig. 3, back contact solar cell 20 includes a semiconductor substrate 21, such as a silicon substrate having a conductivity type of an n-type or a p-type, an antireflection film 27 that is formed on an uneven surface of semiconductor substrate 21 constituting a light receiving surface of back contact solar cell 20, and a passivation film 26 that is formed on a back surface of semiconductor substrate 21 constituting a back surface of back contact solar cell 20.

First-conductivity-type impurity diffusion regions 22, each of which is formed by diffusion of a first-conductivity-type impurity, and second-conductivity-type impurity diffusion regions 23, each of which is formed by diffusion of a second-conductivity-type impurity, are alternately formed at predetermined intervals in a back surface of semiconductor substrate 21.

An electrode for first conductivity type 24, which contacts with first-conductivity-type impurity diffusion region 22 through a contact hole made in passivation film 26 of the back surface of semiconductor substrate 21, and an electrode for second conductivity type 25, which contacts with second-conductivity-type impurity diffusion region 23 through the contact hole, are provided in the back surface of semiconductor substrate 21.

In the case that the conductivity type is the n-type, phosphorus and the like can be used as the first-conductivity-type diffusion impurity and the second-conductivity-type diffusion impurity. In the case that the conductivity type is the p-type, boron and the like can be used.

Plural pn junctions are formed by the above configuration at an interface between first-conductivity-type impurity diffusion region 22 or second-conductivity-type impurity diffusion region 23 and an inside of semiconductor substrate 21. The pn junction may be formed by a contact of first-conductivity-type impurity diffusion region 22 with second-conductivity-type impurity diffusion region 23 that is close to first-conductivity-type impurity diffusion region 22.

When semiconductor substrate 21 has the conductivity type of either the n-type or the p-type, first-conductivity-type impurity diffusion region 22 and second-conductivity-type impurity diffusion region 23 are coupled to the inside of semiconductor substrate 21, respectively. Therefore, each of electrode for first conductivity type 24 and electrode for second conductivity type 25 constitutes an electrode corresponding to each of the plural pn junctions formed in the back surface of semiconductor substrate 21.

At least a partial surface of one of or both electrode for first conductivity type 24 and electrode for second conductivity type 25 of back contact solar cell 20 may be coated with an electric conductor containing at least one kind of material selected from a group consisting of nickel (Ni), gold (Au), platinum (Pt), palladium (Pd), silver (Ag), tin (Sn), Sn-Pb solder, and ITO (Indium Tin Oxide).

This provides good electric connection between wiring material 16 of wiring sheet 10 and the coated electrode of back contact solar cell 20, and a weather resistance of the electrode of back contact solar cell 20 can be improved.

A surface treatment, such as blacking processing, may be performed to at least the partial surface of one of or both electrode for first conductivity type 24 and electrode for second conductivity type 25 of back contact solar cell 20.

For example, a silicon substrate made of polycrystalline silicon or a single-crystal silicon, which has the conductivity type of the n-type or the p-type, can be used as semiconductor substrate 21.

For example, the electrode made of metal, such as silver, can be used as electrode for first conductivity type 24 and electrode for second conductivity type 25.

For example, a silicon oxide film, a silicon nitride film, or a laminated body of the silicon oxide film and the silicon nitride film can be used as passivation film 26.

For example, the silicon nitride film can be used as antireflection film 27.

A concept of the back contact solar cell of the invention includes not only the above configuration in which both electrode for first conductivity type 24 and electrode for second conductivity type 25 are formed only on the back surface of the semiconductor substrate 21, but also what is called a back contact solar cell, such as an MWT (Metal Wrap Through) cell that is a solar cell having a configuration in which part of the electrode is disposed in a through-hole made in the semiconductor substrate.

As illustrated in Fig. 3, electrode first conductivity type 24 of back contact solar cell 20 is electrically connected to first wiring 12 of wiring sheet 10. Electrode for second conductivity type 25 of back contact solar cell 20 is electrically connected to second wiring 13 of wiring sheet 10.

It is necessary to provide the good electric connection between an electrode pattern of back contact solar cell 20 and a wiring pattern of wiring sheet 10. Therefore, desirably alignment accuracy between the electrode pattern and the wiring pattern is enhanced in connecting back contact solar cell 20 and wiring sheet 10.

In the invention, in order to enhance the alignment accuracy between back contact solar cell 20 and wiring sheet 10, an alignment mark is provided in the back contact solar cell, and a different shape portion is provided in the wiring of the wiring sheet. As to an alignment method, as illustrated in Fig. 3, relative positions of back contact solar cell 20 and wiring sheet 10 are adjusted while the alignment mark is checked from a direction of an arrow A or an arrow B using observation device 15. The alignment mark of the first embodiment will be described below.

### (Alignment Mark in Back contact Solar Cell)

Fig. 4 is a plan view illustrating the back surface of the back contact solar cell of the first embodiment. Only a column L₁ and a column L₂ in Fig. 1 are partially illustrated in Fig. 4.

As illustrated in Fig. 4, the alignment mark of back contact solar cell 20 is formed in an inner region located inside of an outer periphery of the electrode pattern including the plural electrodes, which are formed on one of surface sides of semiconductor substrate 21 constituting back contact solar cell 20. In Fig. 4, a boundary line of the inner region is indicated by a dotted line.

The inner region contains all the electrodes included in the electrode pattern provided with plural electrodes for first conductivity type 24 and plural electrodes for second conductivity type 25 in one back contact solar cell 20, and the inner region is formed by one polygon in which an interior angle is less than or equal to 180 °. Accordingly, in the case that a line continuously connecting end portions of the electrodes is locally dented, part of the boundary line of the inner region is formed by a line connecting both ends of the dented portion.

For example, in the first embodiment in Fig. 4, electrode for second conductivity type 25 in a column in which an alignment mark 25a or an alignment mark 25b is provided is formed shorter than other electrodes for first conductivity type 24 and other electrodes for second conductivity type 25. In this case, the inner region is defined by other electrodes for first conductivity type 24 and other electrodes for second conductivity type 25 (the region indicated by the dotted line) irrespective of shortly-formed electrode for second conductivity type 25.

In the first embodiment, as illustrated in Fig. 4, circular-point-like alignment marks 25a and 25b are formed near a leading end of shortly-formed electrode for second conductivity type 25. That is, alignment marks 25a and 25b are located in a space where the plural electrodes are not located in the inner region.

Specifically, the electrode pattern includes plural electrode lines in which plural linearly-extending electrodes for first conductivity type 24 and plural linearly-extending electrodes for second conductivity type 25 are arrayed in parallel. The space is formed such that one of end portions in an electrode extending direction in at least one of the plural electrode lines is located inside of one of end portions in each of other electrode lines in the extending direction.

In the first embodiment, alignment marks 25a and 25b are formed on an extended line of the electrode line. Alternatively, each of alignment marks 25a and 25b may be formed between the electrode lines adjacent to each other.

When the alignment mark is formed outside of the inner region, an area of the region, which is the outside of the inner region and the electrode is not disposed, is enlarged to degrade a collection efficiency of the generated power. Therefore, a power generation efficiency per unit area of the solar cell is degraded.

In back contact solar cell 20 of the first embodiment, alignment marks 25a and 25b are formed in the inner region, so that the alignment between back contact solar cell 20 and wiring sheet 10 can be achieved without enlarging the region where the power is not taken out.

Back contact solar cell 20 disposed in column L₁ and back contact solar cell 20 disposed in column L2 have the same electrode pattern.

Alignment mark 25a formed in back contact solar cell 20 disposed in column L₁ and alignment mark 25b formed in back contact solar cell 20 disposed in column L2 are disposed so as to be overlapped with each other when one of back contact solar cells 20 is rotated by 180° in a paper plane of Fig. 4 to overlap patterns of electrodes for first conductivity type 24 with patterns of electrodes for second conductivity type 25. Accordingly, back contact solar cell 20 disposed in column L2 can be disposed by rotating back contact solar cell 20 disposed in column L₁ by 180° in the paper plane.

Alignment marks 25a and 25b is made of the same material as plural electrodes for first conductivity type 24 and plural electrodes for second conductivity type 25.

In this case, electrode for first conductivity type 24 and electrode for second conductivity type 25 and alignment marks 25a and 25b can be formed in one process. For example, accuracy of a positional relationship can be enhanced by preparing electrode for first conductivity type 24 and electrode for second conductivity type 25 and alignment marks 25a and 25b in the same process using photolithography or screen printing. At this point, preferably widths of alignment marks 25a and 25b is substantially equal to that of the electrode line. Therefore, alignment marks 25a and 25b can be formed without changing an electrode forming process.

The positions of alignment marks 25a and 25b are not limited to the positions in Fig. 4. For example, alignment marks 25a and 25b may be formed in the inner region on the extended line of the electrode line disposed on the outermost side of back contact solar cell 20.

### (Identical Shape Portion and Different Shape Portion in Wiring Sheet)

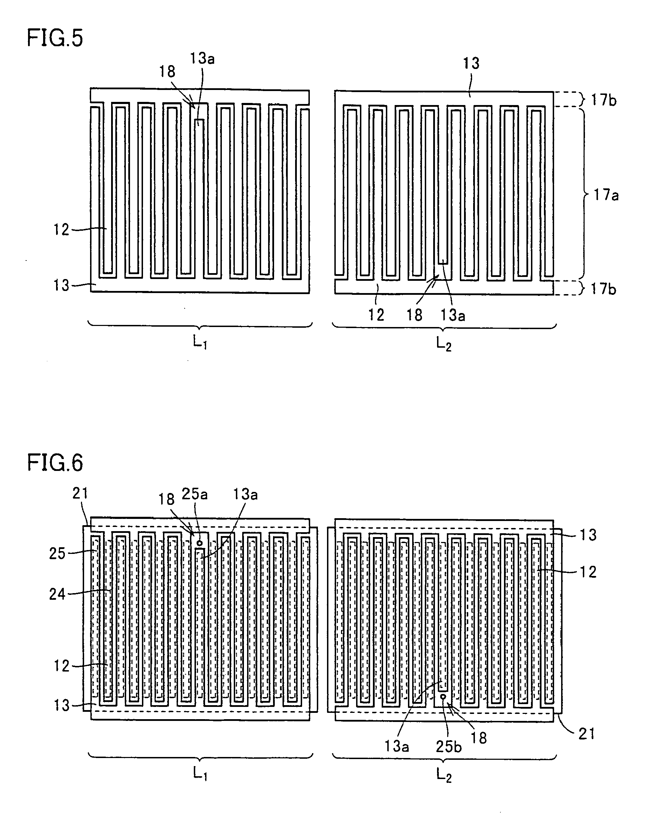

Fig. 5 is a plan view illustrating the wiring pattern of the wiring sheet of the first embodiment. In Fig. 5, only the wiring material is illustrated with respect to parts of columns L₁ and L₂ in Fig. 1.

As illustrated in Fig. 5, wiring sheet 10 includes the wiring in order to electrically connect plural back contact solar cells 20. The wiring includes plural identical shape portions having the same shape and at least one different shape portion having a shape different from that of the identical shape portion.

The wiring includes first wiring 12 that connects electrode for first conductivity type 24 and second wiring 13 that connects electrode for second conductivity type 25. First wiring 12 and second wiring 13 are electrically insulated from each other. Each of first wiring 12 and second wiring 13 includes plural comb-tooth-shaped portions 17a and a connection wiring portion 17b that connects plural comb-tooth-shaped portions 17a.

At least one of first wiring 12 and second wiring 13 includes the identical shape portion and the different shape portion. In the first embodiment, second wiring 13 includes a different shape portion 13a. Different shape portion 13a such that at least one of plural comb-tooth-shaped portions 17a is shorter than other comb-tooth-shaped portions 17a that are the identical shape portion.

As illustrated in Fig. 5, in the first embodiment, comb-tooth-shaped portion 17a of second wiring 13, which is located in the center of the direction in which plural comb-tooth-shaped portions 17a are arrayed, is formed shorter than other comb-tooth-shaped portions 17a. An alignment target region 18 is defined by different shape portion 13a. In the first embodiment, alignment target region 18 is a wiring non-existence region where wiring material 16 is not disposed on insulating base material 11.

Alignment target region 18 of wiring sheet 10 disposed in column L₁ and alignment target region 18 of wiring sheet 10 disposed in column L2 are disposed so as to be overlapped with each other when one of wiring sheets 10 is rotated by 180 ° in the paper plane of Fig. 5 to overlap patterns of first wirings 12 with patterns of first wirings 12.

There is no particular limitation to insulating base material 11 of wiring sheet 10 as long as an electrically insulating material is used. For example, a material including at least one kind of resin selected from a group consisting of PET (polyethylene terephthalate), PEN (polyethylene naphthalate) PPS (polyphenylene sulfide), PVF (polyvinyl fluoride), and polyimide.

There is no particular limitation to a thickness of insulating base material 11. For example, the thickness ranges from 10 µm to 200 µm. Insulating base material 11 may have a single-layer structure or a stacked-layer structure including at least two layers.

There is no particular limitation to wiring material 16 as long as an electrically conductive material is used. For example, a material including at least one kind of metal selected from a group consisting of copper, aluminum, and silver can be used.

There is no particular limitation to the thickness of each of first wiring 12 and second wiring 13. For example, the thickness ranges from 5 µm to 75 µm. There is no particular limitation to the pattern shape of each of first wiring 12 and second wiring 13 as long as each of first wiring 12 and second wiring 13 has the identical shape portion and the different shape portion, but the pattern shape may properly be set.

At least a partial surface of one of or both first wiring 12 and second wiring 13 may be coated with an electric conductor containing at least one kind of material selected from a group consisting of nickel (Ni), gold (Au), platinum (Pt), palladium (Pd), silver (Ag), tin (Sn), Sn-Pb solder, and ITO (Indium Tin Oxide).

This provides the good electric connection between wiring material 16 of wiring sheet 10 and the coated electrode of back contact solar cell 20, and the weather resistances of first wiring 12 and second wiring 13 can be improved.

The surface treatment, such as blacking processing, may be performed to at least the partial surface of one of or both first wiring 12 and second wiring 13. First wiring 12 and second wiring 13 may have the single-layer structure or the stacked-layer structure including at least two layers.

As to a production method for wiring sheet 10, insulating base material 11, such as a PET film, is prepared. An electric conductor, such as a metallic foil and a metallic plate, is bonded to the whole of one of the surfaces of insulating base material 11.

Then, the electric conductor bonded to the surface of insulating base material 11 is partially removed to perform patterning by photo-etching, thereby forming first wiring 12 and second wiring 13.

In the case that alignment target region 18 is set to the wiring non-existence region, preferably a transmittance ratio of insulating base material 11 and wiring material 16 at a specific wavelength becomes ten times or more. Therefore, alignment target region 18 can accurately be recognized in a process of aligning back contact solar cell 20 and wiring sheet 10 with each other.

### (Alignment between Back Contact Solar Cell and Wiring Sheet)

Fig. 6 is a plan view illustrating a state in which the back contact solar cell and the wiring sheet of the first embodiment are overlapped with each other when viewed from the back surface side of the solar cell having wiring sheet. Only columns L₁ and L₂ in Fig. 1 are partially illustrated in Fig. 6.

As illustrated in Fig. 6, back contact solar cell 20 and wiring sheet 10 are aligned with each other such that alignment marks 25a and 25b of back contact solar cell 20 and alignment target regions 18 defined by different shape portions 13a of wiring sheets 10 are disposed while overlapped with each other.

In the first embodiment, the wiring non-existence region constituting alignment target region 18 is defined near the leading end of different shape portion 13a, because different shape portion 13a is formed shorter than other first wirings 12 and other second wirings 13, which are the identical shape portion.

As illustrated in Fig. 3, the alignment between back contact solar cell 20 and wiring sheet 10 is performed while back contact solar cell 20 and wiring sheet 10 are observed from the directions of arrows A and B using observation devices 15.

In the case that back contact solar cell 20 and wiring sheet 10 are observed from the direction of arrow A, back contact solar cell 20 is irradiated with light transmitted through back contact solar cell 20 from the side of back contact solar cell 20, and back contact solar cell 20 and wiring sheet 10 are overlapped with each other while alignment marks 25a and 25b and alignment target regions 18 are checked, thereby aligning back contact solar cell 20 and wiring sheet 10 with each other.

Alternatively, back contact solar cell 20 is irradiated with the light reflected by back contact solar cell 20 from the side of wiring sheet 10, and back contact solar cell 20 and wiring sheet 10 are overlapped with each other while alignment marks 25a and 25b and alignment target regions 18 are checked, thereby aligning back contact solar cell 20 and wiring sheet 10 with each other.

In the case that back contact solar cell 20 and wiring sheet 10 are observed from the direction of arrow B, back contact solar cell 20 is irradiated with the light transmitted through back contact solar cell 20 from the side of wiring sheet 10, and back contact solar cell 20 and wiring sheet 10 are overlapped with each other while alignment marks 25a and 25b and alignment target regions 18 are checked, thereby aligning back contact solar cell 20 and wiring sheet 10 with each other.

For example, an X-ray and an IR (infrared) ray can be used as the light transmitted through back contact solar cell 20. For example, light emitted from an LED (Light Emitting Diode) or a halogen lamp may be used as the light reflected by back contact solar cell 20.

Specifically, back contact solar cell 20 and wiring sheet 10 are aligned with each other such that alignment marks 25a and 25b are disposed in alignment target regions 18 and on the extended line of the different shape portion 13a. In the first embodiment, an error in positions of back contact solar cell 20 and wiring sheet 10 can be reduced to 50 µm or less.

At this point, the solar cell having wiring sheet is formed by joining back contact solar cell 20 and wiring sheet 10.

In the case that alignment target region 18 is set to the wiring non-existence region, preferably the light, with which back contact solar cell 20 is irradiated to observe the alignment mark and the alignment target in the alignment process, includes light having a wavelength in which the transmittance ratio of insulating base material 11 and wiring material 16 is greater than or equal to ten times.

In the case that the alignment mark is checked by irradiating back contact solar cell 20 with the light transmitted through back contact solar cell 20, preferably the light includes light having a wavelength in which the transmittance ratio of alignment marks 25a and 25b and surrounding semiconductor substrate 21 is greater than or equal to ten times. In the case that the alignment mark is checked by irradiating back contact solar cell 20 with the light reflected by back contact solar cell 20, preferably the light includes light having a wavelength in which the transmittance ratio of alignment marks 25a and 25b and surrounding semiconductor substrate 21 is greater than or equal to five times. Therefore, alignment marks 25a and 25b and alignment target regions 18 can accurately be recognized.

### (Solar Cell Module)

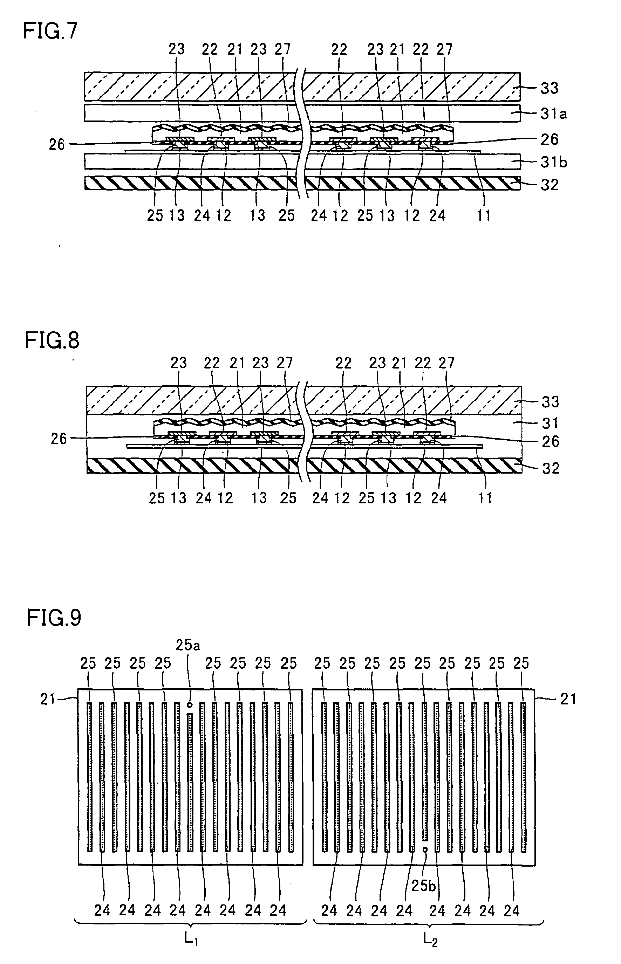

Fig. 7 is a sectional view illustrating a state before the solar cell having wiring sheet is sealed. Fig. 8 is a sectional view illustrating a state in which the solar cell having wiring sheet is sealed to form the solar cell module.

As illustrated in Fig. 7, the solar cell having wiring sheet is disposed between a back-surface protecting sheet 32 and a transparent substrate 33. A first transparent resin 31a is disposed between back contact solar cell 20 of the solar cell having wiring sheet and transparent substrate 33. A second transparent resin 31 b is disposed between wiring sheet 10 of the solar cell having wiring sheet and back-surface protecting sheet 32.

A heat treatment is performed while back-surface protecting sheet 32 and transparent substrate 33 are pressed so as to be nipped. As a result, as illustrated in Fig. 8, after being softened and integrated, first transparent resin 31a and second transparent resin 31b are hardened to constitute a sealing material 31. The solar cell module is formed by sealing the solar cell having wiring sheet in sealing material 31.

Contractive force is generated when first transparent resin 31a and second transparent resin 31b are hardened to constitute sealing material 31. The strong pressure bonding of back contact solar cell 20 and wiring sheet 10 is performed by the contractive force.

Therefore, the joining between electrode for first conductivity type 24 of back contact solar cell 20 and first wiring 12 of wiring sheet 10 is strengthened. Similarly the joining between electrode for second conductivity type 25 of back contact solar cell 20 and second wiring 13 of wiring sheet 10 is also strengthened. As a result, the good electric connection is provided in the wiring between the electrode of back contact solar cell 20 and wiring sheet 10.

For example, the pressing and heating process of sealing the solar cell having wiring sheet in sealing material 31 is performed using a device called a laminator that performs vacuum pressure bonding and the heating process. The vacuum pressure bonding is one in which the pressure bonding is performed in a reduced-pressure atmosphere.

A bubble remaining in sealing material 31 can be suppressed by performing the vacuum pressure bonding. A pressure bonding can also be equalized in a joining surface between back contact solar cell 20 and wiring sheet 10.

There is no particular limitation to transparent substrate 33 as long as a substrate transparent to sunlight is used. For example, a glass substrate can be used.

There is no particular limitation to the materials for first transparent resin 31 a and second transparent resin 31 b as long as a resin transparent to the sunlight is used. The same kind of the transparent resin or different kinds of transparent resins may be used as first transparent resin 31 a and second transparent resin 31 b.

In sealing the solar cell having wiring sheet in sealing material 31, a temperature of the heating process is properly determined according to melting points of first transparent resin 31 a and second transparent resin 31 b.

An adhesive such as NCP (Non Conductive Paste) and ACP (Anisotropic Conductive Paste) or solder may be used in order to further strengthen the joining between the electrode of back contact solar cell 20 and the wiring of wiring sheet 10.

For the use of the NCP, preferably the NCP is not applied to the positions of alignment marks 25a and 25b so as not to interrupt the observations of alignment marks 25a and 25b, or the NCP has the high transmittance to the irradiation light used in the alignment process. For the use of the ACP or the solder, preferably the ACP or the solder is applied to at least one of the electrode of back contact solar cell 20 and the wiring of wiring sheet 10.

There is no particular limitation to back-surface protecting sheet 32 as long as the back surface of sealing material 31 can be protected. For example, a weather-resistance film, such as PET, can be used.

Back-surface protecting sheet 32 may include a metallic film, such as aluminum, in order that permeation of water vapor and oxygen into sealing material 31 is sufficiently suppressed to secure long-term reliability of the solar cell module.

In a portion, such as an end face of the solar cell module, in which back-surface protecting sheet 32 is hardly brought into close contact with sealing material 31, back-surface protecting sheet 32 and sealing material 31 are brought into close contact with each other using a moisture-permeability preventing tape, such as a butyl rubber tape.

For example, the solar cell module may be attached so as to be enclosed with a frame made of an aluminum alloy.

Each of the wiring sheet, the solar cell having wiring sheet, and the solar cell module is not limited to the above configuration, but various configurations may be made. For example, alignment marks 25a and 25b of back contact solar cell 20 are provided on the extended line of electrode for first conductivity type 24, and the different shape portion of wiring sheet 10 may be included in first wiring 12. The shapes of alignment marks 25a and 25b are not limited to the circular-point-like shape. For example, alignment marks 25a and 25b may have a quadrangular-point-like shape or a triangular-point-like shape.

In the solar cell having wiring sheet of the first embodiment, alignment marks 25a and 25b are disposed so as not to be overlapped with the wiring. Alternatively, alignment marks 25a and 25b may be disposed so as to be partially overlapped with the wiring. In this case, the power is taken out from parts of alignment marks 25a and 25b joined to the wiring, so that the power generation efficiency of the solar cell having wiring sheet can be improved.

In the first embodiment, one alignment mark is provided for one back contact solar cell 20. Alternatively, plural alignment marks may be provided for one back contact solar cell 20. In this case, preferably the wiring of wiring sheet 10 includes the different shape portion so as to correspond to the plural alignment marks.

According to the above configuration, the good alignment between back contact solar cell 20 and wiring sheet 10 can be performed, and the high-reliability solar cell having wiring sheet and the high-reliability solar cell module can be prepared. Back contact solar cell 20 is disposed in a correct position, so that a filling rate of the solar cell having wiring sheet can be enhanced to improve the power generation efficiency per unit area of the solar cell module.

A back contact solar cell, a wiring sheet, a solar cell having wiring sheet, a solar cell module, and a production method for the solar cell having wiring sheet according to a second embodiment of the invention will be described below.

### <Second Embodiment>

The repetitive description of the same component as the first embodiment is not given because the second embodiment differs from the first embodiment only in the configuration of the different shape portion.

### (Alignment Mark in Back contact Solar Cell)

Fig. 9 is a plan view illustrating a back surface of a back contact solar cell of the second embodiment of the invention. Only columns L₁ and L₂ in Fig. 1 are partially illustrated in Fig. 9.

As illustrated in Fig. 9, a back contact solar cell 20 of the second embodiment includes an electrode pattern and alignment marks 25a and 25b, which are identical to those of back contact solar cell 20 of the first embodiment.

### (Identical Shape Portion and Different Shape Portion in Wiring Sheet)

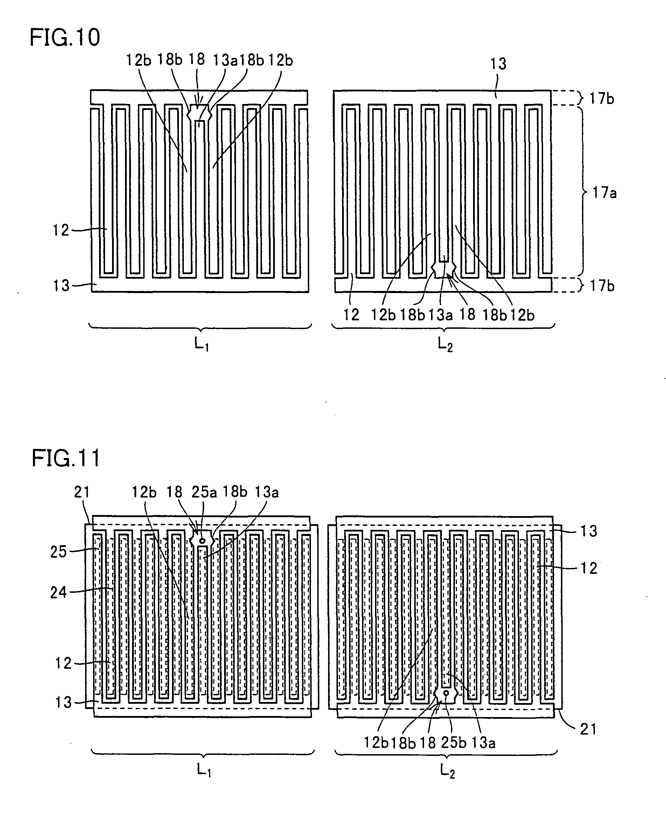

Fig. 10 is a plan view illustrating a wiring pattern of a wiring sheet of the second embodiment. In Fig. 10, only the wiring material is illustrated with respect to parts of columns L₁ and L₂ in Fig. 1.

As illustrated in Fig. 10, in wiring sheet 10 of the second embodiment, both first wiring 12 and second wiring 13 include the different shape portions. Different shape portion 13a of second wiring 13 is identical to that of the first embodiment.

A different shape portion 12b of first wiring 12 is formed such that at least one of plural comb-tooth-shaped portions 17a has a shape in which a gap between comb-tooth-shaped portions 17a adjacent to each other is partially widened.

In the second embodiment, comb-tooth-shaped portions 17a of first wiring 12, which are formed adjacent to different shape portion 13a of second wiring 13 constitute different shape portions 12b. Different shape portion 12b includes a bent portion 18b in which a lateral portion of comb-tooth-shaped portion 17a of first wiring 12 on the side opposite to different shape portion 13a is curved or bent in a position near the leading end of different shape portion 13a. Because different shape portion 12b includes bent portion 18b, comb-tooth-shaped portion 17a of different shape portion 12b is partially thinned compared with other comb-tooth-shaped portions 17a that are the identical shape portions.

However, different shape portion 12b is not limited to the above configuration. Alternatively, while the width of comb-tooth-shaped portion 17a is not changed, comb-tooth-shaped portion 17a may partially be curved or bent by including bent portion 18b. In this case, a portion parallel to bent portion 18b is formed in a lateral portion on the opposite side of the lateral portion of comb-tooth-shaped portion 17a, in which bent portion 18b is formed.

Alignment target regions 18 are defined by different shape portions 12b and different shape portion 13a.

Alignment target region 18 of wiring sheet 10 disposed in column L₁ and alignment target region 18 of wiring sheet 10 disposed in column L₂ are disposed so as to be overlapped with each other when one of wiring sheets 10 is rotated by 180° in the paper plane of Fig. 10 to overlap the patterns of first wirings 12 with the patterns of second wirings 13.

According to the above configuration, preferably the wiring pattern, the electrode pattern corresponding to alignment target region 18, and one kind of back contact solar cell 20 including alignment marks 25a and 25b can commonly be disposed in both columns L₁ and L₂.

### (Alignment between Back contact Solar Cell and Wiring Sheet)

Fig. 11 is a plan view illustrating a state in which the back contact solar cell and the wiring sheet of the second embodiment are overlapped with each other when viewed from the back surface side of the solar cell having wiring sheet. Only columns L₁ and L₂ in Fig. 1 are partially illustrated in Fig. 11.

As illustrated in Fig. 11, the alignment between back contact solar cell 20 and wiring sheet 10 is performed such that alignment marks 25a and 25b of back contact solar cell 20 and alignment target region 18 defined by different shape portions 12b and 13a of wiring sheet 10 are disposed while overlapped with each other.

In the second embodiment, different shape portion 13a is formed shorter than first wiring 12 and second wiring 13, which are the identical shape portions. Different shape portion 12b is partially formed shorter than first wiring 12 and second wiring 13, which are the identical shape portions. As a result, the wiring non-existence region, which constitutes alignment target region 18 while sandwiched between two different shape portions 12b, is defined near the leading end of different shape portion 13a.

The alignment between back contact solar cell 20 and wiring sheet 10 can be performed with high accuracy such that alignment marks 25a and 25b and alignment target regions 18 are overlapped with each other based on bent portion 18b of different shape portion 12b in addition to the leading end of different shape portion 13a.

The width of alignment target region 18 is partially increased by bent portion 18b of different shape portion 12b, so that the widths of alignment marks 25a and 25b can be increased according to the increased width of alignment target region 18. In this case, visibility of alignment marks 25a and 25b can be improved.

In the second embodiment, one alignment mark is provided for one back contact solar cell 20. Alternatively, plural alignment marks may be provided for one back contact solar cell 20. In this case, preferably the wiring of wiring sheet 10 includes the different shape portion so as to correspond to the plural alignment marks.

In the second embodiment, the good alignment between back contact solar cell 20 and wiring sheet 10 can be performed to prepare the high-reliability solar cell having wiring sheet and the high-reliability solar cell module.

The second embodiment can also be applied by a combination with another embodiment. That is, in another embodiment, alignment target region 18 can be defined by the comb-tooth-shaped portion in which the different shape portion, such as the bent portion, is formed like the second embodiment.

A back contact solar cell, a wiring sheet, a solar cell having wiring sheet, a solar cell module, and a production method for the solar cell having wiring sheet according to a third embodiment of the invention will be described below.

### <Third Embodiment>

The repetitive description of the same component as the first and second embodiments is not given because the third embodiment differs from the first and second embodiments only in the configuration of the different shape portion.

### (Alignment Mark in Back contact Solar Cell)

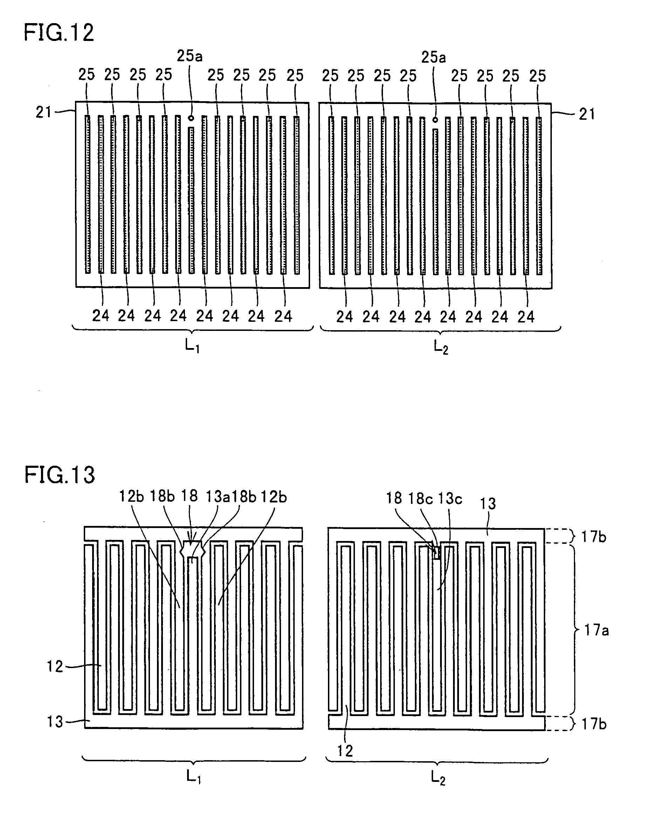

Fig. 12 is a plan view illustrating a back surface of a back contact solar cell of the third embodiment of the invention. Only columns L₁ and L₂ in Fig. 1 are partially illustrated in Fig. 12.

As illustrated in Fig. 12, in back contact solar cell 20 of the third embodiment of the invention, back contact solar cell 20 disposed in column L₁ and back contact solar cell 20 disposed in column L₂ have the identical electrode pattern.

Specifically, in each of back contact solar cells 20 disposed in columns L₁ and L₂, electrode for second conductivity type 25 is formed short. Circular-point-like alignment mark 25a is formed near the leading end of shortly-formed electrode for second conductivity type 25.

### (Identical Shape Portion and Different Shape Portion in Wiring Sheet)

Fig. 13 is a plan view illustrating a wiring pattern of a wiring sheet of the third embodiment. In Fig. 13, only the wiring material is illustrated with respect to parts of columns L₁ and L₂ in Fig. 1.

As illustrated in Fig. 13, in wiring sheet 10 disposed in column L₁, alignment target region 18 is defined by two different shape portions 12b and different shape portion 13a like wiring sheet 10 of the second embodiment.

In wiring sheet 10 disposed in column L₂, second wiring 13 includes a different shape portion 13c. Different shape portion 13c is formed such that second wiring 13 includes a rectangular opening 18c.

As illustrated in Fig. 13, in the third embodiment, opening 18c is formed in comb-tooth-shaped portion 17a of second wiring 13, which is located in the center of the direction in which plural comb-tooth-shaped portions 17a are arrayed. Alignment target region 18 is defined by different shape portion 13c.

Opening 18c is not limited to the rectangular shape, but opening 18c may be formed into a circular or polygonal shape. Opening 18c may have the shape, in which alignment mark 25a cab be observed while the surroundings of opening 18c are overlapped with the electrode pattern to cause different shape portion 13c to act as the wiring. Accordingly, opening 18c is not limited to the case that opening 18c is formed in the center of the width direction of the wiring as illustrated in Fig. 13, but opening 18c may be formed while biased toward the end portion in the width direction of the wiring. It is not always necessary that the whole periphery of opening 18c be surrounded by the wiring, namely, opening 18c may partially be opened.

Opening 18c may be formed in connection wiring portion 17b, or may be disposed while straddling comb-tooth-shaped portion 17a and connection wiring portion 17b.

### (Alignment between Back contact Solar Cell and Wiring Sheet)

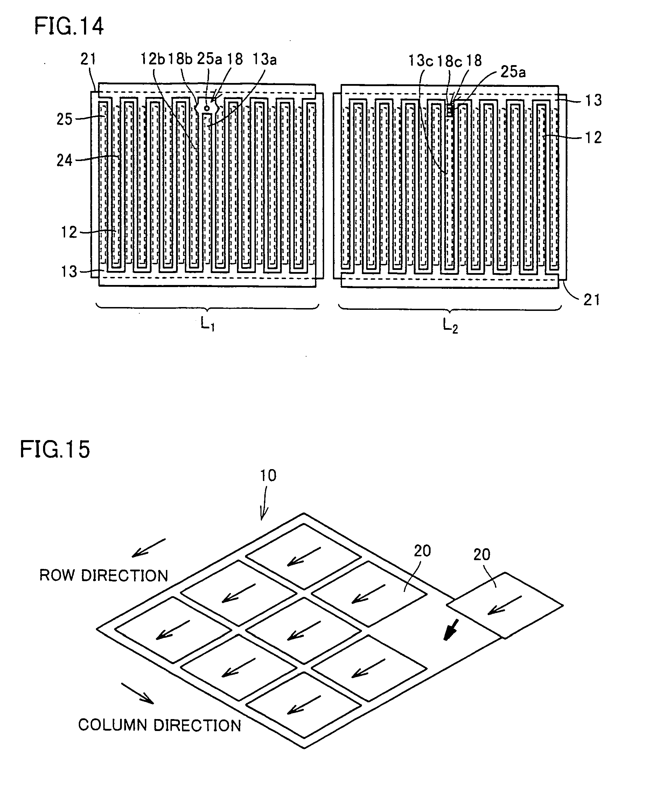

Fig. 14 is a plan view illustrating a state in which the back contact solar cell and the wiring sheet of the third embodiment are overlapped with each other when viewed from the back surface side of the solar cell having wiring sheet. Only columns L₁ and L₂ in Fig. 1 are partially illustrated in Fig. 14.

As illustrated in Fig. 14, the alignment between back contact solar cell 20 and wiring sheet 10 is performed such that alignment mark 25a of back contact solar cell 20 disposed in column L₁ and alignment target region 18 defined by different shape portions 12b and 13a of wiring sheet 10 are disposed while overlapped with each other.

The alignment between back contact solar cell 20 and wiring sheet 10 is also performed such that alignment mark 25a of back contact solar cell 20 disposed in column L₂ and alignment target region 18 defined by different shape portion 13c of wiring sheet 10 are disposed while overlapped with each other.

In the third embodiment, different shape portion 13c is formed such that the wiring includes opening 18c. Therefore, in different shape portion 13c, comb-tooth-shaped portion 17a and connection wiring portion 17b can be connected through the surrounding of opening 18c. As a result, alignment target region 18 can be formed while the degradation of the power generation efficiency of the solar cell having wiring sheet is suppressed.

Fig. 15 is a perspective view illustrating the state in which the back contact solar cell and the wiring sheet of the third embodiment are overlapped with each other. In each of back contact solar cells 20, arrows oriented toward the side on which alignment mark 25a is disposed is illustrated in Fig. 15.

In back contact solar cell 20 of the third embodiment, as described above, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, as illustrated in Fig. 5, irrespective of the column, all back contact solar cells 20 can be disposed on wiring sheet 10 while alignment mark 25a is located on the leading end side indicated by the arrow. Accordingly, component management is easy to perform, and the production process is reduced to improve the production efficiency.

In the third embodiment, one alignment mark is provided for one back contact solar cell 20. Alternatively, plural alignment marks may be provided for one back contact solar cell 20. In this case, preferably the wiring of wiring sheet 10 includes the different shape portion so as to correspond to the plural alignment marks.

In the third embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a fourth embodiment of the invention will be described below.

### <Fourth Embodiment>

The repetitive description of the same component as the first to third embodiments is not given because the fourth embodiment differs from the first to third embodiments only in the position of the alignment mark and the configuration of the different shape portion.

### (Alignment Mark in Back contact Solar Cell)

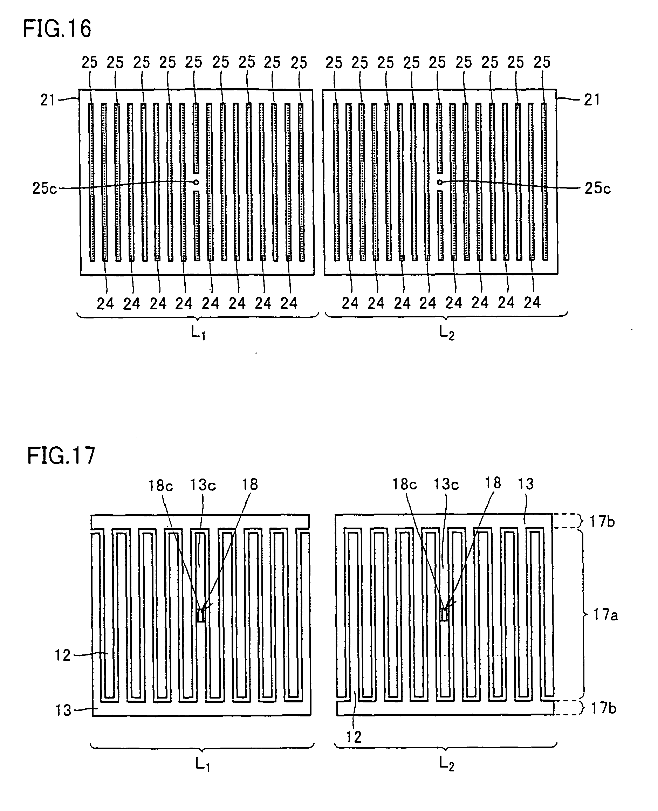

Fig. 16 is a plan view illustrating a back surface of a back contact solar cell of the fourth embodiment of the invention. Only columns L₁ and L₂ in Fig. 1 are partially illustrated in Fig. 16.

As illustrated in Fig. 16, in back contact solar cell 20 of the fourth embodiment of the invention, back contact solar cell 20 disposed in column L₁ and back contact solar cell 20 disposed in column L₂ have the identical electrode pattern.

Specifically, an alignment mark 25c is formed in a space of the gap between the electrodes such that at least one of the plural electrode lines is separated in the electrode extending direction.

As illustrated in Fig. 16, in the fourth embodiment, electrode for second conductivity type 25 located in the center of the direction in which the electrodes are arrayed is separated in the extending direction of electrode for second conductivity type 25. Circular-point-like alignment mark 25c is formed in the gap between the separated electrodes for second conductivity type 25. Alignment mark 25c is formed in the substantial center of the back surface of back contact solar cell 20.

### (Identical Shape Portion and Different Shape Portion in Wiring Sheet)

Fig. 17 is a plan view illustrating a wiring pattern of a wiring sheet of the fourth embodiment. In Fig. 17, only the wiring material is illustrated with respect to parts of columns L₁ and L₂ in Fig. 1.

As illustrated in Fig. 17, in wiring sheets 10 disposed in columns L₁ and L₂, second wiring 13 includes different shape portion 13c. Different shape portion 13c is formed such that second wiring 13 includes rectangular opening 18c.

In the fourth embodiment, opening 18c is formed in comb-tooth-shaped portion 17a of second wiring 13, which is located in the center of the direction in which plural comb-tooth-shaped portions 17a are arrayed. Opening 18c is formed in the center of comb-tooth-shaped portion 17a in the extending direction of comb-tooth-shaped portion 17a. Alignment target region 18 is defined by different shape portion 13c.

### (Alignment between Back contact Solar Cell and Wiring Sheet)

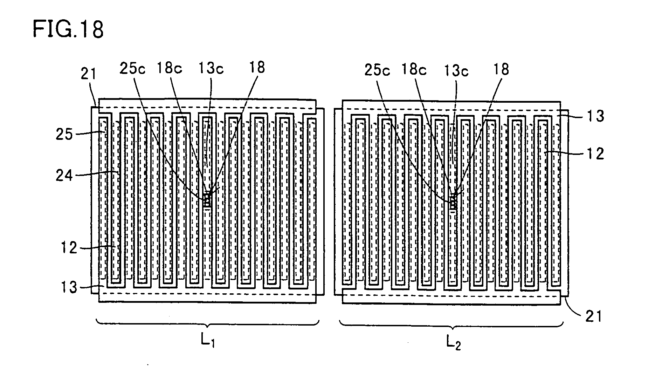

Fig. 18 is a plan view illustrating a state in which the back contact solar cell and the wiring sheet of the fourth embodiment are overlapped with each other when viewed from the back surface side of the solar cell having wiring sheet. Only column L₁ and column L₂ in Fig. 1 are partially illustrated in Fig. 18.

As illustrated in Fig. 18, the alignment between back contact solar cell 20 and wiring sheet 10 is performed such that alignment mark 25c of back contact solar cell 20 and alignment target region 18 defined by different shape portion 13c of wiring sheet 10 are disposed while overlapped with each other.

In back contact solar cell 20 of the fourth embodiment, as described above, back contact solar cell 20 disposed in column L₁ and back contact solar cell 20 disposed in column L₂ have the identical electrode pattern. Alignment mark 25c is located in the center of the back surface of back contact solar cell 20.

Therefore, irrespective of the column, all back contact solar cells 20 can be disposed on wiring sheet 10 while alignment mark 25a is located on the leading end side indicated by the arrow. Accordingly, the component management is easy to perform, and the process to rotate back contact solar cell 20 is reduced to improve the production efficiency.

In the fourth embodiment, one alignment mark is provided for one back contact solar cell 20. Alternatively, plural alignment marks may be provided for one back contact solar cell 20. In this case, preferably the wiring of wiring sheet 10 includes the different shape portion so as to correspond to the plural alignment marks.

In the fourth embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a fifth embodiment of the invention will be described below.

### <Fifth Embodiment>

The repetitive description of the same component as the first embodiment is not given because the fifth embodiment differs from the first embodiment only in the position of the alignment mark and the configuration of the different shape portion.

### (Alignment Mark in Back contact Solar Cell)

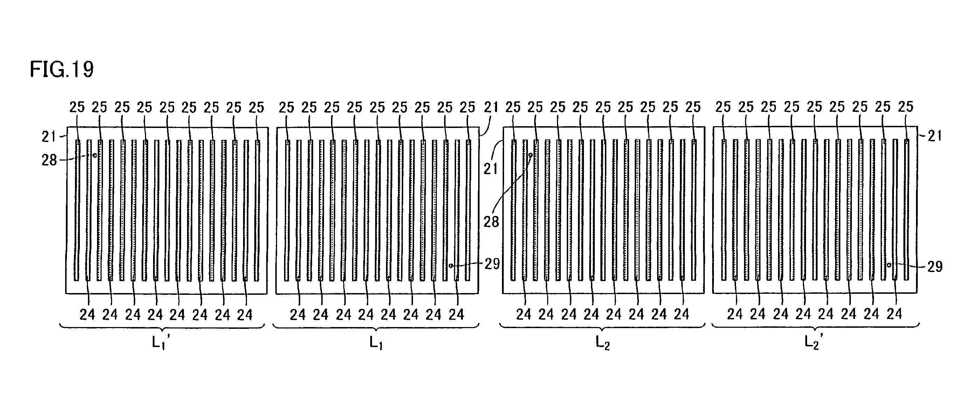

Fig. 19 is a plan view illustrating a back surface of a back contact solar cell of the fifth embodiment of the invention. Only column L₁, column L₁ column L₂, and column L_{2'} in Fig. 1 are partially illustrated in Fig. 19.

As illustrated in Fig. 19, in back contact solar cell 20 of the fifth embodiment of the invention, back contact solar cell 20 disposed in column L₁. and back contact solar cell 20 disposed in column L₂ have the identical electrode pattern. Back contact solar cell 20 disposed in column L₁ and back contact solar cell 20 disposed in column L_{2'} have the identical electrode pattern.

Specifically, each of alignment marks 28 and 29 is formed between the electrode lines adjacent to each other in the plural electrode lines.

As illustrated in Fig. 19, in back contact solar cells 20 disposed in columns L_{1'} and L₂, alignment mark 28 is formed between electrode for first conductivity type 24, which is disposed second from the left, and electrode for second conductivity type 25, which is disposed third from the left. Alignment mark 28 is formed in the inner region. Alignment mark 28 is formed near one of the end portions of the electrode in the electrode extending direction.

In back contact solar cells 20 disposed in columns L₁ and L_{2'}, alignment mark 29 is formed between electrode for first conductivity type 24, which is disposed second from the right, and electrode for second conductivity type 25, which is disposed third from the left. Alignment mark 29 is formed in the inner region. Alignment mark 29 is formed near the other end portion of the electrode in the electrode extending direction.

Alignment marks 29 formed in back contact solar cells 20 disposed in columns L₁ and L₂, and alignment marks 28 formed in back contact solar cell 20 disposed in columns L_{1'} and L₂ are disposed so as to be overlapped with each other when one of back contact solar cells 20 is rotated by 180° in the paper plane of Fig. 19 to overlap patterns of electrodes for first conductivity type 24 with patterns of electrodes for second conductivity type 25. Accordingly, back contact solar cells 20 disposed in columns L₁ and L_{2'} can be disposed such that back contact solar cells 20 disposed in columns L_{1'} and L₂ are rotated by 180° in the paper plane.

### (Identical Shape Portion and Different Shape Portion in Wiring Sheet)

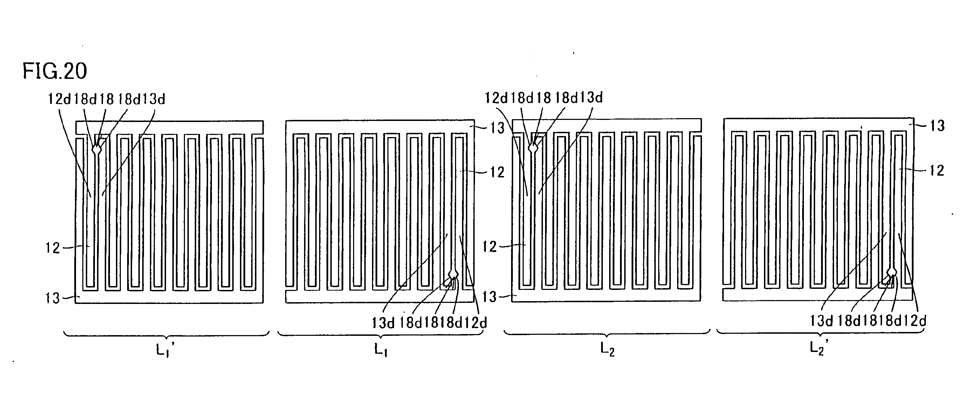

Fig. 20 is a plan view illustrating a wiring pattern of a wiring sheet of the fifth embodiment. In Fig. 20, only the wiring material is illustrated with respect to parts of column L₁, column L_{1'}, column L₂, and column L_{2'} in Fig. 1.

As illustrated in Fig. 20, in wiring sheet 10 of the fifth embodiment, both first wiring 12 and second wiring 13 include the different shape portion.

The different shape portion is formed such that the gap between at least one set of comb-tooth-shaped portions 17a adjacent to each other is partially increased.

In the fifth embodiment, in wiring sheets 10 disposed in columns L₁ and L_{2'}, comb-tooth-shaped portion 17a of first wiring 12, which is formed second from the right, constitutes a different shape portion 12d. Comb-tooth-shaped portion 17a of second wiring 13, which is formed third from the right, constitutes a different shape portion 13d.

In the fifth embodiment, in wiring sheets 10 disposed in columns L_{1'} and L₂, comb-tooth-shaped portion 17a of first wiring 12, which is formed second from the left, constitutes different shape portion 12d. Comb-tooth-shaped portion 17a of first wiring 12, which is formed third from the left, constitutes different shape portion 13d.

Different shape portion 12d and different shape portion 13d are formed opposite each other. Each of different shape portion 12d and different shape portion 13d includes a bent portion 18d in which the lateral portion of comb-tooth-shaped portion 17a on the side on which different shape portion 12d and different shape portion 13d are formed opposite each other is curved or bent, and each of different shape portion 12d and different shape portion 13d is formed such that comb-tooth-shaped portion 17a is partially thinned compared with other comb-tooth-shaped portions 17a that are the identical shape portion.

However, different shape portion 12d and different shape portion 13d are not limited to the above configuration. Alternatively, while the width of comb-tooth-shaped portion 17a is not changed, different shape portion 12d and different shape portion 13d may partially be curved and bent by including bent portion 18d. In this case, a portion parallel to bent portion 18d is formed in a lateral portion on the opposite side of the lateral portion of comb-tooth-shaped portion 17a, in which bent portion 18d is formed.

Alignment target region 18 is defined by different shape portions 12d and different shape portion 13d.

Alignment target regions 18 of wiring sheets 10 disposed in columns L₁ and L_{2'} and alignment target regions 18 of wiring sheets 10 disposed in columns L₁ and L₂ are disposed so as to be overlapped with each other when one of wiring sheets 10 is rotated by 180° in the paper plane of Fig. 20 to overlap the patterns of first wirings 12 with the patterns of second wiring 13.

According to the above configuration, preferably the wiring pattern, the electrode pattern corresponding to alignment target region 18, and one kind of back contact solar cell 20 including alignment marks 25a and 25b can commonly be disposed in all column L₁, column L_{1'}, column L₂, and column L_{2'}.

### (Alignment between Back contact Solar Cell and Wiring Sheet)

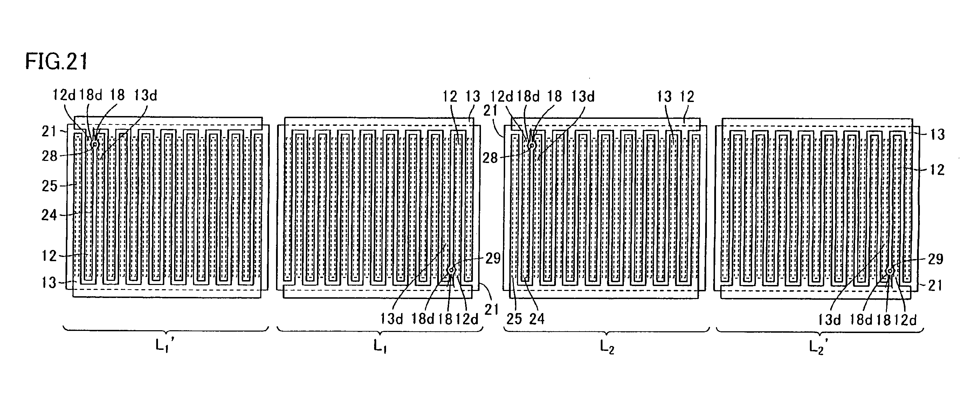

Fig. 21 is a plan view illustrating a state in which the back contact solar cell and the wiring sheet of the fifth embodiment are overlapped with each other when viewed from the back surface side of the solar cell having wiring sheet. Only column L₁, column L₁', column L₂, and column L_{2'} in Fig. 1 are partially illustrated in Fig. 21.

As illustrated in Fig. 21, the alignment between back contact solar cell 20 and wiring sheet 10 is performed such that alignment marks 28 and 29 of back contact solar cells 20 and alignment target regions 18 defined by different shape portions 12d and 13d of wiring sheet 10 are disposed while overlapped with each other.

In the fifth embodiment, different shape portion 12d and different shape portion 13d are partially thinned compared with other first wirings 12 and other second wirings 13, which are the identical shape portion, thereby defining the wiring non-existence region that constitutes alignment target region 18 sandwiched between different shape portion 12d and different shape portion 13d.

In the fifth embodiment, the alignment between back contact solar cell 20 and wiring sheet 10 can be performed with high accuracy such that alignment marks 28 and 29 and alignment target regions 18 are overlapped with each other based on bent portions 18d of different shape portion 12d and different shape portion 13d.

In the fifth embodiment, unlike back contact solar cell 20 of the first embodiment, it is not necessary to partially shorten the electrode line in order to define alignment target region 18. Therefore, the power generation efficiency of the solar cell having wiring sheet can be improved.

In the fifth embodiment, two alignment marks are provided for one back contact solar cell 20. Alternatively, plural alignment marks may be provided for one back contact solar cell 20. In this case, preferably the wiring of wiring sheet 10 includes the different shape portion so as to correspond to the plural alignment marks.

In the fifth embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a sixth embodiment of the invention will be described below.

### <Sixth Embodiment>

The repetitive description of the same component as the first embodiment is not given because the sixth embodiment differs from the first embodiment only in the numbers of alignment marks and different shape portions.

### (Alignment Mark in Back contact Solar Cell)

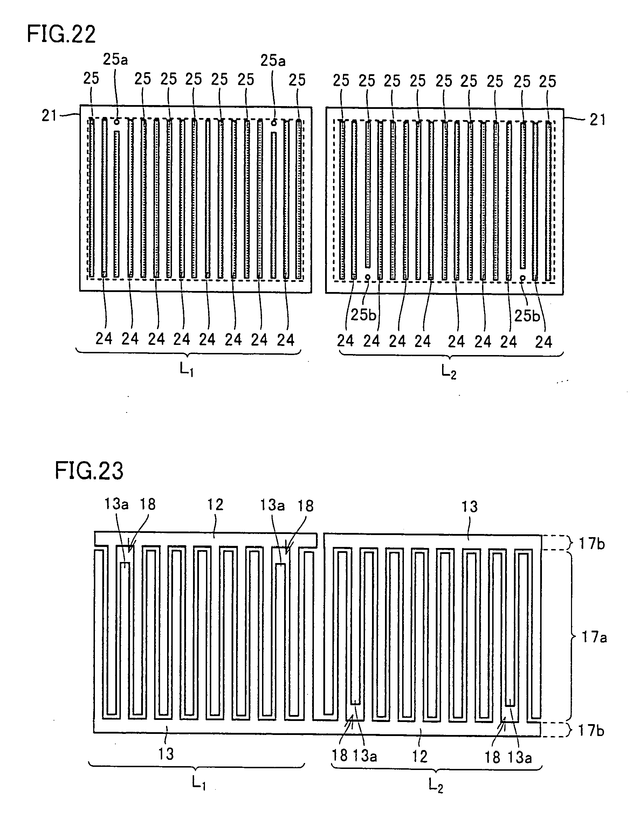

Fig. 22 is a plan view illustrating a back surface of a back contact solar cell of the sixth embodiment of the invention. Only columns L₁ and L₂ in Fig. 1 are partially illustrated in Fig. 22.

As illustrated in Fig. 22, in the fifth embodiment, electrodes for second conductivity type 25, which are disposed third from the left and third from the right in the direction in which the electrodes are arrayed, are formed shorter than other electrodes for first conductivity type 24 and other electrodes for second conductivity type 25.

Circular-point-like alignment mark 25a is formed near the leading end of shortly-formed electrode for second conductivity type 25. That is, alignment mark 25a is located in the space where the electrode is not located in the inner region.

In back contact solar cells 20 disposed in column L₁, plural alignment marks 25a are formed near one of the end portions of the electrode in the electrode extending direction. In back contact solar cells 20 disposed in column L₂, plural alignment marks 25b are formed near the other end portion of the electrode in the electrode extending direction.

Alignment mark 25a formed in back contact solar cell 20 disposed in column L₁ and alignment mark 25b formed in back contact solar cell 20 disposed in column L₂ are disposed so as to be overlapped with each other when one of back contact solar cells 20 is rotated by 180° in the paper plane of Fig. 22 to overlap the patterns of electrodes for first conductivity type 24 with the patterns of electrodes for second conductivity type 25. Accordingly, back contact solar cell 20 disposed in column L₂ can be disposed such that back contact solar cell 20 disposed in column L₁ is rotated by 180° in the paper plane.

### (Identical Shape Portion and Different Shape Portion in Wiring Sheet)

Fig. 23 is a plan view illustrating a wiring pattern of a wiring sheet of the sixth embodiment. In Fig. 23, only the wiring material is illustrated with respect to parts of columns L₁ and L₂ in Fig. 1.

In the sixth embodiment, second wiring 13 includes different shape portions 13a. Different shape portions 13a are formed such that plural comb-tooth-shaped portions 17a are formed shorter than other comb-tooth-shaped portions 17a that are the identical shape portion.

As illustrated in Fig. 23, in each of wiring sheets 10 disposed in columns L₁ and L₂, comb-tooth-shaped portions 17a of second wiring 13, which are disposed third from the left and third from the right in the direction in which plural comb-tooth-shaped portions 17a are arrayed, are formed shorter than other comb-tooth-shaped portions 17a. Alignment target region 18 is defined by different shape portion 13a.

Alignment target region 18 of wiring sheet 10 disposed in column L₁ and alignment target region 18 of wiring sheet 10 disposed in column L₂ are disposed so as to be overlapped with each other when one of wiring sheets 10 is rotated by 180° in the paper plane of Fig. 23 to overlap the patterns of first wirings 12 with the patterns of second wirings 13.

### (Alignment between Back contact Solar Cell and Wiring Sheet)

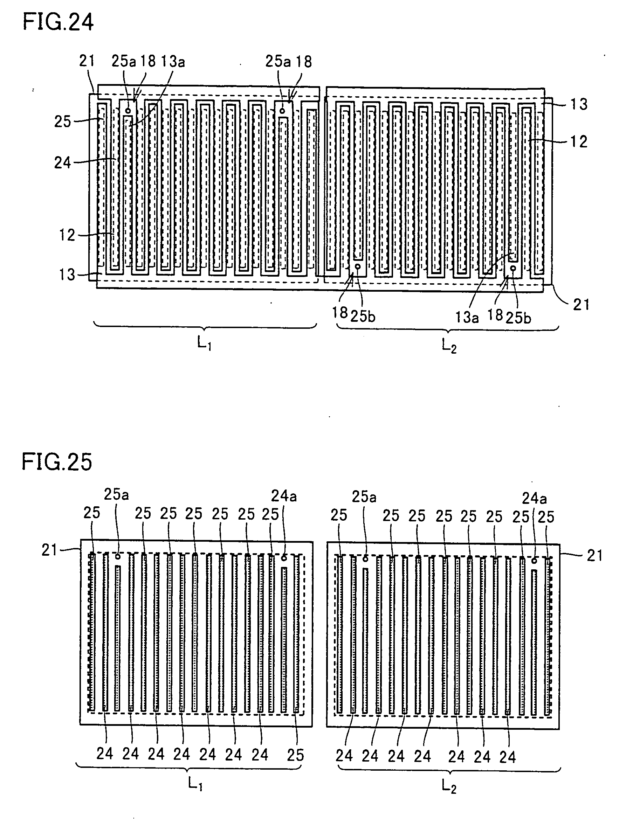

Fig. 24 is a plan view illustrating a state in which the back contact solar cell and the wiring sheet of the sixth embodiment are overlapped with each other when viewed from the back surface side of the solar cell having wiring sheet. Only columns L₁ and L₂ in Fig. 1 are partially illustrated in Fig. 24.

As illustrated in Fig. 24, the alignment between back contact solar cell 20 and wiring sheet 10 is performed such that alignment marks 25a and 25b of back contact solar cell 20 and alignment target regions 18 defined by different shape portions 13a of wiring sheet 10 are disposed while overlapped with each other.

In the sixth embodiment, because two alignment marks 25a are provided for one back contact solar cell 20, the alignment between back contact solar cell 20 and wiring sheet 10 can accurately be performed in not only the vertical and horizontal directions also the rotating direction.

Therefore, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a seventh embodiment of the invention will be described below.

### <Seventh Embodiment>

The repetitive description of the same component as the sixth embodiment is not given because the seventh embodiment differs from the sixth embodiment only in the position of the alignment mark, the number of different shape portions, and the position of the different shape portion.

### (Alignment Mark in Back contact Solar Cell)

Fig. 25 is a plan view illustrating a back surface of a back contact solar cell of the seventh embodiment of the invention. Only columns L₁ and L₂ in Fig. 1 are partially illustrated in Fig. 25.

As illustrated in Fig. 25, in back contact solar cell 20 of the seventh embodiment of the invention, back contact solar cell 20 disposed in column L₁ and back contact solar cell 20 disposed in column L₂ have the identical electrode pattern.

In each of back contact solar cells 20 disposed in column L₁ and L₂, electrode for first conductivity type 24, which is disposed second from the right, and electrode for second conductivity type 25, which is disposed third from the left, are formed short. Circular-point-like alignment mark 24a is formed near the leading end of shortly-formed electrode for first conductivity type 24. Circular-point-like alignment mark 25a is formed near the leading end of shortly-formed electrode for second conductivity type 25. Thus, in the seventh embodiment, two alignment marks 24a and 25a are formed on the extended lines of the electrode lines having different conductivity types, respectively.

### (Identical Shape-Portion and Different Shape Portion in Wiring Sheet)

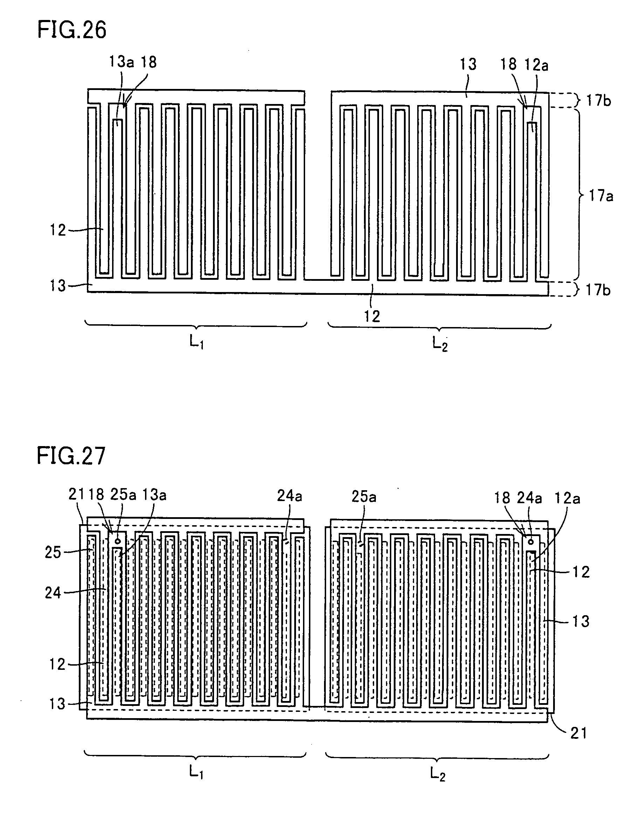

Fig. 26 is a plan view illustrating a wiring pattern of a wiring sheet of the seventh embodiment. In Fig. 26, only the wiring material is illustrated with respect to parts of columns L₁ and L₂ in Fig. 1.

In the seventh embodiment, first wiring 12 and second wiring 13 include different shape portion 12a and different shape portion 13a, respectively. Different shape portions 12a and 13a are formed such that at least one of plural comb-tooth-shaped portions 17a is formed shorter than other comb-tooth-shaped portions 17a that are the identical shape portion.

As illustrated in Fig. 26, in wiring sheet 10 disposed in column L₁, comb-tooth-shaped portion 17a of second wiring 13, which is disposed third from the left in the direction in which plural comb-tooth-shaped portions 17a are arrayed, is formed shorter than other comb-tooth-shaped portions 17a. In wiring sheet 10 disposed in column L₂, comb-tooth-shaped portion 17a of first wiring 12, which is disposed second from the right in the direction in which plural comb-tooth-shaped portions 17a are arrayed, is formed shorter than other comb-tooth-shaped portions 17a.

In wiring sheet 10 disposed in column L₁, alignment target region 18 is defined by different shape portion 13a. In wiring sheet 10 disposed in column L₂, alignment target region 18 is defined by different shape portion 12a.

### (Alignment between Back contact Solar Cell and Wiring Sheet)

Fig. 27 is a plan view illustrating a state in which the back contact solar cell and the wiring sheet of the seventh embodiment are overlapped with each other when viewed from the back surface side of the solar cell having wiring sheet. Only columns L₁ and L₂ in Fig. 1 are partially illustrated in Fig. 27.

As illustrated in Fig. 27, in wiring sheet 10 disposed in column L₁, alignment mark 25a of back contact solar cell 20 and alignment target region 18 defined by different shape portion 13a of wiring sheet 10 are disposed as to be overlapped with each other. Comb-tooth-shaped portion 17a of first wiring 12 and alignment mark 24a are disposed so as to be overlapped with each other.

In wiring sheet 10 disposed in column L₂, alignment mark 24a of back contact solar cell 20 and alignment target region 18 defined by different shape portion 12a of wiring sheet 10 are disposed so as to be overlapped with each other. Comb-tooth-shaped portion 17a of second wiring 13 and alignment mark 25a are disposed so as to be overlapped with each other.

Using back contact solar cell 20 including plural alignment marks, at least one alignment mark is disposed so as to be overlapped with alignment target region 18, and at least one alignment mark is disposed so as to be overlapped with the wiring, thereby performing the alignment between back contact solar cell 20 and wiring sheet 10.

Specifically, in wiring sheet 10 disposed in column L₁, by observing the light transmitted through back contact solar cell 20 from the direction indicated by arrow A in Fig. 3, the alignment between back contact solar cell 20 and wiring sheet 10 is performed such that alignment mark 25a and alignment target region 18 are overlapped with each other, and comb-tooth-shaped portion 17a of first wiring 12 and alignment mark 24a are overlapped with each other.

In wiring sheet 10 disposed in column L₂, by observing the light transmitted through back contact solar cell 20 from the direction indicated by arrow A in Fig. 3, the alignment between back contact solar cell 20 and wiring sheet 10 is performed such that alignment mark 24a and alignment target region 18 are overlapped with each other, and comb-tooth-shaped portion 17a of second wiring 13 and alignment mark 25a are overlapped with each other.

Thus, the alignment between back contact solar cell 20 and wiring sheet 10 can accurately be performed using two alignment marks 24a and 25a. When alignment mark 24a and alignment mark 25a can be distinguished from each other by forming alignment mark 24a and alignment mark 25a into different shapes, the alignment between back contact solar cell 20 disposed in column L₁ and back contact solar cell 20 disposed in column L₂ can accurately be performed while alignment marks 24a and 25a are distinguished from each other.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

As described above, in back contact solar cell 20 of the seventh embodiment, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, as illustrated in Fig. 15, irrespective of the column, all back contact solar cells 20 can be disposed on wiring sheet 10 while alignment marks 24a and 25a are located on the leading end side indicated by the arrow. Accordingly, the component management is easy to perform, and the production process is reduced to improve the production efficiency.

In the seventh embodiment, because alignment mark 24a and alignment mark 25a can be distinguished from each other, for example, when alignment mark 24a and alignment mark 25a are located on the extended line of the electrode lines having the different conductivity types, it can be checked that the alignment between back contact solar cell 20 and wiring sheet 10 is performed such that electrode for first conductivity type 24 of back contact solar cell 20 is properly connected to first wiring 12 of the corresponding wiring sheet, and it can be checked that the alignment between back contact solar cell 20 and wiring sheet 10 is performed such that electrode for second conductivity type 25 of back contact solar cell 20 is properly connected to second wiring 13 of the corresponding wiring sheet. Therefore, production of a defective product, which is caused by an unintended misalignment, can securely be prevented.

In the seventh embodiment, each two of the alignment marks and the different shape portions are provided for one solar cell having wiring sheet. However, the numbers of alignment marks and different shape portions are not limited to those of the seventh embodiment.

In the seventh embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to an eighth embodiment of the invention will be described below.

### <Eighth Embodiment>

The repetitive description of the same component as the seventh embodiment is not given because the eighth embodiment differs from the seventh embodiment only in the configuration of the different shape portion.

### (Alignment Mark in Back contact Solar Cell)

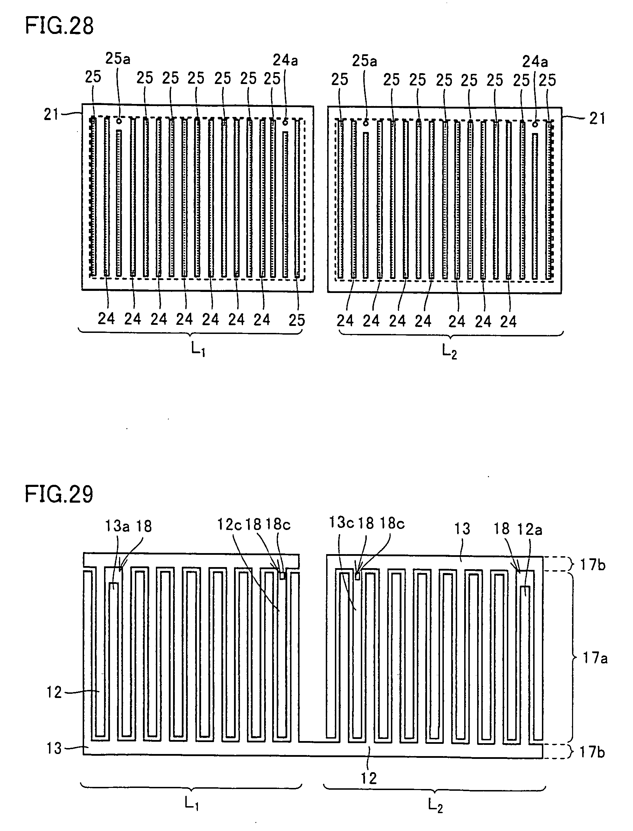

Fig. 28 is a plan view illustrating a back surface of a back contact solar cell of the eighth embodiment of the invention. As illustrated in Fig. 28, in back contact solar cell 20 of the eighth embodiment of the invention, back contact solar cell 20 disposed in column L₁ and back contact solar cell 20 disposed in column L₂ have the identical electrode pattern. Back contact solar cell 20 of the eighth embodiment has the same electrode pattern as back contact solar cell 20 of the seventh embodiment.

### (Identical Shape Portion and Different Shape Portion in Wiring Sheet)

Fig. 29 is a plan view illustrating a wiring pattern of a wiring sheet of the eighth embodiment. In Fig. 29, only the wiring material is illustrated with respect to parts of columns L₁ and L₂ in Fig. 1.

In the eighth embodiment, first wiring 12 includes different shape portions 12a and 12c. Second wiring 13 includes different shape portions 13a and 13c. Different shape portion 12a and 13a are formed such that at least one of plural comb-tooth-shaped portions 17a is shorter than other comb-tooth-shaped portions 17a that are the identical shape portion.

As illustrated in Fig. 29, in wiring sheet 10 disposed in column L₁, comb-tooth-shaped portion 17a of second wiring 13, which is disposed third from the left in the direction in which plural comb-tooth-shaped portions 17a are arrayed, is formed shorter than other comb-tooth-shaped portions 17a. In wiring sheet 10 disposed in column L₂, comb-tooth-shaped portion 17a of first wiring 12, which is disposed second from the right in the direction in which plural comb-tooth-shaped portions 17a are arrayed, is formed shorter than other comb-tooth-shaped portions 17a.

Different shape portions 12c and 13c are formed such that first wiring 12 and second wiring 13 include rectangular openings 18c. In wiring sheet 10 disposed in column L₁, opening 18c is formed in comb-tooth-shaped portion 17a of first wiring 12, which is disposed second from the right. In wiring sheet 10 disposed in column L₂, opening 18c is formed in comb-tooth-shaped portion 17a of second wiring 13, which is disposed third from the left. However, opening 18c may be formed in connection wiring portion 17b, or may be formed while straddling comb-tooth-shaped portion 17a and connection wiring portion 17b.

In wiring sheet 10 disposed in column L₁, alignment target regions 18 are defined by different shape portion 12c and different shape portion 13a, respectively. In wiring sheet 10 disposed in column L₂, alignment target regions 18 are defined by different shape portion 12a and different shape portion 13c, respectively.

### (Alignment between Back Contact Solar Cell and Wiring Sheet)

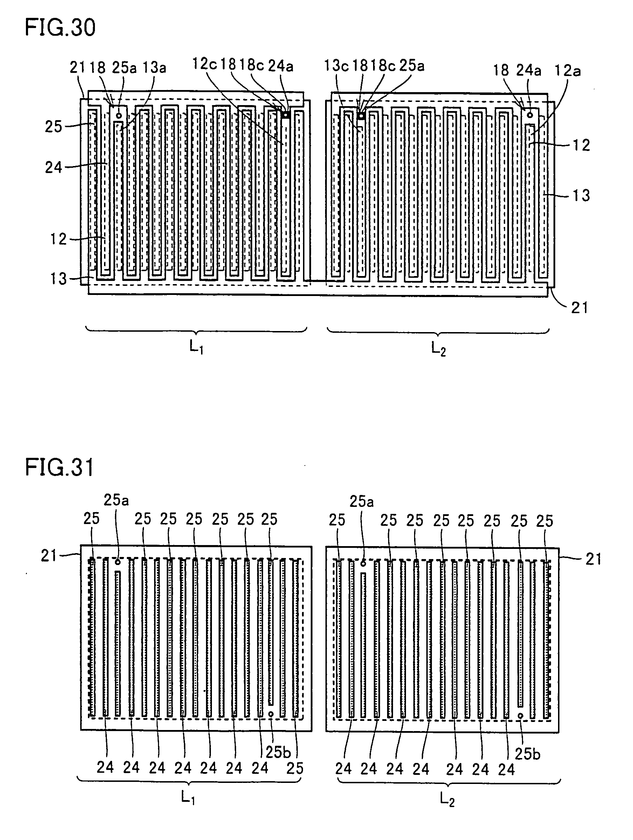

Fig. 30 is a plan view illustrating a state in which the back contact solar cell and the wiring sheet of the eighth embodiment are overlapped with each other when viewed from the back surface side of the solar cell having wiring sheet. Only columns L₁ and

L₂ in Fig. 1 are partially illustrated in Fig. 30.

As illustrated in Fig. 30, in wiring sheet 10 disposed in column L₁, alignment mark 25a of back contact solar cell 20 and alignment target region 18 defined by different shape portion 13a of wiring sheet 10 are disposed while overlapped with each other. Alignment mark 24a of back contact solar cell 20 and alignment target region 18 defined by different shape portion 12c of wiring sheet 10 are disposed while overlapped with each other.

In wiring sheet 10 disposed in column L₂, alignment mark 24a of back contact solar cell 20 and alignment target region 18 defined by different shape portion 12a of wiring sheet 10 are disposed while overlapped with each other. Alignment mark 25a of back contact solar cell 20 and alignment target region 18 defined by different shape portion 13c of wiring sheet 10 are disposed while overlapped with each other.

Using back contact solar cell 20 including plural alignment marks, at least two alignment marks are disposed so as to be overlapped with alignment target regions 18, thereby performing the alignment between back contact solar cell 20 and wiring sheet 10.

In the eighth embodiment, because two alignment marks 24a and 25a are provided for one back contact solar cell 20, the alignment between back contact solar cell 20 and wiring sheet 10 can accurately be performed in not only the vertical and horizontal directions also the rotating direction.

In the eighth embodiment, because alignment mark 24a and alignment mark 25a can be distinguished from each other in each back contact solar cell 20, for example, when alignment mark 24a and alignment mark 25a are located on the extended line of the electrode lines having the different conductivity types, it can be checked that the alignment between back contact solar cell 20 and wiring sheet 10 is performed such that electrode for first conductivity type 24 of back contact solar cell 20 is properly connected to first wiring 12 of the corresponding wiring sheet, and it can be checked that the alignment between back contact solar cell 20 and wiring sheet 10 is performed such that electrode for second conductivity type 25 of back contact solar cell 20 is properly connected to second wiring 13 of the corresponding wiring sheet. Therefore, the production of the defective product, which is caused by an unintended misalignment, can securely be prevented.

In the eighth embodiment, each two of the alignment marks and the different shape portions are provided for one solar cell having wiring sheet. However, the numbers of alignment marks and different shape portions are not limited to those of the eighth embodiment.

In the eighth embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a ninth embodiment of the invention will be described below.

### <Ninth Embodiment>

The repetitive description of the same component as the sixth embodiment is not given because the ninth embodiment differs from the sixth embodiment only in the position of the alignment mark, the number of different shape portions, and the position of the different shape portion.

### (Alignment in Back Contact Solar Cell)

Fig. 31 is a plan view illustrating a back surface of a back contact solar cell of the ninth embodiment of the invention. Only columns L₁ and L₂ in Fig. 1 are partially illustrated in Fig. 31.

As illustrated in Fig. 31, in back contact solar cell 20 of the ninth embodiment of the invention, back contact solar cell 20 disposed in column L₁ and back contact solar cell 20 disposed in column L₂ have the identical electrode pattern.

In the ninth embodiment, electrodes for second conductivity type 25, which are disposed third from the left and third from the right in the direction in which the electrodes are arrayed, are formed shorter than other electrodes for first conductivity type 24 and other electrodes for second conductivity type 25. Circular-point-like alignment marks 25a and 25b are formed near the leading ends of the shortly-formed electrodes for second conductivity type 25.

Alignment mark 25a is formed near one of the end portions of the electrode in the electrode extending direction, and alignment mark 25b is formed near the other end portion of the electrode.

### (Identical Shape Portion and Different Shape Portion in Wiring Sheet)

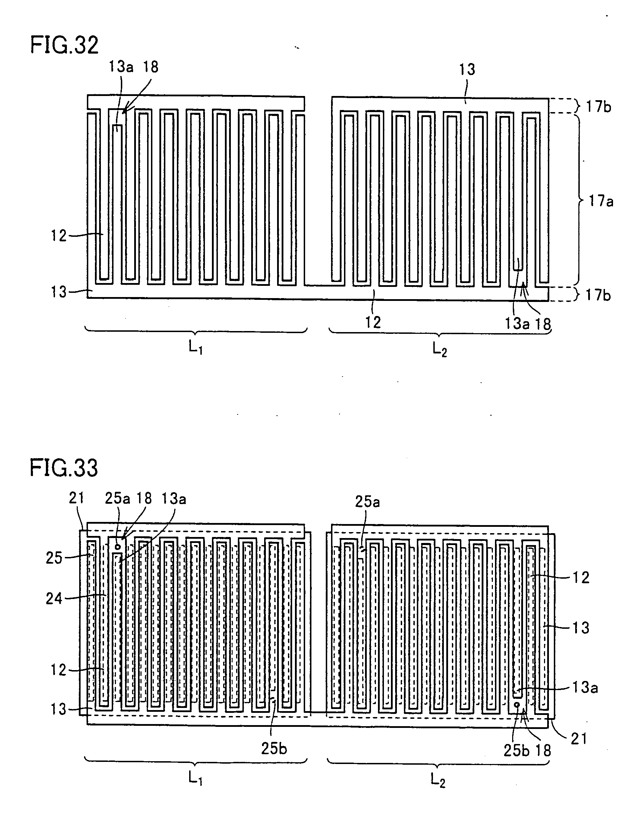

Fig. 32 is a plan view illustrating a wiring pattern of a wiring sheet of the ninth embodiment. In Fig. 32, only the wiring material is illustrated with respect to parts of columns L₁ and L₂ in Fig. 1.

In the ninth embodiment, second wiring 13 includes different shape portion 13a. Different shape portion 13a is formed such that plural comb-tooth-shaped portions 17a are shorter than other comb-tooth-shaped portions 17a.

As illustrated in Fig. 32, in wiring sheet 10 disposed in column L₂, comb-tooth-shaped portion 17a of second wiring 13, which is disposed third from the left in the direction in which plural comb-tooth-shaped portions 17a are arrayed, is formed shorter than other comb-tooth-shaped portions 17a. In wiring sheet 10 disposed in column L₂, comb-tooth-shaped portion 17a of second wiring 13, which is disposed third from the right in the direction in which plural comb-tooth-shaped portions 17a are arrayed, is formed shorter than other comb-tooth-shaped portions 17a. Alignment target region 18 is defined by different shape portion 13a.

Alignment target region 18 of wiring sheet 10 disposed in column L₁ and alignment target region 18 of wiring sheet 10 disposed in column L₂ are disposed so as to be overlapped with each other when one of wiring sheets 10 is rotated by 180° in the paper plane of Fig. 32 to overlap the patterns of first wirings 12 with the patterns of second wirings 13.

### (Alignment between Back contact Solar Cell and Wiring Sheet)

Fig. 33 is a plan view illustrating a state in which the back contact solar cell and the wiring sheet of the ninth embodiment are overlapped with each other when viewed from the back surface side of the solar cell having wiring sheet. Only columns L₁ and L₂ in Fig. 1 are partially illustrated in Fig. 33.

As illustrated in Fig. 33, in wiring sheet 10 disposed in column L₁, alignment mark 25a of back contact solar cell 20 and alignment target region 18 defined by different shape portion 13a of wiring sheet 10 are disposed while overlapped with each other. Comb-tooth-shaped portion 17a of second wiring 13 and alignment mark 25b are disposed so as to be overlapped with each other.

In wiring sheet 10 disposed in column L₂, alignment mark 25b of back contact solar cell 20 and alignment target region 18 defined by different shape portion 13a of wiring sheet 10 are disposed while overlapped with each other. Comb-tooth-shaped portion 17a of second wiring 13 and alignment mark 25a are disposed so as to be overlapped with each other.

Using back contact solar cell 20 including plural alignment marks, at least one alignment mark is disposed so as to be overlapped with alignment target regions 18, and at least one alignment mark is disposed so as to be overlapped with the wiring, thereby performing the alignment between back contact solar cell 20 and wiring sheet 10.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In the ninth embodiment, each two of the alignment marks and the different shape portions are provided for one solar cell having wiring sheet. However, the numbers of alignment marks and different shape portions are not limited to those of the ninth embodiment.

As described above, in back contact solar cell 20 of the ninth embodiment, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, irrespective of the column, all back contact solar cells 20 can be disposed on wiring sheet 10 while kept in one direction. Accordingly, the component management is easy to perform, and the process to rotate back contact solar cell 20 is reduced to improve the production efficiency.

Alignment mark 25a and alignment mark 25b are symmetrically formed with respect to the center of the back surface of back contact solar cell 20. Therefore, the alignment between back contact solar cell 20 and wiring sheet 10 can be performed even if back contact solar cell 20 is rotated by 180° in the paper plane. Accordingly, the management in the direction of back contact solar cell 20 can be simplified to improve the production efficiency.

In the ninth embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a tenth embodiment of the invention will be described below.

### <Tenth Embodiment>

The repetitive description of the same component as the ninth embodiment is not given because the tenth embodiment differs from the ninth embodiment only in the configuration of the different shape portion.

### (Alignment Mark in Back contact Solar Cell)

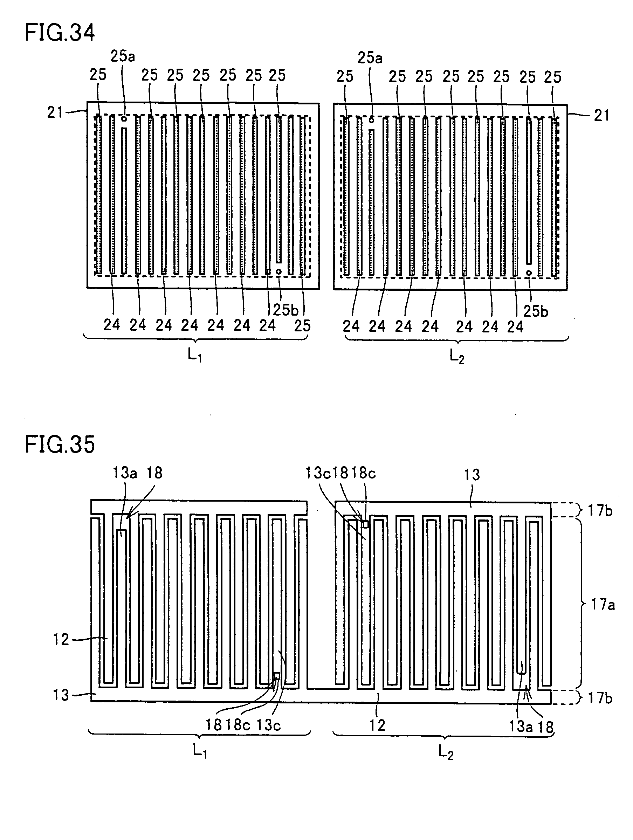

Fig. 34 is a plan view illustrating a back surface of a back contact solar cell of the tenth embodiment of the invention. Only columns L₁ and L₂ in Fig. 1 are partially illustrated in Fig. 34.

As illustrated in Fig. 34, in back contact solar cell 20 of the tenth embodiment of the invention, back contact solar cell 20 disposed in column L₁ and back contact solar cell 20 disposed in column L₂ have the identical electrode pattern. Back contact solar cell 20 of the tenth embodiment has the same electrode pattern as the back contact solar cell 20 of the ninth embodiment.

### (Identical Shape Portion and Different Shape Portion in Wiring Sheet)

Fig. 35 is a plan view illustrating a wiring pattern of a wiring sheet of the tenth embodiment. In Fig. 35, only the wiring material is illustrated with respect to parts of columns L₁ and L₂ in Fig. 1.

In the tenth embodiment, second wiring 13 includes different shape portion 13a and 13c. Different shape portion 13a is formed such that at least one of plural comb-tooth-shaped portions 17a is shorter than other comb-tooth-shaped portions 17a that are the identical shape portion.

As illustrated in Fig. 35, in wiring sheet 10 disposed in column L₁, comb-tooth-shaped portion 17a of second wiring 13, which is disposed third from the right in the direction in which plural comb-tooth-shaped portions 17a are arrayed, is formed shorter than other comb-tooth-shaped portions 17a. In wiring sheet 10 disposed in column L₂, comb-tooth-shaped portion 17a of second wiring 13, which is disposed third from the right in the direction in which plural comb-tooth-shaped portions 17a are arrayed, is formed shorter than other comb-tooth-shaped portions 17a.

Different shape portion 13c is formed such that second wiring 13 has rectangular opening 18c. In the tenth embodiment, opening 18c is formed in comb-tooth-shaped portion 17a. Comb-tooth-shaped portion 17a of second wiring 13, which is disposed third from the right, is formed in wiring sheet 10 disposed in column L₁. In wiring sheet 10 disposed in column L₂, Comb-tooth-shaped portion 17a of second wiring 13, which is disposed third from the left, is formed in wiring sheet 10 disposed in column L₂. However, opening 18c may be formed in connection wiring portion 17b, or may be formed while straddling comb-tooth-shaped portion 17a and connection wiring portion 17b.

In both wiring sheets 10 disposed in columns L₁ and L₂, alignment target regions 18 are defined by different shape portion 13a and different shape portion 13c, respectively.

### (Alignment between Back contact Solar Cell and Wiring Sheet)

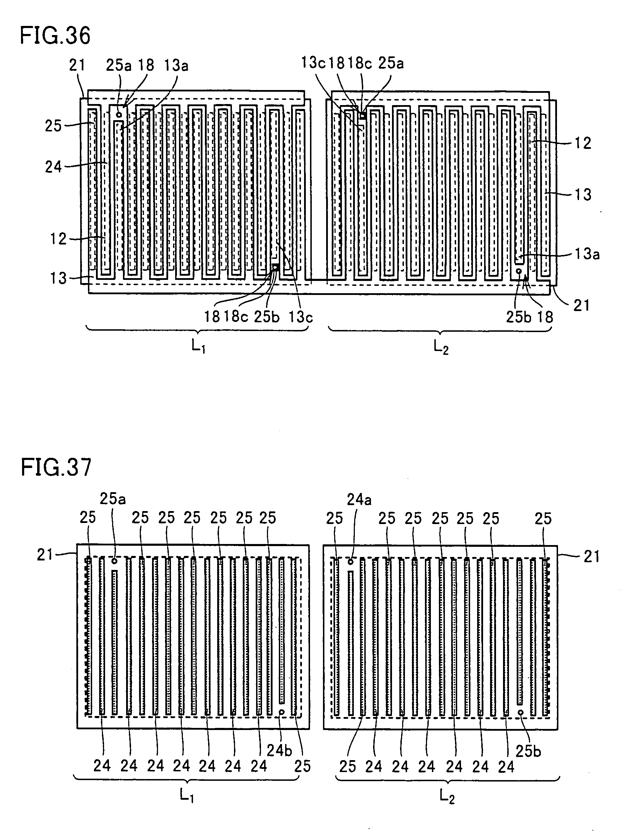

Fig. 36 is a plan view illustrating a state in which the back contact solar cell and the wiring sheet of the tenth embodiment are overlapped with each other when viewed from a back surface side of the solar cell having wiring sheet. Only columns L₁ and L₂ in Fig. 1 are partially illustrated in Fig. 36.

As illustrated in Fig. 36, in wiring sheet 10 disposed in column L₁, alignment mark 25a of back contact solar cell 20 and alignment target region 18 defined by different shape portion 13a of wiring sheet 10 are disposed while overlapped with each other. Alignment mark 25b of back contact solar cell 20 and alignment target region 18 defined by different shape portion 13c of wiring sheet 10 are disposed while overlapped with each other.

In wiring sheet 10 disposed in column L₂, alignment mark 25b of back contact solar cell 20 and alignment target region 18 defined by different shape portion 13a of wiring sheet 10 are disposed while overlapped with each other. Alignment mark 25a of back contact solar cell 20 and alignment target region 18 defined by different shape portion 13c of wiring sheet 10 are disposed while overlapped with each other.

Using back contact solar cell 20 including plural alignment marks, at least two alignment marks are disposed so as to be overlapped with alignment target regions 18, thereby performing the alignment between back contact solar cell 20 and wiring sheet 10.

In the tenth embodiment, because alignment mark 25a and alignment mark 25b can be distinguished from each other in each back contact solar cell 20, the alignment between back contact solar cell 20 and wiring sheet 10 can accurately be performed in not only the vertical and horizontal directions also the rotating direction.

In the tenth embodiment, each two of the alignment marks and the different shape portions are provided for one solar cell having wiring sheet. However, the numbers of alignment marks and different shape portions are not limited to those of the tenth embodiment.

In the tenth embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to an eleventh embodiment of the invention will be described below.

### <Eleventh Embodiment>

The repetitive description of the same component as the ninth embodiment is not given because the eleventh embodiment differs from the ninth embodiment only in the position of the alignment mark and the number of different shape portions.

### (Alignment Mark in Back contact Solar Cell)

Fig. 37 is a plan view illustrating a back surface of a back contact solar cell according to an eleventh embodiment of the invention. Only columns L₁ and L₂ in Fig. 1 are partially illustrated in Fig. 37.

As illustrated in Fig. 37, in back contact solar cell 20 of the eleventh embodiment of the invention, in each of back contact solar cells 20 disposed in columns L₁ and L₂, two electrodes are formed shorter than other electrodes for first conductivity type 24 and other electrodes for second conductivity type 25.

Specifically, in back contact solar cells 20 disposed in column L₁, electrode for first conductivity type 24 disposed second from the right and electrode for second conductivity type 25 disposed third from the left are formed short.

In back contact solar cells 20 disposed in column L₂, electrode for first conductivity type 24 disposed second from the left and electrode for second conductivity type 25 disposed third from the right are formed short.

In back contact solar cells 20 disposed in column L₁, a circular-point-like alignment mark 24b is formed near the leading end of shortly-formed electrode for first conductivity type 24. Circular-point-like alignment mark 25a is formed near the leading end of shortly-formed electrode for second conductivity type 25. Thus, two alignment marks 24b and 25a are formed on the extended lines of the electrode lines having different conductivity types, respectively.

In back contact solar cell 20 disposed in column L₂, circular-point-like alignment mark 24a is formed near the leading end of shortly-formed electrode for first conductivity type 24. Circular-point-like alignment mark 25a is formed near the leading end of shortly-formed electrode for second conductivity type 25. Thus, two alignment marks 24a and 25b are formed on the extended lines of the extending directions of the electrode lines having the different conductivity types, respectively.

Alignment mark 25a is formed near one of the end portions of the electrode in the electrode extending direction, and alignment mark 24b is formed near the other end portion on the opposite side of alignment mark 25a in the electrode extending direction. Similarly alignment mark 24a is formed near one of the end portions of the electrode in the electrode extending direction, and alignment mark 25b is formed near the other end portion on the opposite side of alignment mark 24a in the electrode extending direction.

Alignment marks 24b and 25a formed in back contact solar cell 20 disposed in column L₁ and alignment marks 24a and 25b formed in back contact solar cell 20 disposed in column L₂ are disposed so as to be overlapped with each other when one of back contact solar cells 20 is rotated by 180° in the paper plane of Fig. 37 to overlap the patterns of electrodes for first conductivity type 24 with the patterns of electrodes for second conductivity type 25. Accordingly, back contact solar cell 20 disposed in column L₂ can be disposed by rotating back contact solar cell 20 disposed in column L₁ by 180° in the paper plane.

### (Identical Shape Portion and Different Shape Portion in Wiring Sheet)

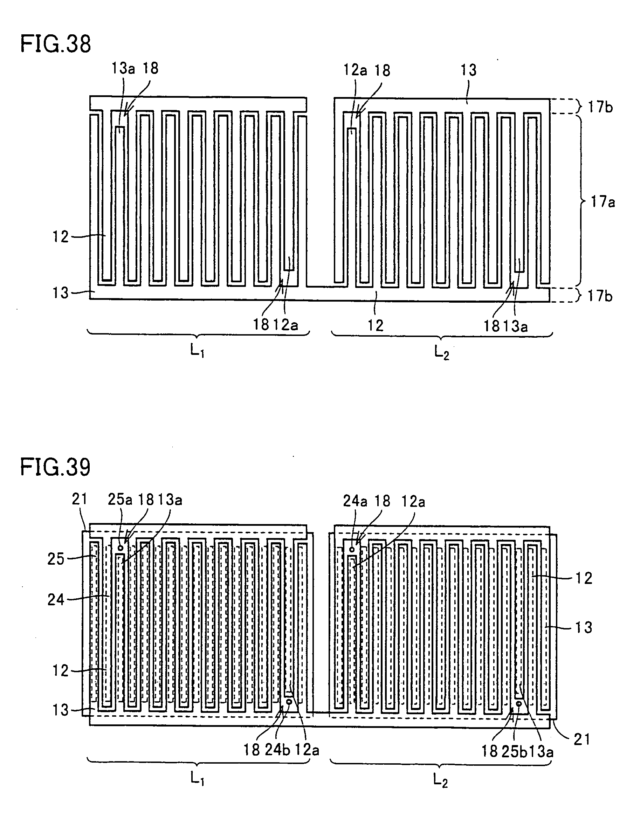

Fig. 38 is a plan view illustrating a wiring pattern of a wiring sheet of the eleventh embodiment. In Fig. 38, only the wiring material is illustrated with respect to parts of column L₁ and the column L₂ in Fig. 1.

In the eleventh embodiment, first wiring 12 and second wiring 13 include different shape portion 12a and different shape portion 13a, respectively. Different shape portion 12a and 13a are formed such that at least one of plural comb-tooth-shaped portions 17a is shorter than other comb-tooth-shaped portions 17a that are the identical shape portion.

As illustrated in Fig. 38, in wiring sheet 10 disposed in column L₁, comb-tooth-shaped portion 17a of first wiring 12, which is disposed second from the right in the direction in which plural comb-tooth-shaped portions 17a are arrayed, is formed shorter than other comb-tooth-shaped portions 17a. Comb-tooth-shaped portion 17a of second wiring 13, which is disposed third from the left in the direction in which plural comb-tooth-shaped portions 17a are arrayed, is formed shorter than other comb-tooth-shaped portions 17a.

In wiring sheet 10 disposed in column L₂, comb-tooth-shaped portion 17a of first wiring 12, which is disposed second from the left in the direction in which plural comb-tooth-shaped portions 17a are arrayed, is formed shorter than other comb-tooth-shaped portions 17a. Comb-tooth-shaped portions 17a of second wiring 13, which is disposed third from the right in the direction in which plural comb-tooth-shaped portions 17a are arrayed, is formed shorter than other comb-tooth-shaped portions 17a. Alignment target regions 18 are defined by different shape portion 12a and different shape portion 13a, respectively.

Alignment target region 18 of wiring sheet 10 disposed in column L₁ and alignment target region 18 of wiring sheet 10 disposed in column L₂ are disposed so as to be overlapped with each other when one of wiring sheets 10 is rotated by 180° in the paper plane of Fig. 38 to overlap the patterns of first wirings 12 with the patterns of first wirings 12.

### (Alignment between Back contact Solar Cell and Wiring Sheet)

Fig. 39 is a plan view illustrating a state in which the back contact solar cell and the wiring sheet of the eleventh embodiment are overlapped with each other when viewed from the back surface side of the solar cell having wiring sheet. Only columns L₁ and L₂ in Fig. 1 are partially illustrated in Fig. 39.

As illustrated in Fig. 39, in wiring sheet 10 disposed in column L₁, alignment mark 24b of back contact solar cell 20 and alignment target region 18 defined by different shape portion 12a of wiring sheet 10 are disposed while overlapped with each other. Alignment mark 25a of back contact solar cell 20 and alignment target region 18 defined by different shape portion 13a of wiring sheet 10 are disposed while overlapped with each other.

In wiring sheet 10 disposed in column L₂, alignment mark 24a of back contact solar cell 20 and alignment target region 18 defined by different shape portion 12a of wiring sheet 10 are disposed while overlapped with each other. Alignment mark 25b of back contact solar cell 20 and alignment target region 18 defined by different shape portion 13a of wiring sheet 10 are disposed while overlapped with each other.

Using back contact solar cell 20 including plural alignment marks, at least two alignment marks are disposed so as to be overlapped with alignment target regions 18, thereby performing the alignment between back contact solar cell 20 and wiring sheet 10.

In the eleventh embodiment, because two alignment marks 24b and 25a or two alignment marks 24a and 25b are provided for one back contact solar cell 20, the alignment between back contact solar cell 20 and wiring sheet 10 can accurately be performed in not only the vertical and horizontal directions also the rotating direction.

In the eleventh embodiment, each two of the alignment marks and the different shape portions are provided for one solar cell having wiring sheet. However, the numbers of alignment marks and different shape portions are not limited to those of the eleventh embodiment.

Because the positions of alignment marks 24b and 25a and the positions of alignment marks 24a and 25b are opposite in the electrode extending direction, the alignment of each of back contact solar cell 20 disposed in column L₁ and back contact solar cell 20 disposed in column L₂ can accurately be performed while alignment marks 24b and 25a or alignment marks 24a and 25b are checked in a distant position.

Particularly, alignment marks 24b and 25a or alignment marks 24a and 25b are disposed distant from the neighborhoods of both ends of the electrode in the electrode extending direction, so that the alignment between back contact solar cell 20 and wiring sheet 10 can accurately be performed in the rotating direction.

In the eleventh embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a twelfth embodiment of the invention will be described below.

### <Twelfth Embodiment>

The repetitive description of the same component as the ninth embodiment is not given because the twelfth embodiment differs from the ninth embodiment only in the position of the alignment mark, the number of alignment marks, the configuration of the different shape portion, and the number of different shape portions.

### (Alignment Mark in Back contact Solar Cell)

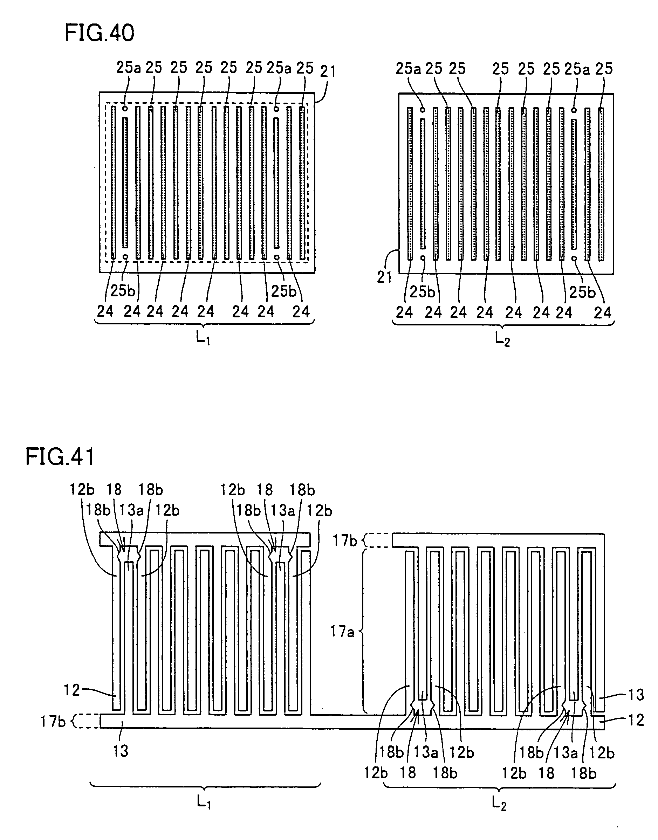

Fig. 40 is a plan view illustrating a back surface of a back contact solar cell of the twelfth embodiment of the invention. Only columns L₁ and L₂ in Fig. 1 are partially illustrated in Fig. 40.

As illustrated in Fig. 40, in back contact solar cell 20 of the twelfth embodiment of the invention, back contact solar cell 20 disposed in column L₁ and back contact solar cell 20 disposed in column L₂ have the identical electrode pattern.

In the twelfth embodiment, electrodes for second conductivity type 25, which are disposed second from the left and third from the right, are formed shorter than other electrode for first conductivity type 24 and other electrodes for second conductivity type 25. Circular-point-like alignment marks 25a and 25b are formed near the leading ends of shortly-formed electrodes for second conductivity type 25.

Alignment mark 25a is formed near one of the end portions of the electrode in the electrode extending direction, and alignment mark 25b is formed near the other end portion of the electrode. Alignment marks 25a and 25b are located in the space where the plural electrodes are not located in the inner region.

In the twelfth embodiment, four alignment marks 25a and 25b are provided on the extended lines of the electrode lines of electrode for second conductivity type 25. However, the dispositions of the alignment marks are not limited to the twelfth embodiment.

The good alignment can be performed like the twelfth embodiment, in the case that four alignment marks for first conductivity type are provided on the extended lines of the electrode lines of electrodes for first conductivity type 24, or in the case that the total of four alignment marks including two alignment marks for first conductivity type on the extended lines of the electrode lines of electrodes for first conductivity type 24 and two alignment marks for first conductivity type on the extended lines of the electrodes lines of electrode for second conductivity type 25 are provided.

In the case that four alignment marks for first conductivity type are provided, for example, the alignment marks are provided in the spaces, which are formed such that both end portions of each of the two electrode lines in the electrode lines of plural electrodes for first conductivity type 24 are located inside of one of end portions of other electrode lines of electrodes for first conductivity type 24 and end portions of other electrode lines of electrodes for second conductivity type 25 in the electrode-line extending direction.

In the case that two alignment marks for first conductivity type and two alignment marks for second conductivity type are provided, the alignment marks for first conductivity type are provided in the spaces, which are formed such that both end portions of one electrode line in the electrode lines of plural electrodes for first conductivity type 24 are located inside of one of end portions of other electrode lines of electrodes for first conductivity type 24 and end portions of other electrode lines of electrodes for second conductivity type 25 in the electrode-line extending direction. The alignment marks for second conductivity type are also provided in the spaces, which are formed such that both end portions of one electrode line in the electrode lines of plural electrodes for second conductivity type 25 are located inside of one of end portions of other electrode lines of electrodes for first conductivity type 24 and end portions of other electrode lines of electrodes for second conductivity type 25 in the electrode-line extending direction.

At least four alignment mark may be provided, for example, four alignment marks may be provided on the extended lines of the electrode lines of electrodes for second conductivity type 25, and at least one alignment mark may be provided on the extended line of at least one of the electrode lines of electrodes for first conductivity type 24 and electrodes for second conductivity type 25.

In the case that alignment marks 25a and 25b are provided on the extended lines of the electrode pattern, desirably alignment marks 25a and 25b are formed while the widths of alignment marks 25a and 25b are less than or equal to the width of the electrode line. Alternatively, alignment marks 25a and 25b may be formed while the widths of alignment marks 25a and 25b are greater than the width of the electrode line.

Alignment marks 25a and 25b may have different shapes. During the alignment, the alignment mark overlapped with alignment target region 18 in back contact solar cell 20 disposed in column L₁ and the alignment mark overlapped with alignment target region 18 in back contact solar cell 20 disposed in column L₂ may have different shapes.

In such cases, whether back contact solar cell 20 is disposed in the desired direction can be checked because the alignment marks having the different shapes can be checked in each of back contact solar cells 20 disposed in different columns on wiring sheet 10.

Desirably the position and the shape of the alignment mark are not symmetrical with respect to the center of the electrode pattern of back contact solar cell 20 in the paper plane of Fig. 40. According to the configuration, when back contact solar cell 20 is rotated by 180° in the paper plane in the process of placing back contact solar cell 20 on wiring sheet 10, the alignment mark cannot be observed, or the shape of the observed alignment mark is different from the original shape, so that it can be noticed that back contact solar cell 20 is mistakenly disposed. As a result, the alignment of back contact solar cell 20 on wiring sheet 10 with contact solar cell 20 mistakenly rotated can be prevented.

### (Identical Shape Portion and Different Shape Portion in Wiring Sheet)

Fig. 41 is a plan view illustrating a wiring pattern of a wiring sheet of the twelfth embodiment. In Fig. 41, only the wiring material is illustrated with respect to parts of columns L₁ and L₂ in Fig. 1.

As illustrated in Fig. 41, in wiring sheet 10 of the twelfth embodiment, both first wiring 12 and second wiring 13 include the different shape portion. Different shape portion 12b of first wiring 12 is identical to that of the second embodiment. Different shape portion 13a of second wiring 13 is identical to that of the first embodiment.

Alignment target region 18 is defined by different shape portions 12b and different shape portion 13a. Wiring sheet 10 of the twelfth embodiment includes the case that at least one of first wiring 12 and second wiring 13 includes the different shape portion. In this case, alignment target region 18 is defined by at least one of different shape portions 12b and different shape portion 13a.

One of the features of wiring sheet 10 of the twelfth embodiment is that wiring sheet 10 includes at least two alignment target regions 18 defined by the different shape portions. In the twelfth embodiment, desirably at least two of alignment marks 25a and 25b included in back contact solar cell 20 are recognized through alignment target regions 18. For example, in addition to the identical shape portion, a portion, in which the width of the partial shape of the wiring pattern is larger than that of the identical shape portion or a wiring length is longer than that of the identical shape portion, may be included in the wiring pattern as long as at least two alignment target regions are included.

The wiring pattern including first wiring 12 and second wiring 13 may be included in at least one cell disposition portion 19 in whole wiring sheet 10.

### (Alignment between Back contact Solar Cell and Wiring Sheet)

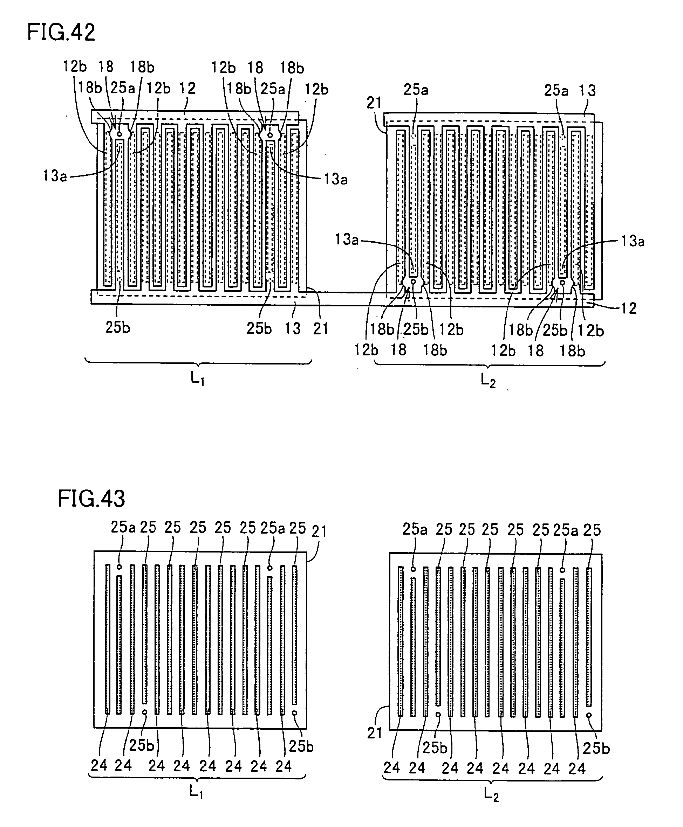

Fig. 42 is a plan view illustrating a state in which the back contact solar cell and the wiring sheet of the twelfth embodiment are overlapped with each other when viewed from the back surface side of the solar cell having wiring sheet. Only columns L₁ and L₂ in Fig. 1 are partially illustrated in Fig. 42.

As illustrated in Fig. 42, in wiring sheet 10 disposed in column L₁, the alignment between back contact solar cell 20 and wiring sheet 10 is performed such that two alignment marks 25a of back contact solar cell 20 and two alignment target regions 18 defined by different shape portions 12b and 13a of wiring sheet 10 are disposed while overlapped with each other. Comb-tooth-shaped portion 17a of second wiring 13 and alignment mark 25b are disposed so as to be overlapped with each other.

In wiring sheet 10 disposed in column L₂, the alignment between back contact solar cell 20 and wiring sheet 10 is performed such that two alignment marks 25b of back contact solar cell 20 and two alignment target regions 18 defined by different shape portions 12b and 13a of wiring sheet 10 are disposed while overlapped with each other. Comb-tooth-shaped portion 17a of second wiring 13 and alignment mark 25a are disposed so as to be overlapped with each other.

Using back contact solar cell 20 including plural alignment marks, at least two alignment marks are disposed so as to be overlapped with alignment target regions 18, and at least one alignment mark is thereby performing the alignment between back contact solar cell 20 and wiring sheet 10.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In the twelfth embodiment, the four alignment marks and the six different shape portions are provided for one solar cell having wiring sheet. However, the numbers of alignment marks and different shape portions are not limited to those of the twelfth embodiment.

As described above, in back contact solar cell 20 of the twelfth embodiment, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₂ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, irrespective of the column, all back contact solar cells 20 can be disposed on wiring sheet 10 while kept in one direction. Accordingly, the component management is easy to perform, and the process to rotate back contact solar cell 20 is reduced to improve the production efficiency.

In the twelfth embodiment, because two alignment marks 25a or two alignment marks 25b can be distinguished from each other in each back contact solar cell 20 through alignment target region 18 of wiring sheet 10, the alignment between back contact solar cell 20 and wiring sheet 10 can accurately be performed in not only the vertical and horizontal directions also the rotating direction.

In the twelfth embodiment, the good alignment between back contact solar cell 20 and wiring sheet 10 can be performed to prepare the high-reliability solar cell having wiring sheet and the high-reliability solar cell module.

A back contact solar cell, a wiring sheet, a solar cell having wiring sheet, a solar cell module, and a production method for the solar cell having wiring sheet according to a thirteenth embodiment of the invention will be described below.

### <Thirteenth Embodiment>

The repetitive description of the same component as the twelfth embodiment is not given because the thirteenth embodiment differs from the twelfth embodiment only in the positions of the alignment mark and the different shape portion and the number of different shape portions.

### (Alignment Mark in Back contact Solar Cell)

Fig. 43 is a plan view illustrating a back surface of a back contact solar cell according to a thirteenth embodiment of the invention. Only columns L₁ and L₂ in Fig. 1 are partially illustrated in Fig. 43.

As illustrated in Fig. 43, in back contact solar cell 20 of the thirteenth embodiment of the invention, back contact solar cell 20 disposed in column L₁ and back contact solar cell 20 disposed in column L₂ have the identical electrode pattern.

In the thirteenth embodiment, electrodes" for second conductivity type 25, which are disposed second and fourth from the left and first and third from the right in the direction in which the electrodes are arrayed, are formed shorter than other electrodes for first conductivity type 24 and other electrodes for second conductivity type 25. Circular-point-like alignment marks 25a and 25b are formed near the leading ends of shortly-formed electrodes for second conductivity type 25. In back contact solar cell 20 of the thirteenth embodiment, all alignment marks 25a and 25b are formed on the extended lines of different electrode lines.

Alignment mark 25a is formed near one of the end portions of the electrode in the electrode extending direction, and alignment mark 25b is formed near the other end portion of the electrode. Alignment marks 25a and 25b are disposed on a space where plural electrodes are not located in the inner region.

In the thirteenth embodiment, four alignment marks are provided on the extended lines of the electrode lines of electrode for second conductivity type 25. However, the dispositions of the alignment marks are not limited to the thirteenth embodiment.

That is, the good alignment can be performed like the thirteenth embodiment, in the case that four alignment marks for first conductivity type are provided on the extended lines of the electrode lines of electrodes for first conductivity type 24, or in the case that the total of four alignment marks including two alignment marks for first conductivity type on the extended lines of the electrode lines of electrodes for first conductivity type 24 and two alignment marks for second conductivity type on the extended lines of the electrodes lines of electrode for second conductivity type 25 are provided.

In the case that four alignment marks for first conductivity type are provided, for example, the alignment marks are provided in the spaces, which are formed such that both end portions of each of the two electrode lines in the electrode lines of plural electrodes for first conductivity type 24 are located inside of one of end portions of other electrode lines of electrodes for first conductivity type 24 and end portions of other electrode lines of electrodes for second conductivity type 25 in the electrode-line extending direction.

In the case that two alignment marks for first conductivity type and two alignment marks for second conductivity type are provided, the alignment marks for first conductivity type are provided in the spaces, which are formed such that the respective end portions of two electrode lines in the electrode lines of plural electrodes for first conductivity type 24, which are opposed to each other, are located inside of one of end portions of other electrode lines of electrodes for first conductivity type 24 and end portions of other electrode lines of electrodes for second conductivity type 25 in the electrode-line extending direction. The alignment marks for second conductivity type are also provided in the spaces, which are formed such that the respective end portions of two electrode lines in the electrode lines of plural electrodes for second conductivity type 25, which are opposed to each other, are located inside of one of end portions of other electrode lines of electrodes for first conductivity type 24 and end portions of other electrode lines of electrodes for second conductivity type 25 in the electrode-line extending direction.

At least four-alignment marks may be provided. For example, four alignment marks 25a and 25b may be provided on the extended lines of the electrode lines of electrodes for second conductivity type 25, and at least one alignment mark may be provided on the extended line of at least one of the electrode lines of electrodes for first conductivity type 24 and electrodes for second conductivity type 25.

### (Identical Shape Portion and Different Shape Portion in Wiring Sheet)

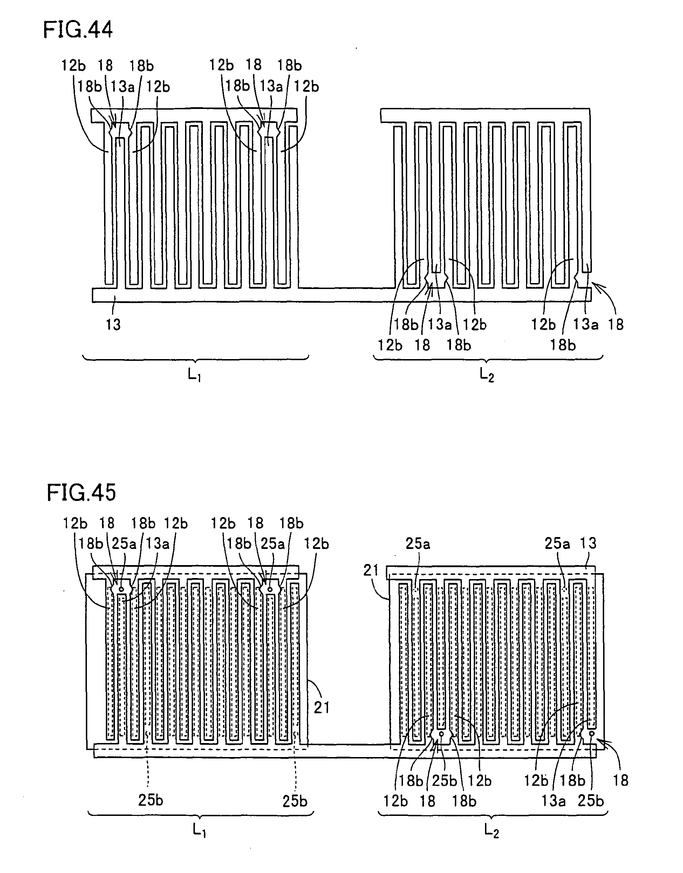

Fig. 44 is a plan view illustrating a wiring pattern of a wiring sheet of the thirteenth embodiment. In Fig. 44, only the wiring material is illustrated with respect to parts of columns L₁ and L₂ in Fig. 1.

As illustrated in Fig. 44, in wiring sheet 10 of the thirteenth embodiment, both first wiring 12 and second wiring 13 include the different shape portion. Different shape portion 12b of first wiring 12 is identical to that of the second embodiment. Different shape portion 13a of second wiring 13 is identical to that of the first embodiment.

Alignment target region 18 is defined by different shape portions 12b and different shape portion 13a. Wiring sheet 10 of the thirteenth embodiment includes the case that at least one of first wiring 12 and second wiring 13 includes the different shape portion. In this case, alignment target region 18 is defined by at least one of different shape portions 12b and different shape portion 13a.

One of the features of wiring sheet 10 of the thirteenth embodiment is that wiring sheet 10 includes at least two alignment target regions 18 defined by the different shape portions. In the thirteenth embodiment, desirably at least two of alignment marks 25a and 25b included in back contact solar cell 20 can be recognized through alignment target regions 18.

The wiring pattern including first wiring 12 and second wiring 13 may be included in at least one cell disposition portion 19 in whole wiring sheet 10.

### (Alignment between Back contact Solar Cell and Wiring Sheet)

Fig. 45 is a plan view illustrating a state in which the back contact solar cell and the wiring sheet of the thirteenth embodiment are overlapped with each other when viewed from the back surface side of the solar cell having wiring sheet. Only columns L₁ and L₂ in Fig. 1 are partially illustrated in Fig. 45.

As illustrated in Fig. 45, in wiring sheet 10 disposed in column L₁, the alignment between back contact solar cell 20 and wiring sheet 10 is performed such that two alignment marks 25a of back contact solar cell 20 and two alignment target regions 18 defined by different shape portions 12b and 13a of wiring sheet 10 are disposed while overlapped with each other. Comb-tooth-shaped portion 17a of second wiring 13 and alignment mark 25b are disposed so as to be overlapped with each other.

In wiring sheet 10 disposed in column L₂, the alignment between back contact solar cell 20 and wiring sheet 10 is performed such that two alignment marks 25b of back contact solar cell 20 and two alignment target regions 18 defined by different shape portions 12b and 13a of wiring sheet 10 are disposed while overlapped with each other. Comb-tooth-shaped portion 17a of second wiring 13 and alignment mark 25a are disposed so as to be overlapped with each other.

Using back contact solar cell 20 including plural alignment marks, at least two alignment marks are disposed so as to be overlapped with alignment target regions 18, and at least one alignment mark is disposed so as to be overlapped with the wiring, thereby performing the alignment between back contact solar cell 20 and wiring sheet 10.

Alternatively, the alignment between back contact solar cell 20 and wiring sheet. 10 may be performed such that at least one alignment mark is disposed so as to be overlapped with alignment target region 18, or such that at least one alignment mark is disposed so as to be overlapped with the wiring.

In the thirteenth embodiment, the four alignment marks and the six different shape portions are provided for one solar cell having wiring sheet in wiring sheet 10 disposed in column L₁, and the four alignment marks and the five different shape portions are provided for one solar cell having wiring sheet in wiring sheet 10 disposed in column L₂. However, the numbers of alignment marks and different shape portions are not limited to those of the thirteenth embodiment.

In back contact solar cell 20 of the thirteenth embodiment, as described above, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, irrespective of the column, all back contact solar cells 20 can be disposed on wiring sheet 10 while kept in one direction. Accordingly, the component management is easy to perform, and the process to rotate back contact solar cell 20 is reduced to improve the production efficiency.

In the thirteenth embodiment, because two alignment mark 25a or two alignment marks 25b can be distinguished from each other in each back contact solar cell 20 through alignment target region 18 of wiring sheet 10, the alignment between back contact solar cell 20 and wiring sheet 10 can accurately be performed in not only the vertical and horizontal directions also the rotating direction.

In the thirteenth embodiment, the good alignment between back contact solar cell 20 and wiring sheet 10 can be performed to prepare the high-reliability solar cell having wiring sheet and the high-reliability solar cell module.

Additionally, in the thirteenth embodiment, because alignment marks 25a and 25b are not provided at both the end of one electrode line unlike the twelfth embodiment, a degree of freedom of the design for the electrode pattern and the wiring pattern is enhanced compared with the twelfth embodiment.

A back contact solar cell, a wiring sheet, a solar cell having wiring sheet, a solar cell module, and a production method for the solar cell having wiring sheet according to a fourteenth embodiment of the invention will be described below.

### <Fourteenth Embodiment>

The repetitive description of the same component as the twelfth embodiment is not given because the fourteenth embodiment differs from the twelfth embodiment only in the positions of the alignment mark and the different shape portion.

### (Alignment Mark in Back contact Solar Cell)

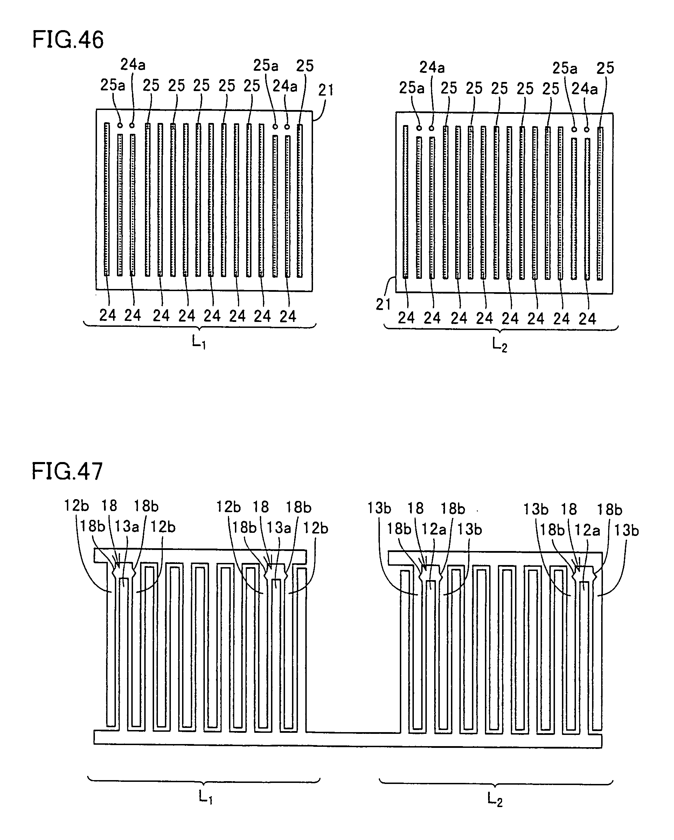

Fig. 46 is a plan view illustrating a back surface of a back contact solar cell of the fourteenth embodiment of the invention. Only columns L₁ and L₂ in Fig. 1 are partially illustrated in Fig. 46.

As illustrated in Fig. 46, in back contact solar cell 20 of the fourteenth embodiment of the invention, back contact solar cell 20 disposed in column L₁ and back contact solar cell 20 disposed in column L₂ have the identical electrode pattern.

In the fourteenth embodiment, electrodes for first conductivity type 24, which are disposed third from the left and second from the right in the direction in which the electrodes are arrayed, and electrodes for second conductivity type 25, which are disposed second from the left and third from the right, are formed shorter than other electrodes for first conductivity type 24 and other electrodes for second conductivity type 25.

Circular-point-like alignment marks 24a and 25a are formed near the leading ends of shortly-formed electrode for first conductivity type 24 and shortly-formed electrode for second conductivity type 25. In back contact solar cell 20 of the fourteenth embodiment, all alignment marks 24a and 25a are formed on the extended lines of the different electrode lines.

Alignment marks 24a and 25a are formed near one of the end portions of the electrode in the electrode extending direction. Alignment marks 24a and 25a are located in the space where the plural electrodes are not located in the inner region.

In the fourteenth embodiment, two alignment marks 24a are provided on the extended lines of the electrode lines of electrodes for first conductivity type 24, and two alignment marks 25a are provided on the extended lines of the electrode lines of electrodes for second conductivity type 25. The dispositions of the alignment marks are not limited to the fourteenth embodiment. At least four alignment marks may be disposed.

For example, four alignment marks may be provided, and at least one alignment mark may be provided on the extended line of at least one of the electrode lines of electrode for first conductivity type 24 and electrode for second conductivity type 25.

In the fourteenth embodiment, alignment marks 24a and 25a are located on the extended lines of the electrode lines adjacent to each other. However, the dispositions of alignment marks 24a and 25a are not limited to the fourteenth embodiment. For example, alignment marks 24a and 25a may be located on the extended lines of the electrode lines that are not adjacent to each other.

Alignment mark 24a and 25a may have different shapes. During the alignment, the alignment mark overlapped with alignment target region 18 in back contact solar cell 20 disposed in column L₁ and the alignment mark overlapped with alignment target region 18 in back contact solar cell 20 disposed in column L₂ may have different shapes.

In such cases, whether back contact solar cell 20 is disposed in the desired direction can be checked because the alignment marks having the different shapes can be checked in each of back contact solar cells 20 disposed in different columns on wiring sheet 10.

Preferably the position and the shape of the alignment mark are not symmetrical with respect to the center of the electrode pattern of back contact solar cell 20 in the paper plane of Fig. 46. According to the configuration, back contact solar cell 20 is rotated by 180° in the paper plane in the process of placing back contact solar cell 20 on wiring sheet 10, the alignment mark cannot be observed, or the shape of the observed alignment mark is different from the original shape, so that it can be noticed that back contact solar cell 20 is mistakenly disposed. As a result, the alignment of back contact solar cell 20 on wiring sheet 10 with contact solar cell 20 mistakenly rotated can be prevented.

### (Identical Shape Portion and Different Shape Portion in Wiring Sheet)

Fig. 47 is a plan view illustrating a wiring pattern of a wiring sheet of the fourteenth embodiment. In Fig. 47, only the wiring material is illustrated with respect to parts of columns L₁ and L₂ in Fig. 1.

As illustrated in Fig. 47, in wiring sheet 10 of the fourteenth embodiment, both first wiring 12 and second wiring 13 include the different shape portion. Different shape portion 12b of first wiring 12 and different shape portion 13b of second wiring 13 are identical to those of the second embodiment. Different shape portion 12a of first wiring 12 and different shape portion 13a of second wiring 13 are identical to those of the first embodiment.

Alignment target region 18 is defined by different shape portions 12b and different shape portion 13a, and alignment target region 18 is also defined by different shape portion 12a and different shape portions 13b. Wiring sheet 10 of the fourteenth embodiment includes the case that alignment target region 18 is defined only by the different shape portion of at least one of first wiring 12 and second wiring 13.

One of the features of wiring sheet 10 of the fourteenth embodiment is that wiring sheet 10 includes at least two alignment target regions 18 defined by the different shape portions. In the fourteenth embodiment, desirably at least two of alignment marks 24a and 25a included in back contact solar cell 20 can be recognized through alignment target regions 18.

The wiring pattern including first wiring 12 and second wiring 13 may be included in at least one cell disposition portion 19 in whole wiring sheet 10.

### (Alignment between Back contact Solar Cell and Wiring Sheet)

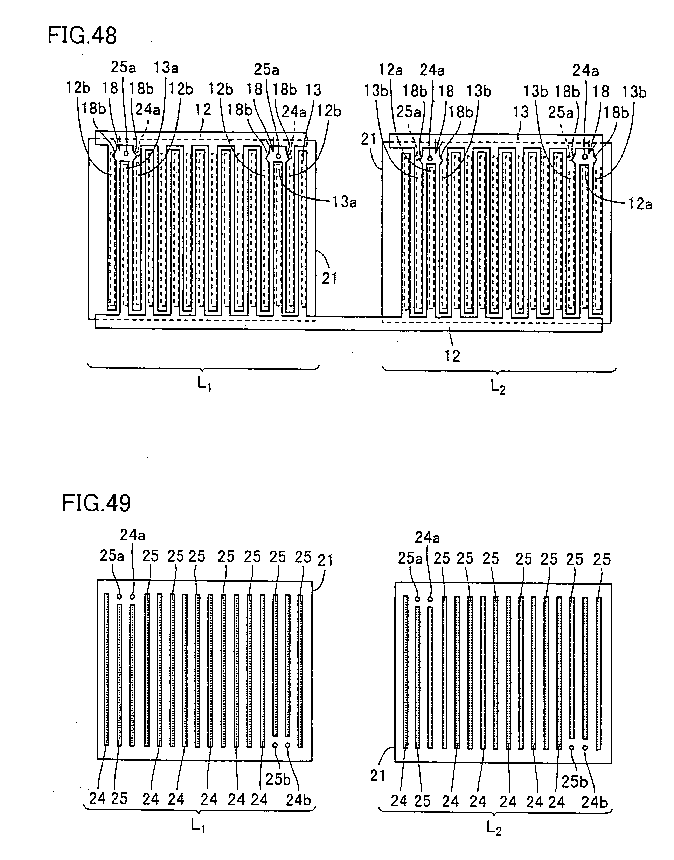

Fig. 48 is a plan view illustrating a state in which the back contact solar cell and the wiring sheet of the fourteenth embodiment are overlapped with each other when viewed from the back surface side of the solar cell having wiring sheet. Only columns L₁ and L₂ in Fig. 1 are partially illustrated in Fig. 48.

As illustrated in Fig. 48, in wiring sheet 10 disposed in column L₁, the alignment between back contact solar cell 20 and wiring sheet 10 is performed such that two alignment marks 25a of back contact solar cell 20 and two alignment target regions 18 defined by different shape portions 12b and 13a of wiring sheet 10 are disposed while overlapped with each other. Comb-tooth-shaped portion 17a of first wiring 12 and alignment mark 24a are disposed so as to be overlapped with each other.

In wiring sheet 10 disposed in column L₂, the alignment between back contact solar cell 20 and wiring sheet 10 is performed such that two alignment marks 24a of back contact solar cell 20 and two alignment target regions 18 defined by different shape portions 12a and 13ba of wiring sheet 10 are disposed while overlapped with each other. Comb-tooth-shaped portion 17a of second wiring 13 and alignment mark 25a are disposed so as to be overlapped with each other.

Using back contact solar cell 20 including plural alignment marks, at least two alignment marks are disposed so as to be overlapped with alignment target regions 18, and at least one alignment mark is disposed so as to be overlapped with the wiring, thereby performing the alignment between back contact solar cell 20 and wiring sheet 10.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In back contact solar cell 20 of the fourteenth embodiment, as described above, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, irrespective of the column, all back contact solar cells 20 can be disposed on wiring sheet 10 while kept in one direction. Accordingly, the component management is easy to perform, and the process to rotate back contact solar cell 20 is reduced to improve the production efficiency.

In the fourteenth embodiment, because two alignment mark 24a or two alignment marks 25a can be distinguished from each other for one back contact solar cell 20 through alignment target region 18 of wiring sheet 10, the alignment between back contact solar cell 20 and wiring sheet 10 can accurately be performed in not only the vertical and horizontal directions also the rotating direction.

In the fourteenth embodiment, the good alignment between back contact solar cell 20 and wiring sheet 10 can be performed to prepare the high-reliability solar cell having wiring sheet and the high-reliability solar cell module.

In the fourteenth embodiment, because alignment marks 24a and 25a are not provided at both the end of one electrode line unlike the twelfth embodiment, the degree of freedom of the design for the electrode pattern and the wiring pattern is enhanced compared with the twelfth embodiment.

In the fourteenth embodiment, because the alignment marks are provided on the extended lines of the electrode lines of both electrode for first conductivity type 24 and electrode for second conductivity type 25, the effective electrode lengths become identical in both the conductivity types, and the power generation efficiency of the solar cell having wiring sheet can be improved.

Because alignment marks 24a and 25a are provided on one end portion side in the electrode-line extending direction, alignment marks 24a and 25a can be provided close to each other. Particularly, alignment marks 24a and 25a are formed on the extended lines of the adjacent electrode lines, alignment marks 24a and 25a are closest to each other.

In this case, during the alignment between wiring sheet 10 and back contact solar cell 20, back contact solar cell 20 disposed in column L₁ is substantially identical to back contact solar cell 20 disposed in column L₂ in the observed positions of alignment marks 24a and 25a, the observation position of the observation device can be restricted, and simplification and accuracy enhancement of the alignment device are effectively achieved.

A back contact solar cell, a wiring sheet, a solar cell having wiring sheet, a solar cell module, and a production method for the solar cell having wiring sheet according to a fifteenth embodiment of the invention will be described below.

### <Fifteenth Embodiment>

The repetitive description of the same component as the twelfth embodiment is not given because the fifteenth embodiment differs from the twelfth embodiment only in the positions of the alignment mark and the different shape portion.

### (Alignment Mark in Back contact Solar Cell)

Fig. 49 is a plan view illustrating a back surface of a back contact solar cell of the fifteenth embodiment of the invention. Only columns L₁ and L₂ in Fig. 1 are partially illustrated in Fig. 49.

As illustrated in Fig. 49, in back contact solar cell 20 of the fifteenth embodiment of the invention, back contact solar cell 20 disposed in column L₁ and back contact solar cell 20 disposed in column L₂ have the identical electrode pattern.

In the fifteenth embodiment, electrodes for first conductivity type 24, which are disposed third from the left and second from the right in the direction in which the electrodes are arrayed, and electrodes for second conductivity type 25, which are disposed second from the left and third from the right, are formed shorter than other electrodes for first conductivity type 24 and other electrodes for second conductivity type 25.

Circular-point-like alignment mark 24a and 24b are formed near the leading end of shortly-formed electrodes for first conductivity type 25. Circular-point-like alignment marks 25a and 25b are formed near the leading end of shortly-formed electrodes for second conductivity type 25. In back contact solar cell 20 of the fifteenth embodiment, all alignment marks 24a, 24b, 25a, and 25b are formed on the extended lines of the different electrode lines.

Alignment marks 24a and 25a are formed near one of the end portions of the electrode in the electrode extending direction. Alignment marks 24b and 25b are formed near the other end portion of the electrode in the electrode extending direction. Alignment marks 24a, 24b, 25a, and 25b are located in the space where the plural electrodes are not located in the inner region.

In the fifteenth embodiment, two alignment marks 24a and 24b are provided on the extended lines of the electrode lines of electrodes for first conductivity type 24, and two alignment marks 25a and 25b are provided on the extended lines of the electrode lines of electrodes for second conductivity type 25. The dispositions of the alignment marks are not limited to the fifteenth embodiment. At least four alignment marks may be disposed.

For example, four alignment marks 24a, 24b, 25a, and 25b may be provided, and at least one alignment mark may be provided on the extended line of at least one of the electrode lines of electrode for first conductivity type 24 and electrode for second conductivity type 25.

In the fifteenth embodiment, alignment marks 24a and 25a and alignment marks 24b and 25b are located on the extended lines of the electrode lines adjacent to each other. However, the dispositions of alignment marks 24a and 25a and alignment marks 24b and 25b are not limited to the fourteenth embodiment. Alignment marks 24a and 25a and alignment marks 24b and 25b may be located on the extended lines of the electrode lines that are not adjacent to each other.

Alignment marks 24a and 25a may have different shapes. During the alignment, the alignment mark overlapped with alignment target region 18 in back contact solar cell 20 disposed in column L₁ and the alignment mark overlapped with alignment target region 18 in back contact solar cell 20 disposed in column L₂ may have different shapes.

In such cases, whether back contact solar cell 20 is disposed in the desired direction can be checked because the alignment marks having the different shapes can be checked in each of back contact solar cells 20 disposed in different columns on wiring sheet 10.

Preferably the position and the shape of the alignment mark are not symmetrical with respect to the center of the electrode pattern of back contact solar cell 20 in the paper plane of Fig. 49. According to the configuration, when back contact solar cell 20 is rotated by 180° in the paper plane in the process of placing back contact solar cell 20 on wiring sheet 10, the alignment mark cannot be observed, or the shape of the observed alignment mark is different from the original shape, so that it can be noticed that back contact solar cell 20 is mistakenly disposed. As a result, the alignment of back contact solar cell 20 on wiring sheet 10 with contact solar cell 20 mistakenly rotated can be prevented.

### (Identical Shape Portion and Different Shape Portion in Wiring Sheet)

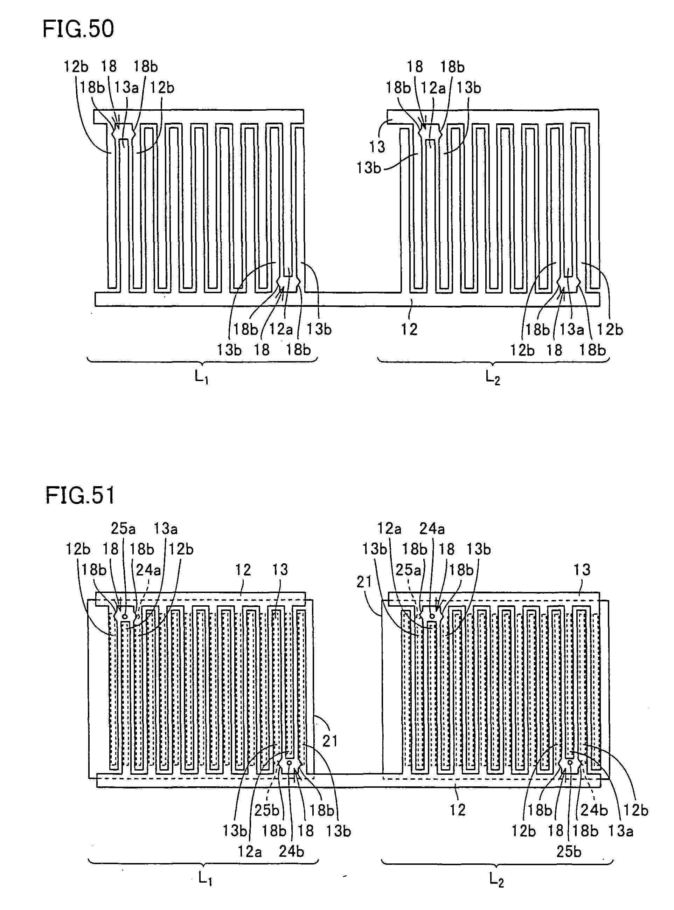

Fig. 50 is a plan view illustrating a wiring pattern of a wiring sheet of the fifteenth embodiment. In Fig. 50, only the wiring material is illustrated with respect to parts of columns L₁ and L₂ in Fig. 1.

As illustrated in Fig. 50, in wiring sheet 10 of the fifteenth embodiment, both first wiring 12 and second wiring 13 include the different shape portion. Different shape portion 12b of first wiring 12 and different shape portion 13b of second wiring 13 are identical to those of the second embodiment. Different shape portion 12a of first wiring 12 and different shape portion 13a of second wiring 13 are identical to those of the first embodiment.

Alignment target region 18 is defined by different shape portion 12b and different shape portion 13a, and alignment target region 18 is also defined by different shape portion 12a and different shape portion 13b. Wiring sheet 10 of the fifteenth embodiment includes the case that alignment target region 18 is defined only by the different shape portion of at least one of first wiring 12 and second wiring 13.

One of the features of wiring sheet 10 of the fifteenth embodiment is that wiring sheet 10 includes at least two alignment target regions 18 defined by the different shape portions. In the fifteenth embodiment, desirably at least two of alignment marks 24a, 24b, 25a, and 25b included in back contact solar cell 20 can be recognized through alignment target region 18.

The wiring pattern including first wiring 12 and second wiring 13 may be included in at least one cell disposition portion 19 in whole wiring sheet 10.

### (Alignment between Back contact Solar Cell and Wiring Sheet)

Fig. 51 is a plan view illustrating a state in which the back contact solar cell and the wiring sheet of the fifteenth embodiment are overlapped with each other when viewed from the back surface side of the solar cell having wiring sheet. Only columns L₁ and L₂ in Fig. 1 are partially illustrated in Fig. 51.

As illustrated in Fig. 51, in wiring sheet 10 disposed in column L₁, the alignment between back contact solar cell 20 and wiring sheet 10 is performed such that alignment marks 24b of back contact solar cell 20 and alignment target region 18 defined by different shape portions 12b and 13a of wiring sheet 10 are disposed while overlapped with each other, and such that alignment marks 25a of back contact solar cell 20 and alignment target region 18 defined by different shape portions 12b and 13a of wiring sheet 10 are disposed while overlapped with each other. Comb-tooth-shaped portion 17a of first wiring 12 and alignment mark 24a are disposed so as to be overlapped with each other. Comb-tooth-shaped portion 17a of second wiring 13 and alignment mark 25b are disposed so as to be overlapped with each other.

In wiring sheet 10 disposed in column L₂, the alignment between back contact solar cell 20 and wiring sheet 10 is performed such that alignment marks 24a of back contact solar cell 20 and alignment target region 18 defined by different shape portions 12a and 13b of wiring sheet 10 are disposed while overlapped with each other, and such that alignment marks 25b of back contact solar cell 20 and alignment target region 18 defined by different shape portions 12b and 13a of wiring sheet 10 are disposed while overlapped with each other. Comb-tooth-shaped portion 17a of first wiring 12 and alignment mark 24b are disposed so as to be overlapped with each other. Comb-tooth-shaped portion 17a of second wiring 13 and alignment mark 25a are disposed so as to be overlapped with each other.

Using back contact solar cell 20 including plural alignment marks, at least two alignment marks are disposed so as to be overlapped with alignment target regions 18, and at least one alignment mark is disposed so as to be overlapped with the wiring, thereby performing the alignment between back contact solar cell 20 and wiring sheet 10.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In back contact solar cell 20 of the fifteenth embodiment, as described above, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, irrespective of the column, all back contact solar cells 20 can be disposed on wiring sheet 10 while kept in one direction. Accordingly, the component management is easy to perform, and the process to rotate back contact solar cell 20 is reduced to improve the production efficiency.

In the fifteenth embodiment, because two alignment mark 24b and 25a or two alignment marks 24a and 25b can be distinguished from each other for one, back contact solar cell 20 through alignment target region 18 of wiring sheet 10, the alignment between back contact solar cell 20 and wiring sheet 10 can accurately be performed in not only the vertical and horizontal directions also the rotating direction.

In the fifteenth embodiment, the good alignment between back contact solar cell 20 and wiring sheet 10 can be performed to prepare the high-reliability solar cell having wiring sheet and the high-reliability solar cell module.

In the fifteenth embodiment, because alignment marks 24a and 24b and alignment marks 25a and 25b are not provided at both the end of one electrode line unlike the twelfth embodiment, the degree of freedom of the design for the electrode pattern and the wiring pattern is enhanced compared with the twelfth embodiment.

In the fifteenth embodiment, because the alignment marks are provided on the extended lines of the electrode lines of both electrode for first conductivity type 24 and electrode for second conductivity type 25, the effective electrode lengths become identical in both the conductivity types, and the power generation efficiency of the solar cell having wiring sheet can be improved.

Because alignment marks 24a and 25a are provided on one end portion side in the electrode-line extending direction, alignment marks 24a and 25a can be provided close to each other. Particularly, when alignment marks 24a and 25a are formed on the extended lines of the adjacent electrode lines, alignment marks 24a and 25a are closest to each other.

Similarly, because alignment marks 24b and 25b are provided on the other end portion side in the electrode-line extending direction, alignment marks 24b and 25b can be provided close to each other. Particularly, alignment marks 24b and 25b are formed on the extended lines of the adjacent electrode lines, alignment marks 24b and 25b are closest to each other.

In this case, during the alignment between wiring sheet 10 and back contact solar cell 20, back contact solar cell 20 disposed in column L₁ is substantially identical to back contact solar cell 20 disposed in column L₂ in the observed positions of alignment marks 24a and 25a and the observed positions of alignment marks 24b and 25b, the observation position of the observation device can be restricted, and simplification and accuracy enhancement of the alignment device are effectively achieved.

In the fifteenth embodiment, as illustrated in Fig. 49, because the alignment marks for different conductivity type are provided on both the end portion sides in the electrode-line extending direction, the alignment mark that can be observed through alignment target region 18 of wiring sheet 10 is included in each of both the end portion sides in the electrode-line extending direction, and a distance between two alignment marks observed in one back contact solar cell 20 can be lengthened compared with the case that, for example, the alignment mark is provided in the electrode line on the identical end portion side as illustrated in Fig. 48. For example, the alignment can be performed at two points near opposing corners of back contact solar cell 20. In this case, the alignment can more accurately be performed compared with the case that two alignment marks located on the identical end portion side of the electrode line are observed (alignment on one side of back contact solar cell 20).

A back contact solar cell, a wiring sheet, a solar cell having wiring sheet, a solar cell module, and a production method for the solar cell having wiring sheet according to a sixteenth embodiment of the invention will be described below.

### <Sixteenth Embodiment>

The repetitive description of the same component as the fifteenth embodiment is not given because the sixteenth embodiment differs from the fifteenth embodiment only in that the space where the alignment mark is located is formed over the plural electrode lines.

### (Alignment Mark in Back contact Solar Cell)

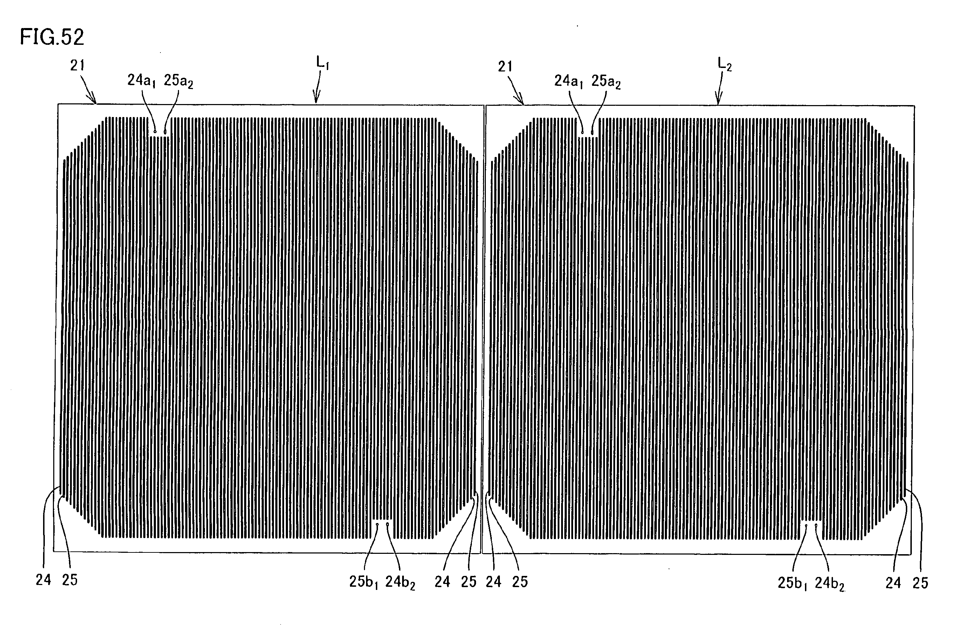

Fig. 52 is a plan view illustrating a back surface of a back contact solar cell of the sixteenth embodiment of the invention. Only columns L₁ and L₂ in Fig. 1 are partially illustrated in Fig. 52.

As illustrated in Fig. 52, in back contact solar cell 20 of the sixteenth embodiment of the invention, back contact solar cell 20 disposed in column L₁ and back contact solar cell 20 disposed in column L₂ have the identical electrode pattern.

In the sixteenth embodiment, three electrode lines adjacent to one another are grouped, and four groups of electrode lines are formed shorter than other electrodes for first conductivity type 24 and other electrodes for second conductivity type 25. The short electrode line independent of the space where the alignment mark is located may be included.

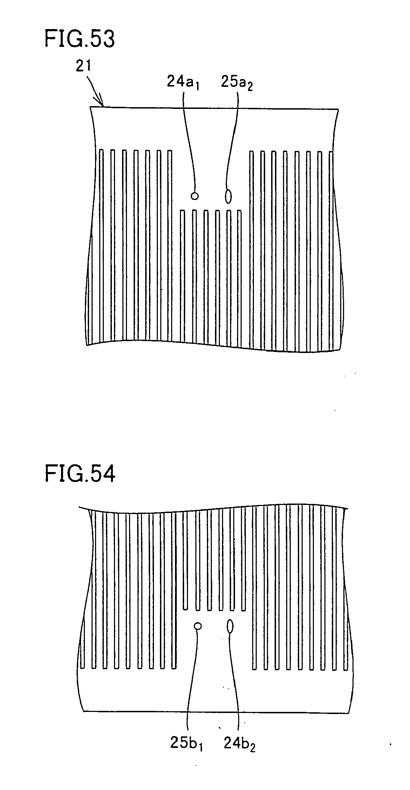

Fig. 53 is a partially enlarged view illustrating the alignment mark formed on one of end portion sides in the electrode extending direction. Fig. 54 is a partially enlarged view illustrating the alignment mark formed on the other end portion side in the electrode extending direction.

As illustrated in Fig. 53, in each of two groups of shortly-formed electrode lines, alignment marks 24a₁ and 25a₂ are formed near the end portion of the electrode line located in the center. As illustrated in Fig. 54, in each of two groups of shortly-formed electrode lines, alignment marks 24b₂ and 25b₁ are formed near the end portion of the electrode line located in the center. Alignment marks 24a₁ and 25b₁ are formed into a circular point shape, and alignment marks 24b₂ and 25a₂ are formed into an elliptical point shape wider than the electrode line.

In the case that the alignment mark has the shape wider than the electrode line, preferably a discrimination power of the alignment mark can be improved. However, the distance between the alignment mark and the adjacent electrode line is decreased with increasing width of the alignment mark, and possibly migration is generated. In the sixteenth embodiment, because the space where alignment marks 24b₂ and 25a₂ are located is formed while straddling three electrode lines, the distance between alignment marks 24b₂ and 25a₂ and the electrode line can be ensured to suppress the generation of

the migration.

The number of shortly-formed electrode lines may properly be changed according to the width of the alignment mark, accuracy in forming the electrode line and the alignment mark, and accuracy of the observation device.

Alignment marks 24a₁ and 25a₂ are formed near one of the end portions of the electrode in the electrode extending direction. Alignment marks 24b₂ and 25b₁ are formed near the other end portion of the electrode in the electrode extending direction. Alignment marks 24a₁, 24b₂, 25a₂, and 25b₁ are located in the space where the plural electrodes are not located in the inner region.

In the sixteenth embodiment, two alignment marks 24a₁ and 24b₂ are provided on the extended lines of the electrode lines of electrodes for first conductivity type 24, and two alignment marks 25a₂ and 25b₁ are provided on the extended lines of the electrode lines of electrodes for second conductivity type 25. The dispositions of the alignment marks are not limited to the sixteenth embodiment. At least four alignment marks may be disposed.

### (Identical Shape Portion and Different Shape Portion in Wiring Sheet)

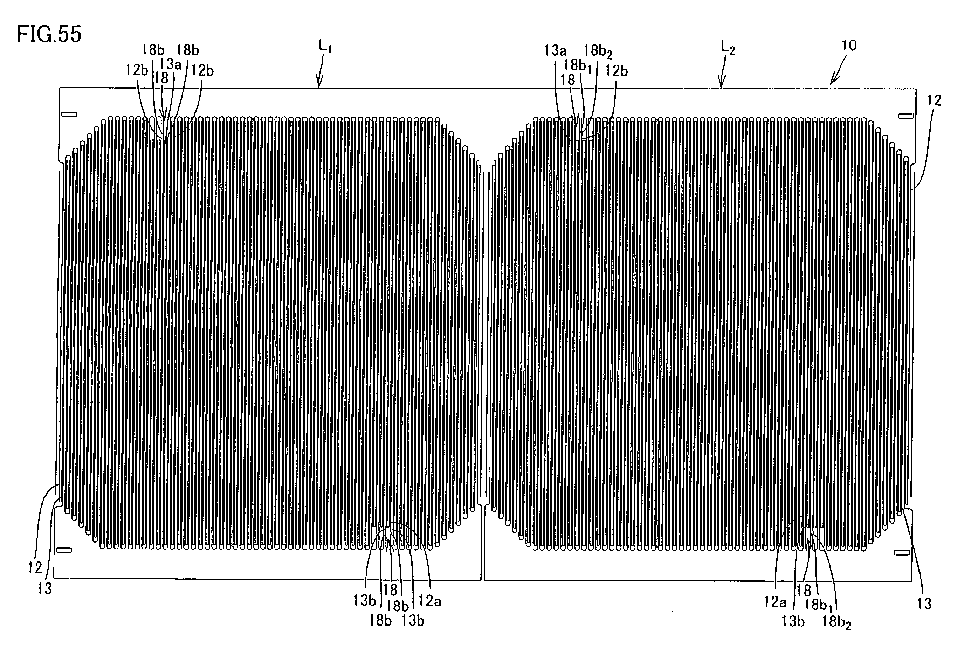

Fig. 55 is a plan view illustrating a wiring pattern of a wiring sheet of the sixteenth embodiment. In Fig. 55, only the wiring material is illustrated with respect to parts of columns L₁ and L₂ in Fig. 1.

As illustrated in Fig. 55, in wiring sheet 10 of the sixteenth embodiment, both first wiring 12 and second wiring 13 include the different shape portion. Each of first wiring 12 and second wiring 13 includes at least three different shape portions 12a and 13a. Different shape portions 12a and 13a of first wiring 12 and second wiring 13 are identical to those of the first embodiment. First wiring 12 and second wiring 13 includes different shape portions 12b and 13b, respectively.

In wiring sheet 10 disposed in column L₁, different shape portions 12b and 13b of first wiring 12 and second wiring 13 are identical to those of the second embodiment. In wiring sheet 10 disposed in column L₂, different shape portions 12b and 13b of first wiring 12 and second wiring 13 include bent portions 18b₁ and 18b₂, and comb-tooth-shaped portion 17a is partially curved without changing the width of comb-tooth-shaped portion 17a. In this case, bent portion 18b₂ parallel to bent portion 18b₁ is formed in the lateral portion on the opposite side of the lateral portion of comb-tooth-shaped portion 17a in which bent portion 18b₁ is formed.

Alignment target regions 18 are defined by different shape portions 13a and 12b and different shape portions 12a and 13, respectively. Wiring sheet 10 of the sixteenth embodiment includes the case that each alignment target region 18 is defined only by the different shape portion of at least of first wiring 12 and second wiring 13.

In wiring sheet 10, the wiring lengths of three comb-tooth-shaped portions are shortened in the positions corresponding to the space where the alignment marks are provided in back contact solar cell 20. In the case of the configuration, from the viewpoint of current taking-out efficiency, preferably the connection to electrode for first conductivity type 24 or electrode for second conductivity type 25, which is provided in back contact solar cell 20, can be ensured in other identical shape portions having the identical wiring length.

The wiring pattern including first wiring 12 and second wiring 13 may be included in at least one cell disposition portion 19 in whole wiring sheet 10.

### (Alignment between Back contact Solar Cell and Wiring Sheet)

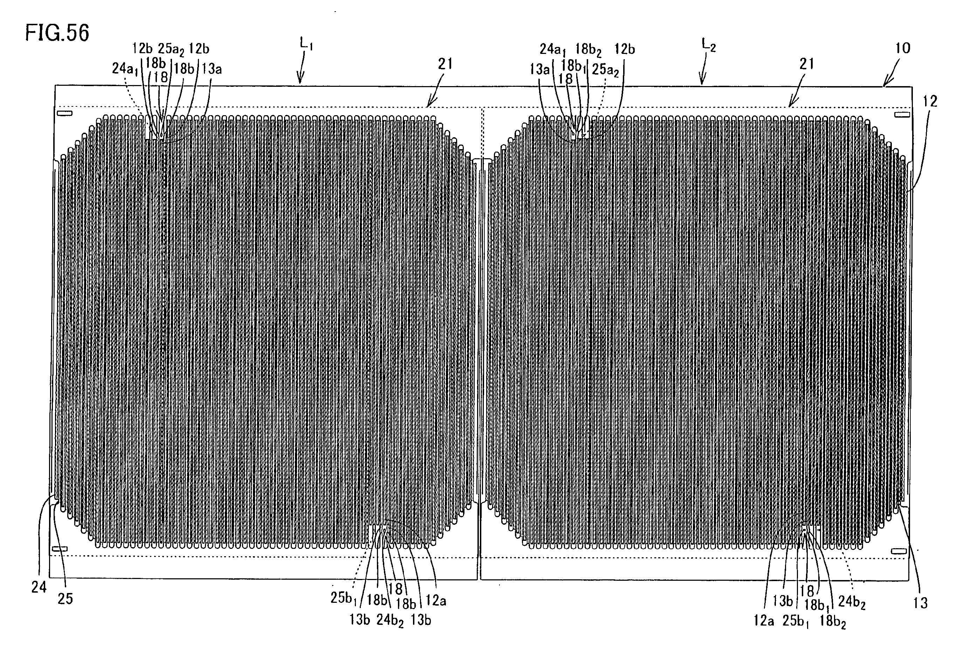

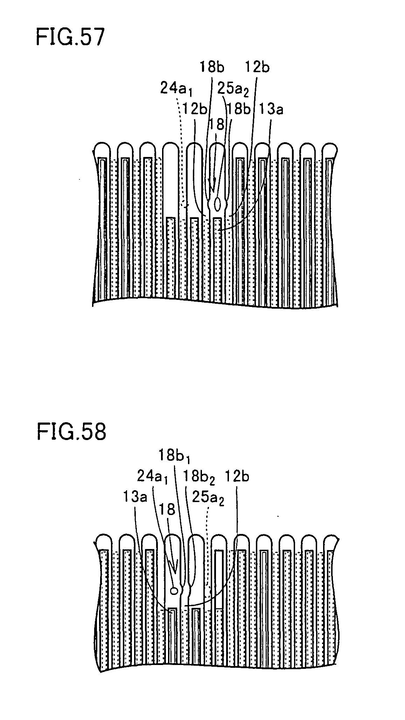

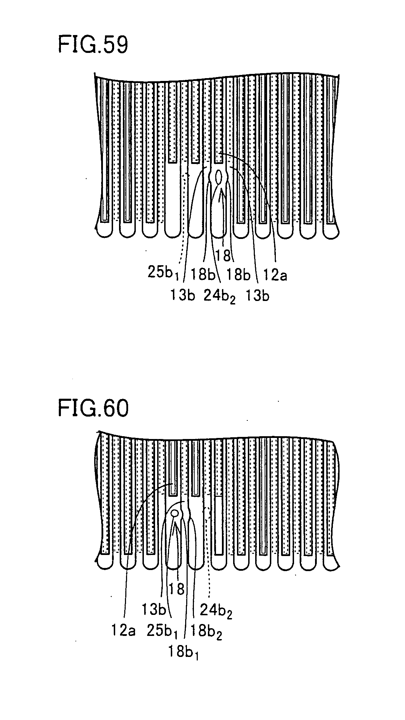

Fig. 56 is a plan view illustrating a state in which the back contact solar cell and the wiring sheet of the sixteenth embodiment are overlapped with each other when viewed from the back surface side of the solar cell having wiring sheet. Fig. 57 is a partially enlarged view illustrating one of end portion sides of the solar cell having wiring sheet located in column L₁. Fig. 58 is a partially enlarged view illustrating one of end portion sides of the solar cell having wiring sheet located in column L₂. Fig. 59 is a partially enlarged view illustrating the other end portion side of the solar cell having wiring sheet located in column L₁. Fig. 60 is a partially enlarged view illustrating the other end portion side of the solar cell having wiring sheet located in column L₂. Only columns L₁ and L₂ in Fig. 1 are partially illustrated in Fig. 56.

As illustrated in Figs. 56, 57, and 59, in wiring sheet 10 disposed in column L₁, the alignment between back contact solar cell 20 and wiring sheet 10 is performed such that alignment marks 24b₂ and 25a₂ of back contact solar cell 20 and alignment target region 18 defined by different shape portions 12a and 13b of wiring sheet 10 are disposed while overlapped with each other, and such that alignment marks 25a₂ of back contact solar cell 20 and alignment target region 18 defined by different shape portions 12b and 13a of wiring sheet 10 are disposed while overlapped with each other. Comb-tooth-shaped portion 17a of first wiring 12 and alignment mark 24a₁ are disposed so as to be overlapped with each other. Comb-tooth-shaped portion 17a of second wiring 13 and alignment mark 25b₁ are disposed so as to be overlapped with each other.

As illustrated in Figs. 56, 58, and 60, in wiring sheet 10 disposed in column L₁, the alignment between back contact solar cell 20 and wiring sheet 10 is performed such that alignment mark 24a₁ of back contact solar cell 20 and alignment target region 18 defined by different shape portions 12a and 13b of wiring sheet 10 are disposed while overlapped with each other, and such that alignment marks 25b₁ of back contact solar cell 20 and alignment target region 18 defined by different shape portions 12b and 13a of wiring sheet 10 are disposed while overlapped with each other. Comb-tooth-shaped portion 17a of first wiring 12 and alignment mark 24b₂ are disposed so as to be overlapped with each other. Comb-tooth-shaped portion 17a of second wiring 13 and alignment mark 25a₂ are disposed so as to be overlapped with each other.

Using back contact solar cell 20 including plural alignment marks, at least two alignment marks are disposed so as to be overlapped with alignment target regions 18, and at least one alignment mark is disposed so as to be overlapped with the wiring, thereby performing the alignment between back contact solar cell 20 and wiring sheet 10.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In back contact solar cell 20 of the sixteenth embodiment, as described above, back contact solar cell 20 disposed in column L₁ and back contact solar cell 20 disposed in column L₂ have the identical electrode pattern. Back contact solar cells 20 are disposed in columns L₁ and L₂ adjacent to each other while back contact solar cell 20 disposed in one of columns L₁ and L₂ is not rotated by 180° in the paper plane. Accordingly, when back contact solar cell 20 is disposed in wiring sheet 10, the orientations of back contact solar cells 20 disposed in columns L₁ and L₂ adjacent to each other can be kept in one direction.

Therefore, irrespective of the column, all back contact solar cells 20 can be disposed on wiring sheet 10 while kept in one direction. Accordingly, the component management is easy to perform, and the process to rotate back contact solar cell 20 is reduced to improve the production efficiency.

In back contact solar cell 20 disposed in column L₁, alignment marks 25a₂ and 24b₂ that are formed into the elliptical point shape wider than the electrode line are observed through alignment target region 18. In back contact solar cell 20 disposed in column L₂, alignment marks 25a₁ and 24b₁ that are formed into the circular point shape are observed through alignment target region 18.

By observing the alignment mark having different shape in each column, it can be checked that the alignment is performed such that electrode for first conductivity type 24 of back contact solar cell 20 is properly connected to first wiring 12 of the corresponding wiring sheet, and it can be checked that the alignment is performed such that electrode for second conductivity type 25 of back contact solar cell 20 is properly connected to second wiring 13 of the corresponding wiring sheet. Therefore, the production of the defective product, which is caused by the unintended misalignment, can securely be prevented.

In the sixteenth embodiment, because two alignment marks 25a₂ and 24b₂ or two alignment marks 24a₁ and 25b can be distinguished from each other in each back contact solar cell 20, the alignment between back contact solar cell 20 and wiring sheet 10 can accurately be performed in not only the vertical and horizontal directions also the rotating direction.

In the sixteenth embodiment, the good alignment between back contact solar cell 20 and wiring sheet 10 can be performed to prepare the high-reliability solar cell having wiring sheet and the high-reliability solar cell module.

When the bent portion is provided in the wiring like the sixteenth embodiment, because the alignment mark can be formed wider than the electrode line, the alignment marks are easy to distinguish. The space is formed while straddling the plural electrode lines, and the alignment mark is provided in the space, so that the distance between the alignment mark and the adjacent electrode line can be ensured to suppress the generation of a short-circuit and the migration. The wiring opposite to the alignment target region includes the curved portion (bent portion). Therefore, the distance between the alignment mark and the adjacent electrode line can be ensured to suppress the generation of the short-circuit and the migration.

A back contact solar cell, a wiring sheet, a solar cell having wiring sheet, a solar cell module, and a production method for the solar cell having wiring sheet according to a seventeenth embodiment of the invention will be described below.

### <Seventeenth Embodiment>

The repetitive description of the same component as the fourteenth embodiment is not given because the seventeenth embodiment differs from the fourteenth embodiment only in the number of alignment marks and the configuration of the different shape portion.

### (Alignment Mark in Back contact Solar Cell)

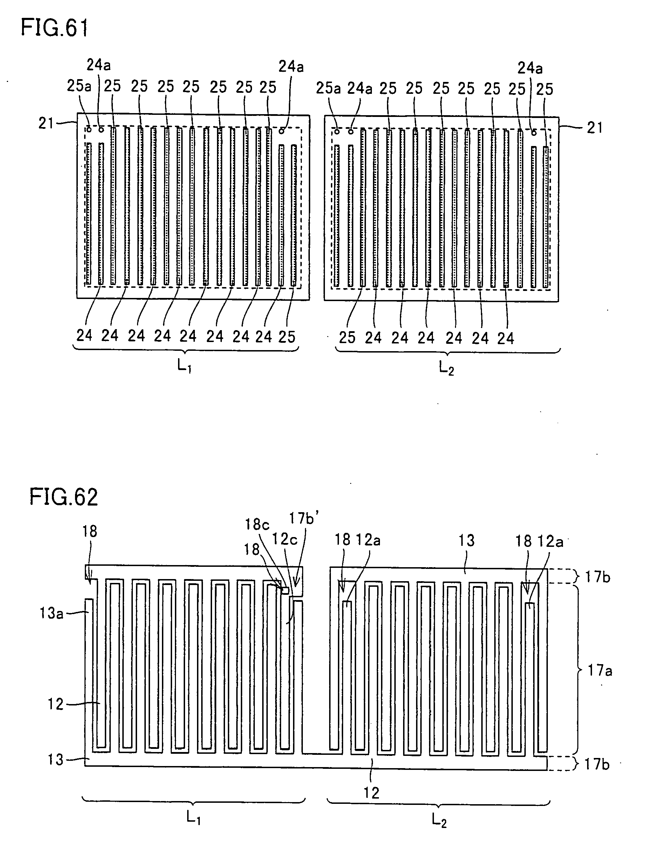

Fig. 61 is a plan view illustrating a back surface of a back contact solar cell of the seventeenth embodiment of the invention. Only columns L₁ and L₂ in Fig. 1 are partially illustrated in Fig. 61.

As illustrated in Fig. 61, in back contact solar cell 20 of the seventeenth embodiment of the invention, back contact solar cell 20 disposed in column L₁ and back contact solar cell 20 disposed in column L₂ have the identical electrode pattern. In each of back contact solar cells 20 disposed in columns L₁ and L₂, four electrodes are formed shorter than other electrodes for first conductivity type 24 and other electrodes for second conductivity type 25.

Specifically, in each of back contact solar cells 20 disposed in columns L₁ and L₂, electrodes for first conductivity type 24, which are disposed second from the right and second from the left, and electrodes for second conductivity type 25, which are disposed first from the left and first from the right, are formed short.

Circular-point-like alignment mark 24a is formed near the leading end of shortly-formed electrode for first conductivity type 24 in both back contact solar cells 20 disposed in columns L₁ and L₂. Circular-point-like alignment mark 25a is formed near the leading end of electrode for second conductivity type 25, which is formed short first from the left. In the seventeenth embodiment, alignment marks 24a and 25a are formed on the extended lines of the extending directions of the electrode lines having the different conductivity types.

### (Identical Shape Portion and Different Shape Portion in Wiring Sheet)

Fig. 62 is a plan view illustrating a wiring pattern of a wiring sheet of the seventeenth embodiment. In Fig. 62, only the wiring material is illustrated with respect to parts of columns L₁ and L₂ in Fig. 1.

In the seventeenth embodiment, first wiring 12 includes different shape portions 12a and 12c. Second wiring 13 includes different shape portion 13a. Different shape portions 12a and 13a are formed such that at least one of plural comb-tooth-shaped portions 17a is shorter than other comb-tooth-shaped portion 17a that are the identical shape portion.

Different shape portion 12c is formed such that first wiring 13 includes rectangular opening 18c. In the seventeenth embodiment, opening 18c is formed in a connection wiring portion 17b'. In connection wiring portion 17b, connection wiring portion 17b' is opposite to the inner region of back contact solar cell 20. Opening 18c may be formed in comb-tooth-shaped portion 17a or connection wiring portion 17b, or opening 18c may be formed while straddling comb-tooth-shaped portion 17a, connection wiring portion 17b, and connection wiring portion 17b'.

In wiring sheet 10 disposed in column L₁, connection wiring portion 17b' is connected to comb-tooth-shaped portion 17a of first wiring 12, which is formed second from the right. Thus, opening 18c is provided in the wiring, and the alignment mark of back contact solar cell 20 is provided near an outer edge of the inner region so as to correspond to opening 18c. In this case, the electrode adjacent to the alignment mark may be formed short.

In the seventeenth embodiment, electrode for second conductivity type 25, which is formed first from the right, is formed short as illustrated in Fig. 61. Therefore, although the collection efficiency of the power generated by back contact solar cell 20, the connection wiring portion can be widened like connection wiring portion 17b' in Fig. 62, the generation of disconnection caused by the wiring thinned around opening 18c by the formation of opening 18c, can be prevented. The seventeenth embodiment can also be applied to other embodiments, in which the wiring is partially thinned or bent or the opening is formed.

In wiring sheet 10 disposed in column L₁, alignment target regions 18 are defined by different shape portion 12c and different shape portion 13a, respectively. In wiring sheet 10 disposed in column L₂, alignment target regions 18 are defined by different shape portions 12a, respectively.

One of the features of wiring sheet 10 of the seventeenth embodiment is that wiring sheet 10 includes at least two alignment target regions 18 defined by the different shape portions. In the seventeenth embodiment, desirably at least two of alignment marks 24a and 25a included in back contact solar cell 20 can be recognized through alignment target regions 18.

### (Alignment between Back contact Solar Cell and Wiring Sheet)

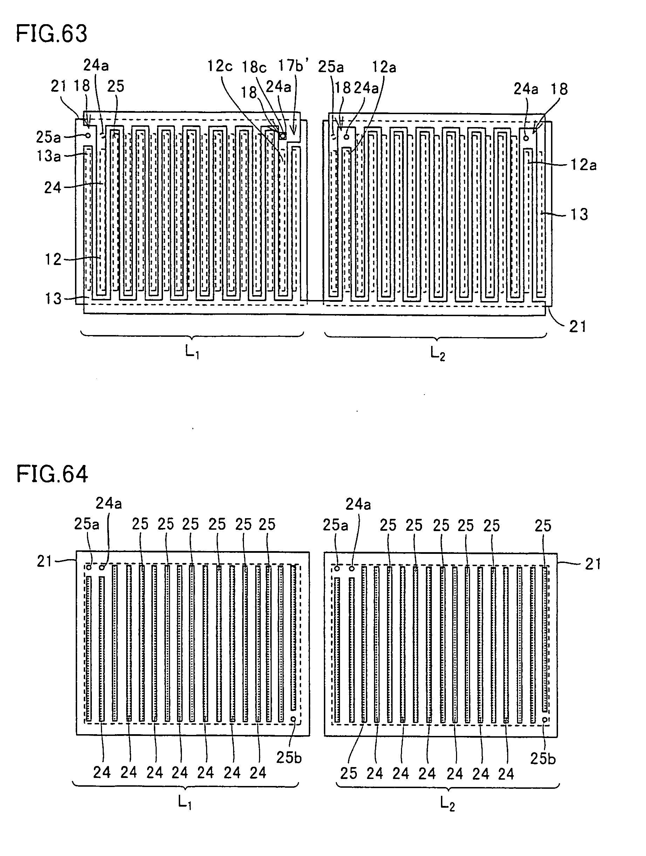

Fig. 63 is a plan view illustrating a state in which the back contact solar cell and the wiring sheet of the seventeenth embodiment are overlapped with each other when viewed from the back surface side of the solar cell having wiring sheet. Only columns L₁ and L₂ in Fig. 1 are partially illustrated in Fig. 63.

As illustrated in Fig. 63, in wiring sheet 10 disposed in column L₁, alignment mark 25a of back contact solar cell 20 and alignment target region 18 defined by different shape portion 13a of wiring sheet 10 are disposed while overlapped with each other. Alignment mark 24a of back contact solar cell 20 and alignment target region 18 defined by different shape portion 12c of wiring sheet 10 are disposed while overlapped with each other. Comb-tooth-shaped portion 17a of first wiring 12 and other alignment mark 24a are disposed so as to be overlapped with each other.

In wiring sheet 10 disposed in column L₂, alignment mark 24a of back contact solar cell 20 and alignment target region 18 defined by different shape portion 12a of wiring sheet 10 are disposed while overlapped with each other. Comb-tooth-shaped portion 17a of second wiring 13 and alignment mark 25a are disposed so as to be overlapped with each other.

Using back contact solar cell 20 including at least three alignment marks, at least two alignment marks are disposed so as to be overlapped with alignment target regions 18, and at least one alignment mark is disposed so as to be overlapped with the wiring, thereby performing the alignment between back contact solar cell 20 and wiring sheet 10.

In the seventeenth embodiment, because three alignment marks 24a and 25a are provided for one back contact solar cell 20, the alignment between back contact solar cell 20 and wiring sheet 10 can accurately be performed in not only the vertical and horizontal directions also the rotating direction.

In the case that alignment marks 24a and 25a can be distinguished from each other because the shapes of alignment marks 24a and 25a differ from each other, the alignment can accurately be performed in each of back contact solar cell 20 disposed in column L₁ and back contact solar cell 20 disposed in column L₂ while alignment marks 24a and 25a having the different shapes are distinguished.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In the case that the alignment between back contact solar cell 20 and wiring sheet 10 is performed such that two alignment marks are disposed so as to be overlapped with alignment target regions 18, two alignment marks 24a and 25a are checked in back contact solar cell 20 disposed in column L₁, and two alignment marks 24a are checked in back contact solar cell 20 disposed in column L₂.

In this case, because the checked alignment mark depends on the column, the orientation of back contact solar cell 20 in the electrode-line extending direction and a position deviation in the direction in which the electrode lines are arrayed can be checked to accurately perform the alignment.

For example, when alignment mark 24a and 25a are located on the extended lines of the electrode lines of the different conductivity types, during the alignment between back contact solar cell 20 and wiring sheet 10, it can be checked that the alignment is performed such that electrode for first conductivity type 24 of back contact solar cell 20 is properly connected to first wiring 12 of the corresponding wiring sheet, and it can be checked that the alignment is performed such that electrode for second conductivity type 25 of back contact solar cell 20 is properly connected to second wiring 13 of the corresponding wiring sheet. Therefore, the production of the defective product, which is caused by the unintended misalignment, can securely be prevented.

In back contact solar cell 20 of the seventeenth embodiment, as described above, back contact solar cell 20 disposed in column L₁ and back contact solar cell 20 disposed in column L₂ have the identical electrode pattern.

Therefore, as illustrated in Fig. 15, irrespective of the column, all back contact solar cells 20 can be disposed on wiring sheet 10 while alignment marks 24a and 25a are located on the leading end side indicated by the arrow. Accordingly, the component management is easy to perform, and the production process is reduced to improve the production efficiency.

In the seventeenth embodiment, each three of the alignment marks and the different shape portions are provided for one solar cell having wiring sheet. However, the numbers of alignment marks and different shape portions are not limited to those of the seventeenth embodiment.

In the seventeenth embodiment, the good alignment between back contact solar cell 20 and wiring sheet 10 can be performed to prepare the high-reliability solar cell having wiring sheet and the high-reliability solar cell module.

In the seventeenth embodiment, four alignment marks of back contact solar cell 20 of the fourteenth embodiment are decreased to three alignment marks, so that the improvement of the production efficiency can be expected by-decreasing the number of alignment marks in which the fine, precise shape is required. Additionally, the electrode can be lengthened by eliminating one alignment mark. In this case, the current taking-out efficiency of the solar cell having wiring sheet can be improved.

A back contact solar cell, a wiring sheet, a solar cell having wiring sheet, a solar cell module, and a production method for the solar cell having wiring sheet according to an eighteenth embodiment of the invention will be described below.

### <Eighteenth Embodiment>

The repetitive description of the same component as the fifteenth embodiment is not given because the eighteenth embodiment differs from the fifteenth embodiment only in the number of alignment marks and the configuration of the different shape portion.

### (Alignment Mark in Back contact Solar Cell)

Fig. 64 is a plan view illustrating a back surface of a back contact solar cell of the eighteenth embodiment of the invention. Only columns L₁ and L₂ in Fig. 1 are partially illustrated in Fig. 64.

As illustrated in Fig. 64, in back contact solar cell 20 of the eighteenth embodiment of the invention, back contact solar cell 20 disposed in column L₁ and back contact solar cell 20 disposed in column L₂ have the identical electrode pattern.

In the eighteenth embodiment, electrode for first conductivity type 24, which is disposed second from the left in the direction in which the electrodes are arrayed, is formed shorter than other electrodes for first conductivity type 24 and other electrodes for second conductivity type 25. Electrodes for second conductivity type 25, which are disposed first from the left and first from the right in the direction in which the electrodes are arrayed, are formed shorter than other electrodes for first conductivity type 24 and other electrodes for second conductivity type 25.

Circular-point-like alignment marks 24a, 25a, and 25b are formed near the leading ends of shortly-formed electrode for first conductivity type 24 and shortly-formed electrodes for second conductivity type 25. Alignment marks 24a and 25a are formed near one of the end portions of the electrode in the electrode extending direction, and alignment mark 25b is formed near the other end portion of the electrode. In the eighteenth embodiment, alignment mark 24a and alignment marks 25a and 25b are formed on the extended lines of the electrode lines having the different conductivity types, alignment marks 24a and 25a are disposed close to each other, and alignment mark 25b is separately on the opposite side of disposed alignment marks 24a and 25a.

### (Identical Shape Portion and Different Shape Portion in Wiring Sheet)

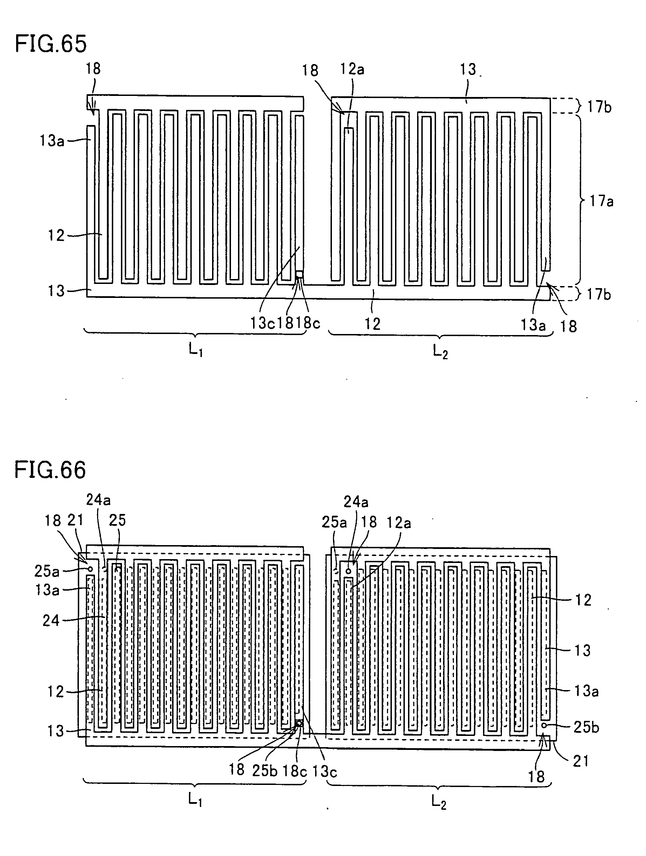

Fig. 65 is a plan view illustrating a wiring pattern of a wiring sheet of the eighteenth embodiment. In Fig. 65, only the wiring material is illustrated with respect to parts of columns L₁ and L₂ in Fig. 1.

In the eighteenth embodiment, first wiring 12 includes different shape portion 12a. Second wiring 13 includes different shape portions 13a and 13c. Different shape portions 12a and 13a are formed such that at least one of plural comb-tooth-shaped portions 17a is shorter than other comb-tooth-shaped portions 17a that are the identical shape portion.

Different shape portion 13c is formed such that second wiring 13 includes rectangular opening 18c. In the eighteenth embodiment, opening 18c is formed in comb-tooth-shaped portion 17a.

In wiring sheet 10 disposed in column L₁, alignment target regions 18 are defined by different shape portions 13a and different shape portion 13c, respectively. In wiring sheet 10 disposed in column L₂, alignment target regions 18 are defined by different shape portion 12a and different shape portion 13a, respectively.

One of the features of wiring sheet 10 of the eighteenth embodiment is that wiring sheet 10 includes at least two alignment target regions 18 defined by the different shape portions. In the eighteenth embodiment, desirably at least two of alignment marks 24a and 25a included in back contact solar cell 20 can be recognized through alignment target regions 18.

### (Alignment between Back contact Solar Cell and Wiring Sheet)

Fig. 66 is a plan view illustrating a state in which the back contact solar cell and the wiring sheet of the eighteenth embodiment are overlapped with each other when viewed from the back surface side of the solar cell having wiring sheet. Only columns L₁ and L₂ in Fig. 1 are partially illustrated in Fig. 66.

As illustrated in Fig. 66, in wiring sheet 10 disposed in column L₁, alignment mark 25a of back contact solar cell 20 and alignment target region 18 defined by different shape portion 13a of wiring sheet 10 are disposed while overlapped with each other. Alignment mark 25b of back contact solar cell 20 and alignment target region 18 defined by different shape portion 13c of wiring sheet 10 are disposed while overlapped with each other. Comb-tooth-shaped portion 17a of first wiring 12 and alignment mark 24a are disposed so as to be overlapped with each other.

In wiring sheet 10 disposed in column L₂, alignment mark 24a of back contact solar cell 20 and alignment target region 18 defined by different shape portion 12a of wiring sheet 10 are disposed while overlapped with each other. Alignment mark 25b of back contact solar cell 20 and alignment target region 18 defined by different shape portion 13a of wiring sheet 10 are disposed while overlapped with each other. Comb-tooth-shaped portion 17a of second wiring 13 and alignment mark 25a are disposed so as to be overlapped with each other.

Using back contact solar cell 20 including at least three alignment marks, at least two alignment marks are disposed so as to be overlapped with alignment target regions 18, and at least one alignment mark is disposed so as to be overlapped with the wiring thereby performing the alignment between back contact solar cell 20 and wiring sheet 10.

In the eighteenth embodiment, because three alignment marks 24a, 25a, and 25b are provided for one back contact solar cell 20, the alignment between back contact solar cell 20 and wiring sheet 10 can accurately be performed in not only the vertical and horizontal directions also the rotating direction.

The distance between two alignment marks (alignment marks 25a and 25b in column L₁, or alignment marks 24a and 25b in column L₂) that can be recognized from alignment target region 18 is lengthened such that alignment mark 25b that can be recognized from alignment target region 18 in each column is disposed distant from alignment marks 24a and 25a. Therefore, the alignment between back contact solar cell 20 and wiring sheet 10 can more accurately be performed.

As illustrated in Fig. 64, preferably alignment mark 25b that can be recognized from alignment target region 18 in each column and alignment marks 24a and 25a in which the alignment mark to be recognized depends on the column are disposed at opposite corners as much as possible in the inner region of back contact solar cell 20.

In the case that alignment marks 24a and 25a can be distinguished from each other because the shapes of alignment marks 24a and 25a differ from each other, the alignment can accurately be performed in each of back contact solar cell 20 disposed in column L₁ and back contact solar cell 20 disposed in column L₂ while alignment marks 24a and 25a are distinguished.

Alternatively, the alignment between back contact solar cell 20 and wiring sheet 10 may be performed such that at least one alignment mark is disposed so as to be overlapped with alignment target region 18, or such that at least one alignment mark is disposed so as to be overlapped with the wiring.

In the case that the alignment between back contact solar cell 20 and wiring sheet 10 is performed such that two alignment marks are disposed so as to be overlapped with alignment target regions 18, two alignment marks 25a and 25b are checked in back contact solar cell 20 disposed in column L₁, and two alignment marks 24a and 25b are checked in back contact solar cell 20 disposed in column L₂.

In this case, because the checked alignment mark depends on the column, the orientation of back contact solar cell 20 in the electrode-line extending direction and the position deviation in the direction in which the electrode lines are arrayed can be checked to accurately perform the alignment.

For example, when alignment mark 24a and 25a are located on the extended lines of the electrode lines of the different conductivity types, during the alignment between back contact solar cell 20 and wiring sheet 10, it can be checked that the alignment is performed such that electrode for first conductivity type 24 of back contact solar cell 20 is properly connected to first wiring 12 of the corresponding wiring sheet, and it can be checked that the alignment is performed such that electrode for second conductivity type 25 of back contact solar cell 20 is properly connected to second wiring 13 of the corresponding wiring sheet. Therefore, the production of the defective product, which is caused by the unintended misalignment, can securely be prevented.

In back contact solar cell 20 of the eighteenth embodiment, as described above, back contact solar cell 20 disposed in column L₁ and back contact solar cell 20 disposed in column L₂ have the identical electrode pattern.

Therefore, as illustrated in Fig. 15, irrespective of the column in which contact solar cell is to be disposed, all back contact solar cells 20 can be disposed on wiring sheet 10 while alignment mark 24a and 25a are located on the leading end side indicated by the arrow. Accordingly, the component management is easy to perform, and the production process is reduced to improve the production efficiency.

In the eighteenth embodiment, each three of the alignment marks and the different shape portions are provided for one solar cell having wiring sheet. However, the numbers of alignment marks and different shape portions are not limited to those of the eighteenth embodiment.

In the eighteenth embodiment, the good alignment between back contact solar cell 20 and wiring sheet 10 can be performed to prepare the high-reliability solar cell having wiring sheet and the high-reliability solar cell module.

In the eighteenth embodiment, four alignment marks of back contact solar cell 20 of the fifteenth embodiment are decreased to three alignment marks, so that the improvement of the production efficiency can be expected by decreasing the number of alignment marks in which the fine, precise shape is required. Additionally, the electrode can be lengthened by eliminating one alignment mark. In this case, the current taking-out efficiency of the solar cell having wiring sheet can be improved.

In all the above embodiments, it is intended from the beginning that the configurations that can be combined with each other are properly combined.

The disclosed embodiments are described only by way of example, and the invention is not limited to the embodiments. The scope of the invention is determined only by the following claims, and changes and modifications of the meaning and scope equivalent to the following claims are included.

### REFERENCE SIGNS LIST

10 wiring sheet, 11 insulating base material, 12 first wiring, 12a, 12b, 12c, 12d, 13a, 13b, 13c, 13d different shape portion, 13 second wiring, 15 observation device, 16 wiring material, 17a comb-tooth-shaped portion, 17b connection wiring portion, 18 alignment target region, 18b₁,18b₂,18b₁,18b₂,18b₂,18d bent portion, 18c opening, 19 cell disposition portion, 20 back contact solar cell, 21 semiconductor substrate, 22 first conductivity type impurity diffusion region, 23 second conductivity type impurity diffusion region, 24 electrode for first conductivity type, 24a, 24a₁, 24b, 25a, 25a₁, 25a₂, 25b, 25b₁, 24b₂, 25c, 28, 29 alignment mark, 25 electrode for second conductivity type, 26 passivation film, 27 antireflection film, 31 sealing material, 31a first transparent resin, 31 b second transparent resin, 32 back-surface protecting sheet, 33 transparent substrate, 100 solar cell having wiring sheet

## Claims

1. A back contact solar cell (20) comprising an alignment mark (24a, 24a₁, 24b, 25a, 25a₁, 25a₂, 25b, 25b₁, 24b₂, 25c, 28, 29) in an inner region inside of an outer periphery of an electrode pattern that includes a plurality of electrodes (24, 25) formed on one surface side of a semiconductor substrate (21).

2. The back contact solar cell (20) according to claim 1, wherein said alignment mark (24a, 24a₁, 24b, 25a, 25a₁, 25a₂, 25b, 25b₁, 24b₂, 25c, 28, 29) is located in a space where said plurality of electrodes (24, 25) are not located in said inner region.

3. The back contact solar cell (20) according to claim 2, wherein said electrode (24, 25) includes a linearly extending electrode line, and
said space is formed such that one end portion in said electrode-line extending direction of at least one of said plurality of electrode lines is located inside of said one end portion in each of other electrode lines in said electrode-line extending direction.

4. The back contact solar cell (20) according to claim 2, wherein said electrode (24, 25) includes a linearly extending electrode line, and
said space is a gap between the electrode lines, the gap being formed such that at least one of said plurality of electrode lines is separately disposed in said electrode-line extending direction.

5. The back contact solar cell (20) according to claim 1, wherein said electrode (24, 25) includes a linearly extending electrode line, and
said alignment mark (24a, 24a₁, 24b, 25a, 25a₁, 25a₂, 25b, 25b₁, 24b2, 25c, 28, 29) is located between electrode lines adjacent to each other in said plurality of electrode lines.

6. The back contact solar cell (20) as in any one of claims 1 to 5, wherein said alignment mark (24a, 24a₁, 24b, 25a, 25a₁, 25a₂, 25b, 25b₁, 24b₂, 25c, 28, 29) is made of a material identical to that of said plurality of electrodes (24, 25).

7. A wiring sheet (10) comprising a wiring (12, 13) electrically connecting a plurality of back contact solar cells (20),
wherein said wiring (12, 13) includes a plurality of identical shape portion having an identical shape and at least one different shape portion (12a, 12b, 12c, 12d, 13a, 13b, 13c, 13d) having a shape different from that of the identical shape portion.

8. The wiring sheet (10) according to claim 7, wherein said wiring (12,13) includes a first wiring (12) and a second wiring (13), which are electrically insulated from each other,
each of said first wiring (12) and said second wiring (13) includes a plurality of comb-tooth-shaped portions (17a) and a connection wiring portion (17b) connecting the plurality of comb-tooth-shaped portions (17a),
at least one of said first wiring (12) and said second wiring (13) includes said identical shape portion and said different shape portion (12a, 13a), and
said different shape portion (12a, 13a) is formed such that at least one of said plurality of comb-tooth-shaped portion (17a) is shorter than other said comb-tooth-shaped portions (17a) that are said identical shape portion.

9. The wiring sheet (10) according to claim 7, wherein said wiring (12,13) includes a first wiring (12) and a second wiring (13), which are electrically insulated from each other,
each of said first wiring (12) and said second wiring (13) includes a plurality of comb-tooth-shaped portions (17a) and a connection wiring portion (17b) connecting the plurality of comb-tooth-shaped portions (17a),
at least one of said first wiring (12) and said second wiring (13) includes said identical shape portion and said different shape portion (12c, 13c), and
said different shape portion (12c, 13c) is formed such that said wiring (12,13) includes an opening (18c).

10. The wiring sheet (10) according to claim 7, wherein said wiring (12, 13) includes a first wiring (12) and a second wiring (13), which are electrically insulated from each other,
each of said first wiring (12) and said second wiring (13) includes a plurality of comb-tooth-shaped portions (17a) and a connection wiring portion (17b) connecting the plurality of comb-tooth-shaped portions (17a),
at least one of said first wiring (12) and said second wiring (13) includes said identical shape portion and said different shape portion (12b, 12d, 13b, 13d), and
said different shape portion (12b, 12d, 13b, 13d) is formed such that at least one of said plurality of comb-tooth-shaped portion (17a) has a shape in which a gap between the comb-tooth-shaped portions (17a) adjacent to each other is partially widened.

11. A solar cell having wiring sheet (100) comprising: the back contact solar cell (20) as in any one of claims 1 to 6; and the wiring sheet (10) as in any one of claims 7 to 10,
wherein at least one of said alignment marks (24a, 24a₁, 24b, 25a, 25a₁, 25a₂, 25b, 25b₁, 24b₂, 25c, 28, 29) is disposed while overlapped with an alignment target region (18) defined by said different shape portion (12a, 12b, 12c, 12d, 13a, 13b, 13c, 13d).

12. The solar cell having wiring sheet (100) according to claim 11, wherein said back contact solar cell (20) includes said plurality of alignment marks (24a, 24awl, 24b, 25a, 25a₁, 25a₂, 25b, 25b₁, 24b₂, 25c, 28, 29).

13. The solar cell having wiring sheet (100) according to claim 12, wherein at least two of said plurality of alignment marks (24a, 24a₁, 24b, 25a, 25a₁, 25a₂, 25b, 25b₁, 24b₂, 25c, 28, 29) are disposed while overlapped with said alignment target region (18).

14. The solar cell having wiring sheet (100) according to claim 12 or 13,
wherein at least one of said plurality of alignment marks (24a, 24a₁, 24b, 25a, 25a₁, 25a₂, 25b, 25b₁, 24b₂, 25c, 28, 29) is disposed while overlapped with said wiring (12, 13).

15. The solar cell having wiring sheet (100) according to claim 11, wherein said back contact solar cell (20) includes at least three of said alignment marks (24a, 24a₁, 24b, 25a, 25a₁, 25a₂, 25b, 25b₁, 24b₂, 25c, 28, 29),
at least two of said alignment marks are disposed while overlapped with said alignment target region (18), and
at least one of said alignment marks is disposed while overlapped with said wiring (12, 13).

16. A solar cell module comprising the solar cell having wiring sheet (100) as in any one of claims 11 to 15.

17. A production method for a solar cell having wiring sheet (100), comprising the steps of:
preparing a back contact solar cells (20) including an alignment mark (24a, 24a₁, 24b, 25a, 25a₁, 25a₂, 25b, 25b₁, 24b₂, 25c, 28, 29) in an inner region inside of an outer periphery of an electrode pattern that includes a plurality of electrodes (24, 25) formed on one surface side of a semiconductor substrate (21);
preparing a wiring sheet (10) electrically connecting said back contact solar cells (20), the wiring sheet (10) including wiring (12, 13) having a plurality of identical shape portions having an identical shape and at least one different shape portion (12a, 12b, 12c, 12d, 13a, 13b, 13c, 13d) having a shape different from that of the identical shape portion; and
performing alignment between said back contact solar cell (20) and said wiring sheet (10) such that said alignment mark (24a, 24a₁, 24b, 25a, 25a₁, 25a₂, 25b, 25b₁, 24b₂, 25c, 28, 29) of said back contact solar cell (20) and an alignment target region (18) defined by said different shape portion (12a, 12b, 12c, 12d, 13a, 13b, 13c, 13d) of said wiring sheet (10) are disposed while overlapped with each other.

18. The production method for a solar cell having wiring sheet (100) according to claim 17, wherein said plurality of alignment marks (24a, 24a₁, 24b, 25a, 25a₁, 25a₂, 25b, 25b₁, 24b₂, 25c, 28, 29) and said alignment target region (18) are disposed while overlapped with each other in said alignment step.

19. The production method for a solar cell having wiring sheet (100) according to claim 17, wherein said at least one alignment mark (24a, 24a₁, 24b, 25a, 25a₁, 25a₂, 25b, 25b₁, 24b₂, 25c, 28, 29) and said wiring (12, 13) are disposed while overlapped with each other in said alignment step.

20. The production method for a solar cell having wiring sheet (100) as in any one of claims 17 to 19; wherein, in said alignment step, the alignment between said back contact solar cell (20) and said wiring sheet (10) is performed such that said back contact solar cell (20) and said wiring sheet (10) are overlapped with each other while said back contact solar cell (20) is irradiated with light, which is transmitted through said back contact solar cell (20), to check said alignment mark (24a, 24a₁, 24b, 25a, 25a₁, 25a₂, 25b, 25b₁, 24b₂, 25c, 28, 29) and said alignment target region (18).

21. The production method for a solar cell having wiring sheet (100) as in any one of claims 17 to 19, wherein, in said alignment step, the alignment between said back contact solar cell (20) and said wiring sheet (10) is performed such that said back contact solar cell (20) and said wiring sheet (10) are overlapped with each other while said back contact solar cell (20) is irradiated with light, which is reflected by said electrode (24, 25) of said back contact solar cell (20), to check said alignment mark (24a, 24a₁, 24b, 25a, 25a₁, 25a₂, 25b, 25b₁, 24b₂, 25c, 28, 29) and said alignment target region (18).
